# EUROPEAN PATENT APPLICATION

(11) **EP 4 546 427 A1**
(43) Date of publication of application: **30.04.2025**
(21) Application number: 23827199.3
(22) Date of filing: 20.06.2023
(51) Int. Cl.: H01L 27/146, H04N 25/63, H04N 25/70, H04N 25/79

(54) **IMAGING ELEMENT AND IMAGING DEVICE**

(30) Priority: 24.06.2022 JP 2022102157; 28.03.2023 JP 2023051956
(71) Applicant: Sony Semiconductor Solutions Corporation, Atsugi-shi, Kanagawa 243-0014 (JP)
(72) Inventor: KITANO, Yoshiaki, Atsugi-shi, Kanagawa 243-0014 (JP); SATO, Shinya, Atsugi-shi, Kanagawa 243-0014 (JP); KAJIKAWA, Ryoko, Atsugi-shi, Kanagawa 243-0014 (JP); TANAKA, Yusuke, Atsugi-shi, Kanagawa 243-0014 (JP); KASUKAWA, Shuhei, Atsugi-shi, Kanagawa 243-0014 (JP); SAITO, Hiromasa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/022778
(87) International publication number: WO 2023/249016

(57) **Abstract**

An imaging element of one embodiment of the present disclosure includes: a first semiconductor substrate having first and second surfaces opposed to each other and including a plurality of pixels arranged in an array in an in-plane direction, a plurality of projections being provided on the first surface with respect to each of the plurality of pixels; a plurality of photoelectric converters that is formed to be embedded in the first semiconductor substrate with respect to each pixel and generates an electric charge according to an amount of light received; a plurality of charge holding units that is provided on respective upper surfaces of the plurality of projections and holds electric charges generated in the plurality of photoelectric converters; a second semiconductor substrate stacked on the side of the first surface of the first semiconductor substrate and provided with one or more pixel circuits that generate a pixel signal on the basis of an electric charge generated by each of the plurality of photoelectric converters; and a gate of a transfer transistor that is provided around the plurality of projections and transfers the electric charges held in the charge holding units to the pixel circuits.

## Description

### Technical Field

The present disclosure relates to, for example, an imaging element and an imaging device that have a three-dimensional structure.

### Background Art

In recent years, a three-dimensional structural imaging element has been developed to make an imaging device smaller and achieve the high density of pixels. For example, Patent Literature 1 discloses an imaging element in which a first substrate including sensor pixels that perform photoelectric conversion and a second substrate including a readout circuit are stacked on top of each other.

### Citation List

### Patent Literature

Patent Literature 1: International Publication No. WO 2019/131965

### Summary of Invention

Incidentally, the reduction of generation of dark current is expected of an imaging element having a three-dimensional structure as described above.

It is desirable to provide an imaging element and an imaging device that make it possible to reduce the generation of dark current.

An imaging element of one embodiment of the present disclosure includes: a first semiconductor substrate having a first surface and a second surface that are opposed to each other and including a plurality of pixels arranged in an array in an in-plane direction, a plurality of projections being provided on the first surface with respect to each of the plurality of pixels; a plurality of photoelectric converters that is formed to be embedded in the first semiconductor substrate with respect to each pixel and generates an electric charge according to an amount of light received; a plurality of charge holding units that is provided on respective upper surfaces of the plurality of projections and holds electric charges generated in the plurality of photoelectric converters; a second semiconductor substrate stacked on the side of the first surface of the first semiconductor substrate and provided with one or more pixel circuits that generate a pixel signal on the basis of an electric charge generated by each of the plurality of photoelectric converters; and a gate of a transfer transistor that is provided around the plurality of projections and transfers the electric charges held in the charge holding units to the pixel circuits.

An imaging device of one embodiment of the present disclosure includes the imaging element of the above-described embodiment.

In the imaging element and the imaging device of the embodiments of the present disclosure, in the first semiconductor substrate having the first and second surfaces opposed to each other and including the plurality of pixels arranged in an array in the in-plane direction, the plurality of projections being provided on the first surface with respect to the plurality of pixels, the plurality of charge holding units that holds electric charges generated in the plurality of photoelectric converters, one formed to be embedded in each pixel, is provided on the respective upper surfaces of the plurality of projections, and the gate of the transfer transistor that transfers the electric charges held in the charge holding units to the pixel circuits is provided around the plurality of projections. Thus, the distance between the charge holding unit and the transfer gate is secured in the height direction.

### Brief Description of Drawings

[FIG. 1] FIG. 1 is a block diagram illustrating an example of a functional configuration of an imaging device according to a first embodiment of the present disclosure.
[FIG. 2] FIG. 2 is a schematic plan view illustrating a schematic configuration of the imaging device illustrated in FIG. 1.
[FIG. 3] FIG. 3 is a schematic diagram illustrating a cross-sectional configuration of the imaging device along a line I-I' illustrated in FIG. 2.
[FIG. 4] FIG. 4 is an equivalent circuit diagram of a pixel-shared unit illustrated in FIG. 1.
[FIG. 5] FIG. 5 is a schematic diagram illustrating an example of a cross-sectional configuration of the imaging device illustrated in FIG. 1.
[FIG. 6] FIG. 6 is a schematic diagram illustrating an example of a planar layout of a first substrate illustrated in FIG. 5.
[FIG. 7A] FIG. 7A is a schematic cross-sectional view illustrating a process for manufacturing the first substrate illustrated in FIG. 5
[FIG. 7B] FIG. 7B is a schematic cross-sectional view illustrating a continuation of the process from FIG. 7A.
[FIG. 7C] FIG. 7C is a schematic cross-sectional view illustrating a continuation of the process from FIG. 7B.
[FIG. 7D] FIG. 7D is a schematic cross-sectional view illustrating a continuation of the process from FIG. 7C.
[FIG. 7E] FIG. 7E is a schematic cross-sectional view illustrating a continuation of the process from FIG. 7D.
[FIG. 7F] FIG. 7F is a schematic cross-sectional view illustrating a continuation of the process from FIG. 7E.
[FIG. 7G] FIG. 7G is a schematic cross-sectional view illustrating a continuation of the process from FIG. 7F.
[FIG. 7H] FIG. 7H is a schematic cross-sectional view illustrating a continuation of the process from FIG. 7G.
[FIG. 7I] FIG. 7I is a schematic cross-sectional view illustrating a continuation of the process from FIG. 7H.
[FIG. 7J] FIG. 7J is a schematic cross-sectional view illustrating a continuation of the process from FIG. 7I.
[FIG. 7K] FIG. 7K is a schematic cross-sectional view illustrating a continuation of the process from FIG. 7J.
[FIG. 7L] FIG. 7L is a schematic cross-sectional view illustrating a continuation of the process from FIG. 7K.
[FIG. 8] FIG. 8 is a schematic diagram for explaining a path of an input signal to the imaging device illustrated in FIG. 3.
[FIG. 9] FIG. 9 is a schematic diagram for explaining a signal path of a pixel signal of the imaging device illustrated in FIG. 3.
[FIG. 10A] FIG. 10A is a schematic diagram illustrating an example of a planar layout of a pixel of a general imaging device.
[FIG. 10B] FIG. 10B is a schematic diagram illustrating a configuration of a cross-section along a line II-II' illustrated in FIG. 10A.
[FIG. 11] FIG. 11 is a schematic diagram illustrating an example of a cross-sectional configuration of an imaging device according to Modification Example 1 of the present disclosure.
[FIG. 12] FIG. 12 is a schematic diagram illustrating an example of a planar layout of a first substrate and a second substrate of the imaging device illustrated in FIG. 11.
[FIG. 13A] FIG. 13A is a schematic plan view illustrating an example of a pixel array of an imaging device according to Modification Example 2 of the present disclosure.
[FIG. 13B] FIG. 13B is a schematic plan view illustrating another example of the pixel array of the imaging device according to Modification Example 2 of the present disclosure.
[FIG. 14] FIG. 14 is a schematic diagram illustrating an example of a cross-sectional configuration of an imaging device according to a second embodiment of the present disclosure.
[FIG. 15] FIG. 15 is a schematic diagram illustrating an example of a cross-sectional configuration of the imaging device according to the second embodiment of the present disclosure in a different position from that of FIG. 14.
[FIG. 16] FIG. 16 is a schematic diagram illustrating an example of a planar layout of the imaging device illustrated in FIGs. 14 and 15.
[FIG. 17A] FIG. 17A is a schematic cross-sectional view illustrating a process for manufacturing a first substrate illustrated in FIGs. 14 and 15.
[FIG. 17B] FIG. 17B is a schematic cross-sectional view illustrating a continuation of the process from FIG. 17A.
[FIG. 17C] FIG. 17C is a schematic cross-sectional view illustrating a continuation of the process from FIG. 17B.
[FIG. 17D] FIG. 17D is a schematic cross-sectional view illustrating a continuation of the process from FIG. 17C.
[FIG. 17E] FIG. 17E is a schematic cross-sectional view illustrating a continuation of the process from FIG. 17D.
[FIG. 17F] FIG. 17F is a schematic cross-sectional view illustrating a continuation of the process from FIG. 17E.
[FIG. 17G] FIG. 17G is a schematic cross-sectional view illustrating a continuation of the process from FIG. 17F.
[FIG. 18] FIG. 18 is a schematic diagram illustrating an example of a cross-sectional configuration of an imaging device according to Modification Example 3 of the present disclosure.
[FIG. 19] FIG. 19 is a schematic diagram illustrating an example of a cross-sectional configuration of the imaging device according to Modification Example 3 of the present disclosure in a different position from that of FIG. 18.
[FIG. 20] FIG. 20 is a schematic diagram illustrating an example of a cross-sectional configuration of an imaging device according to Modification Example 4 of the present disclosure.
[FIG. 21] FIG. 21 is a schematic diagram illustrating an example of a cross-sectional configuration of the imaging device according to Modification Example 4 of the present disclosure in a different position from that of FIG. 20.
[FIG. 22] FIG. 22 is a schematic diagram illustrating an example of a planar layout of an imaging device according to Modification Example 5 of the present disclosure.
[FIG. 23] FIG. 23 is a schematic diagram illustrating an example of a planar configuration of a pixel of an imaging device according to a third embodiment of the present disclosure.
[FIG. 24] FIG. 24 is a schematic diagram illustrating an example of a cross-sectional configuration corresponding to a line V-V' illustrated in FIG. 23.
[FIG. 25] FIG. 25 is a schematic plan view illustrating an example of a configuration of a pixel array section of the imaging device illustrated in FIG. 23.
[FIG. 26] FIG. 26 is a schematic diagram illustrating another example of the cross-sectional configuration corresponding to the line V-V' illustrated in FIG. 23.
[FIG. 27] FIG. 27 is a schematic diagram illustrating an example of a planar configuration of a pixel of an imaging device according to Modification Example 6 of the present disclosure.
[FIG. 28] FIG. 28 is a schematic diagram illustrating an example of a cross-sectional configuration corresponding to a line VI-VI' illustrated in FIG. 27.
[FIG. 29] FIG. 29 is a schematic diagram illustrating another example of the cross-sectional configuration corresponding to the line VI-VI' illustrated in FIG. 27.
[FIG. 30] FIG. 30 is a schematic diagram illustrating an example of a planar configuration of a pixel of an imaging device according to Modification Example 7 of the present disclosure.
[FIG. 31] FIG. 31 is a schematic diagram illustrating an example of a cross-sectional configuration corresponding to a line VII-VII' illustrated in FIG. 30.
[FIG. 32] FIG. 32 is a schematic diagram illustrating another example of the cross-sectional configuration corresponding to the line VII-VII' illustrated in FIG. 30.
[FIG. 33] FIG. 33 is a schematic diagram illustrating an example of a planar configuration of a pixel of an imaging device according to Modification Example 8 of the present disclosure.
[FIG. 34] FIG. 34 is a schematic diagram illustrating an example of a cross-sectional configuration corresponding to a line VIII-VIII' illustrated in FIG. 33.
[FIG. 35] FIG. 35 is a schematic diagram illustrating another example of the cross-sectional configuration corresponding to the line VIII-VIII' illustrated in FIG. 33.
[FIG. 36] FIG. 36 is a schematic diagram illustrating an example of a planar configuration of a pixel of an imaging device according to Modification Example 9 of the present disclosure.
[FIG. 37] FIG. 37 is a schematic diagram illustrating another example of the planar configuration of the pixel of the imaging device according to Modification Example 9 of the present disclosure.
[FIG. 38] FIG. 38 is a schematic diagram illustrating an example of a planar configuration of a pixel of an imaging device according to Modification Example 9 of the present disclosure.
[FIG. 39] FIG. 39 is a schematic diagram illustrating another example of the planar configuration of the pixel of the imaging device according to Modification Example 10 of the present disclosure.
[FIG. 40] FIG. 40 is a schematic diagram illustrating an example of a planar configuration of a pixel of an imaging device according to Modification Example 11 of the present disclosure.
[FIG. 41] FIG. 41 is a schematic diagram illustrating another example of the planar configuration of the pixel of the imaging device according to Modification Example 11 of the present disclosure.
[FIG. 42] FIG. 42 is a schematic diagram illustrating still another example of the planar configuration of the pixel of the imaging device according to Modification Example 11 of the present disclosure.
[FIG. 43] FIG. 43 is a schematic diagram illustrating still another example of the planar configuration of the pixel of the imaging device according to Modification Example 11 of the present disclosure.
[FIG. 44] FIG. 44 is a schematic diagram illustrating an example of a cross-sectional configuration of a semiconductor layer of a first substrate of an imaging device according to a fourth embodiment of the present disclosure.
[FIG. 45A] FIG. 45A is a schematic diagram illustrating an example of a planar layout of the semiconductor layer of the first substrate illustrated in FIG. 44.
[FIG. 45B] FIG. 45B is a schematic diagram illustrating another example of the planar layout of the semiconductor layer of the first substrate illustrated in FIG. 44.
[FIG. 46] FIG. 46 is a schematic diagram illustrating an example of a cross-sectional configuration of a semiconductor layer of a first substrate of an imaging device according to Modification Example 12 of the present disclosure.
[FIG. 47A] FIG. 47A is a schematic diagram illustrating an example of a planar layout of the semiconductor layer of the first substrate illustrated in FIG. 46.
[FIG. 47B] FIG. 47B is a schematic diagram illustrating another example of the planar layout of the semiconductor layer of the first substrate illustrated in FIG. 46.
[FIG. 48] FIG. 48 is a schematic diagram illustrating an example of a planar configuration of a pixel of an imaging device according to Modification Example 13 of the present disclosure.
[FIG. 49] FIG. 49 is a schematic diagram illustrating another example of the planar configuration of the pixel of the imaging device according to Modification Example 13 of the present disclosure.
[FIG. 50] FIG. 50 is a schematic diagram illustrating still another example of the planar configuration of the pixel of the imaging device according to Modification Example 13 of the present disclosure.
[FIG. 51] FIG. 51 is a schematic diagram illustrating still another example of the planar configuration of the pixel of the imaging device according to Modification Example 13 of the present disclosure.
[FIG. 52] FIG. 52 is a schematic diagram illustrating still another example of the planar configuration of the pixel of the imaging device according to Modification Example 13 of the present disclosure.
[FIG. 53] FIG. 53 is a schematic diagram illustrating still another example of the planar configuration of the pixel of the imaging device according to Modification Example 13 of the present disclosure.
[FIG. 54] FIG. 54 is a schematic diagram illustrating still another example of the planar configuration of the pixel of the imaging device according to Modification Example 13 of the present disclosure.
[FIG. 55] FIG. 55 is a schematic diagram illustrating still another example of the planar configuration of the pixel of the imaging device according to Modification Example 13 of the present disclosure.
[FIG. 56] FIG. 56 is a schematic diagram illustrating still another example of the planar configuration of the pixel of the imaging device according to Modification Example 13 of the present disclosure.
[FIG. 57] FIG. 57 is a schematic diagram illustrating still another example of the planar configuration of the pixel of the imaging device according to Modification Example 13 of the present disclosure.
[FIG. 58] FIG. 58 is a schematic plan view illustrating an example of a configuration of a pixel array section of an imaging device according to a fifth embodiment of the present disclosure.
[FIG. 59] FIG. 59 is a schematic diagram illustrating an example of a cross-sectional configuration corresponding to a line XI-XI' illustrated in FIG. 58.
[FIG. 60] FIG. 60 is a schematic diagram illustrating another example of the cross-sectional configuration corresponding to the line XI-XI' illustrated in FIG. 58.
[FIG. 61] FIG. 61 is a schematic diagram illustrating an example of a planar configuration of a pixel of an imaging device according to Modification Example 14 of the present disclosure.
[FIG. 62] FIG. 62 is a schematic diagram illustrating another example of the planar configuration of the pixel of the imaging device according to Modification Example 14 of the present disclosure.
[FIG. 63] FIG. 63 is a diagram illustrating an example of a schematic configuration of an imaging system 6 including the imaging device according to the above-described embodiments and their modification examples.
[FIG. 64] FIG. 64 is a diagram illustrating an example of an imaging procedure in an imaging system illustrated in FIG. 63.
[FIG. 65] FIG. 65 is a view depicting an example of a schematic configuration of an endoscopic surgery system.
[FIG. 66] FIG. 66 is a block diagram depicting an example of a functional configuration of a camera head and a camera control unit (CCU).
[FIG. 67] FIG. 67 is a block diagram depicting an example of schematic configuration of a vehicle control system.
[FIG. 68] FIG. 68 is a diagram of assistance in explaining an example of installation positions of an outside-vehicle information detecting section and an imaging section.

### Modes for Carrying Out the Invention

With reference to the drawings, embodiments of the present disclosure will be described in detail below. The following description is a specific example of the present disclosure, and the present disclosure is not limited to the following aspects. Furthermore, as for the layout, dimensions, dimensional ratio, etc. of each component illustrated in each drawing, the present disclosure is not limited to those. It is to be noted that the order of description is as follows.
1. First Embodiment (an example of an imaging device provided with an FD in a projection of a semiconductor substrate and, around the projection, a transfer gate in a position lower than the FD)
2. Modification Examples
   2-1. Modification Example 1 (another example of a configuration of the imaging device)
   2-2. Modification Example 2 (another example of the configuration of the imaging device)
3. Second Embodiment (an example of an imaging device provided with an FD in a projection of a semiconductor substrate and, around the projection, a transfer gate in a position higher than the FD)
4. Modification Examples
   4-1. Modification Example 3 (another example of a configuration of the imaging device)
   4-2. Modification Example 4 (another example of the configuration of the imaging device)
   4-3. Modification Example 5 (another example of the configuration of the imaging device)
5. Third Embodiment (an example of an imaging device provided with an FD in a projection of a semiconductor substrate and a transfer gate around the projection in a phase difference pixel)
6. Modification Examples
   6-1. Modification Example 6 (another example of a configuration of the imaging device)
   6-2. Modification Example 7 (another example of the configuration of the imaging device)
   6-3. Modification Example 8 (another example of the configuration of the imaging device)
   6-4. Modification Example 9 (another example of the configuration of the imaging device)
   6-5. Modification Example 10 (another example of the configuration of the imaging device)
   6-6. Modification Example 11 (another example of the configuration of the imaging device)
7. Fourth Embodiment (an example of an imaging device provided with an FD between an upper surface and a lower surface of a transfer gate)
8. Modification Examples
   8-1. Modification Example 12 (another example of a configuration of the imaging device)
   8-2. Modification Example 13 (another example of the configuration of the imaging device)
9. Fifth Embodiment (an example of an imaging device in which, in an overall phase difference pixel, an FD is shared between adjacent pixels, and a transfer gate of each pixel is provided around the FD)
10. Modification Example 14 (another example of a configuration of the imaging device)
11. Application Example (an imaging system)
12. Practical Application Examples

### <1. First Embodiment>

### [Functional Configuration of Imaging Device]

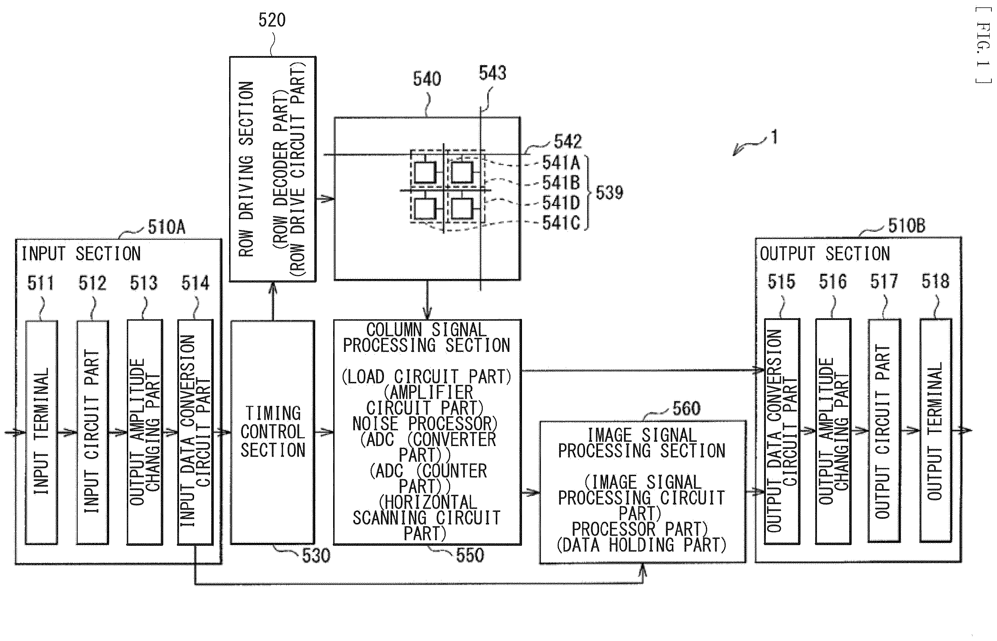

FIG. 1 is a block diagram illustrating an example of a functional configuration of an imaging device (an imaging device 1) according to a first embodiment of the present disclosure.

The imaging device 1 in FIG. 1 includes, for example, an input section 5 10A, a row driving section 520, a timing control section 530, a pixel array section 540, a column signal processing section 550, an image signal processing section 560, and an output section 510B.

In the pixel array section 540, pixels 541 are repeatedly arranged in an array. More specifically, with a unit cell 539 including a set of pixels as a repeat unit, unit cells 539 are repeatedly arranged in an array of rows and columns, i.e., in a row direction and a column direction. It is to be noted that in the present specification, for the sake of convenience, the row direction may be referred to as an H direction, and the column direction perpendicular to the row direction may be referred to as a V direction. In the example of FIG. 1, one unit cell 539 includes, for example, four pixels (pixels 541A, 541B, 541C, and 541D).

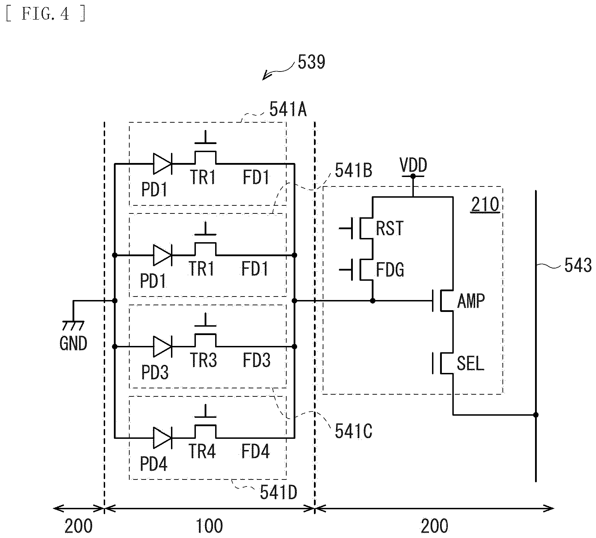

The pixel array section 540 is provided with a plurality of row drive signal lines 542 and a plurality of vertical signal lines (column readout lines) 543 in addition to pixels 541A, 541B, 541C, and 541D. The row drive signal lines 542 drive pixels 541 included in each of the plurality of unit cells 539 arranged side by side in the row direction in the pixel array section 540. The row drive signal lines 542 drive, of a unit cell 539, each of pixels arranged side by side in the row direction. As will be described in detail later with reference to FIG. 4, a unit cell 539 is provided with multiple transistors. To drive each of these multiple transistors, multiple row drive signal lines 542 are coupled to one unit cell 539. The unit cell 539 is coupled to a vertical signal line (column readout line) 543. A pixel signal is read out from each of pixels 541A, 541B, 541C, and 541D included in the unit cell 539 through the vertical signal line (column readout line) 543.

The row driving section 520 includes, for example, a row address controller that determines a position of a row for driving a pixel, i.e., a row decoder part and a row drive circuit part that generates signals for driving pixels 541A, 541B, 541C, and 541D.

The column signal processing section 550 includes, for example, a load circuit part that is coupled to the vertical signal lines 543 and forms a source follower circuit along with pixels 541A, 541B, 541C, and 541D (a unit cell 539). The column signal processing section 550 may include an amplifier circuit part that amplifies a signal read out from a unit cell 539 through a vertical signal line 543. The column signal processing section 550 may include a noise processor. In the noise processor, for example, a noise level of a system is removed from a signal read out from a unit cell 539 as a result of photoelectric conversion.

The column signal processing section 550 includes, for example, an analog-digital converter (ADC). In the analog-digital converter, a signal read out from a unit cell 539 or an analog signal that has been subjected to the above-described noise processing is converted into a digital signal. The ADC includes, for example, a comparator part and a counter part. In the comparator, an analog signal to be converted is compared with a reference signal for comparison with this analog signal. In the counter, the time to invert a result of comparison in the comparator is measured. The column signal processing section 550 may include a horizontal scanning circuit part that performs control of scanning of a column to be read.

The timing control section 530 supplies a signal to control the timing to the row driving section 520 and the column signal processing section 550 on the basis of a reference clock signal or a timing control signal that has been input to the device.

The image signal processing section 560 is a circuit that performs a variety of signal processing on data obtained as a result of photoelectric conversion, i.e., data obtained as a result of an imaging operation in the imaging device 1. The image signal processing section 560 includes, for example, an image signal processing circuit part and a data holding part. The image signal processing section 560 may include a processor part.

An example of the signal processing performed in the image signal processing section 560 is tone curve correction processing that causes imaged data that has been subjected to A/D conversion to have more tones if it is data of a taken image of a dark subject and have fewer tones if it is data of a taken image of a bright subject. In this case, it is desirable to store characteristics data of tone curves in the data holding part of the image signal processing section 560 in advance to determine whether to correct the tone of imaged data on the basis of what kind of tone curve.

The input section 510A is used for inputting, for example, the above-described reference clock signal, the timing control signal, the characteristics data, etc. to the imaging device 1 from the outside of the device. Examples of the timing control signal include a vertical synchronization signal and a horizontal synchronization signal. The characteristics data is for being stored in, for example, the data holding part of the image signal processing section 560. The input section 510A includes, for example, an input terminal 511, an input circuit part 512, an input amplitude changing part 513, an input data conversion circuit part 514, and a power supply unit (not illustrated).

The input terminal 511 is an external terminal for inputting data. The input circuit part 512 is for fetching a signal input to the input terminal 511 into the inside of the imaging device 1. In the input amplitude changing part 513, the amplitude of a signal fetched by the input circuit part 512 is changed to an amplitude that allows the signal to be usable in the inside of the imaging device 1. In the input data conversion circuit part 514, the sequence of a data string of input data is changed. The input data conversion circuit part 514 includes, for example, a serial-parallel conversion circuit. In this serial-parallel conversion circuit, a serial signal received as input data is converted into a parallel signal. It is to be noted that the input amplitude changing part 513 and the input data conversion circuit part 514 may be omitted from the input section 510A. The power supply unit supplies electric power with various voltages required inside the imaging device 1 on the basis of electric power supplied from the outside to the imaging device 1.

The input section 510A may be provided with a memory interface circuit that receives data from an external memory device when the imaging device 1 is coupled to the external memory device. Examples of the external memory device include a flash memory, an SRAM, and a DRAM.

The output section 510B outputs image data to the outside of the device. Examples of this image data include image data of an image taken by the imaging device 1 and image data that has been subjected to signal processing by the image signal processing section 560. The output section 510B includes, for example, an output data conversion circuit part 515, an output amplitude changing part 516, an output circuit part 517, and an output terminal 518.

The output data conversion circuit part 515 includes, for example, a parallel-serial conversion circuit; in the output data conversion circuit part 515, a parallel signal used inside the imaging device 1 is converted into a serial signal. The output amplitude changing part 516 changes the amplitude of a signal used inside the imaging device 1. The signal of the changed amplitude becomes usable in an external device externally coupled to the outside of the imaging device 1. The output circuit part 517 is a circuit that outputs data from the inside of the imaging device 1 to the outside of the device, and a wire of the outside of the imaging device 1 coupled to the output terminal 518 is driven by the output circuit part 517. In the output terminal 518, data is output from the imaging device 1 to the outside of the device. The output data conversion circuit part 515 and the output amplitude changing part 516 may be omitted from the output section 510B.

The output section 510B may be provided with a memory interface circuit that outputs data to an external memory device when the imaging device 1 is coupled to the external memory device. Examples of the external memory device include a flash memory, an SRAM, and a DRAM.

### [Schematic Configuration of Imaging Device]

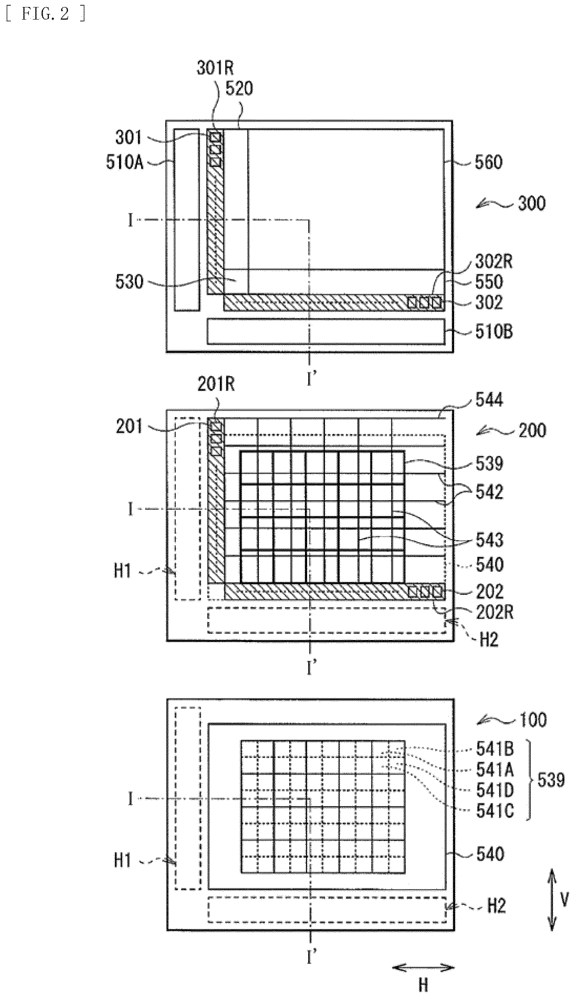

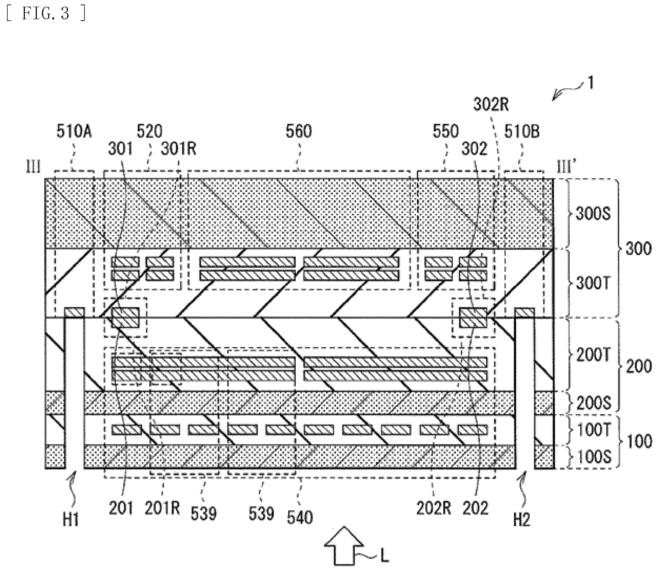

FIGs. 2 and 3 illustrate an example of a schematic configuration of the imaging device 1. The imaging device 1 includes three substrates (a first substrate 100, a second substrate 200, and a third substrate 300). FIG. 2 schematically illustrates respective planar configurations of the first substrate 100, the second substrate 200, and the third substrate 300, and FIG. 3 schematically illustrates cross-sectional configurations of the first substrate 100, the second substrate 200, and the third substrate 300 stacked on top of another. FIG. 3 corresponds to a cross-sectional configuration of the imaging device 1 along a line I-I' illustrated in FIG. 2. The imaging device 1 is a three-dimensional structural imaging device including three substrates (the first substrate 100, the second substrate 200, and the third substrate 300) bonded together. The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. Here, for the sake of convenience, a combination of a wire included in each of the first substrate 100, the second substrate 200, and the third substrate 300 and its surrounding interlayer insulating film is referred to as a wiring layer (100T, 200T, 300T) provided in each substrate (each of the first substrate 100, the second substrate 200, and the third substrate 300). The first substrate 100, the second substrate 200, and the third substrate 300 are stacked on top of another in this order, and, along a direction of the stack, the semiconductor layer 100S, the wiring layer 100T, the semiconductor layer 200S, the wiring layer 200T, the semiconductor layer 300S, and the wiring layer 300T are disposed in order. Specific configurations of the first substrate 100, the second substrate 200, and the third substrate 300 will be described later. An arrow illustrated in FIG. 3 indicates a direction of incidence of light L to the imaging device 1. In the present specification, in subsequent cross-sectional views, for the sake of convenience, the light incident side of the imaging device 1 may be referred to as "the bottom", "the lower side", or "below", and the side opposite to the light incident side may be referred to as "the top", "the upper side", or "above". Furthermore, in the present specification, as for a substrate including a semiconductor layer and a wiring layer, for the sake of convenience, the wiring layer side may be referred to as a front surface, and the semiconductor layer side may be referred to as a back surface. It is to be noted that description in the specification is not limited to the above terms. The imaging device 1 is, for example, a back-illuminated imaging device into which light enters from the side of a back surface of the first substrate 100 including photodiodes.

The pixel array section 540 and the unit cells 539 included in the pixel array section 540 are both included in both of the first substrate 100 and the second substrate 200. The first substrate 100 is provided with respective sets of pixels 541A, 541B, 541C, and 541D included in the unit cells 539. Each of these pixels 541 includes a photodiode (a photodiode PD to be described later) and a transfer transistor (a transfer transistor TR to be described later). The second substrate 200 is provided with a pixel circuit (a pixel circuit 210 to be described later) included in a unit cell 539. The pixel circuit reads out a pixel signal transferred from the photodiode of each of the pixels 541A, 541B, 541C, and 541D through the transfer transistor, or resets the photodiode. In addition to such pixel circuits, this second substrate 200 includes the plurality of row drive signal lines 542 extending in the row direction and the plurality of vertical signal lines 543 extending in the column direction. The second substrate 200 further includes a power line 544 extending in the row direction. The third substrate 300 includes, for example, the input section 510A, the row driving section 520, the timing control section 530, the column signal processing section 550, the image signal processing section 560, and the output section 510B. The row driving section 520 is provided, for example, in a region where a portion thereof overlaps, in a direction in which the first substrate 100, the second substrate 200, and the third substrate 300 are stacked on top of another (hereinafter, referred to simply as the "stack direction"), with the pixel array section 540. More specifically, the row driving section 520 is provided in a region where it overlaps, in the stack direction, with a portion adjacent to an end of the pixel array section 540 in the H direction (FIG. 2). The column signal processing section 550 is provided, for example, in a region where a portion thereof overlaps, in the stack direction, with the pixel array section 540. More specifically, the column signal processing section 550 is provided in a region where it overlaps, in the stack direction, with a portion adjacent to an end of the pixel array section 540 in the V direction (FIG. 2). Although not illustrated, the input section 510A and the output section 510B may be disposed in a part other than the third substrate 300; for example, they may be disposed in the second substrate 200. Alternatively, the input section 510A and the output section 510B may be provided on the side of the back surface (a light incident surface) of the first substrate 100. It is to be noted that the pixel circuit(s) provided in the second substrate 200 may sometimes be referred to by different names such as a pixel transistor circuit, a pixel transistor group, a pixel transistor, a pixel readout circuit, or a readout circuit. In the present specification, the name of pixel circuit is used.

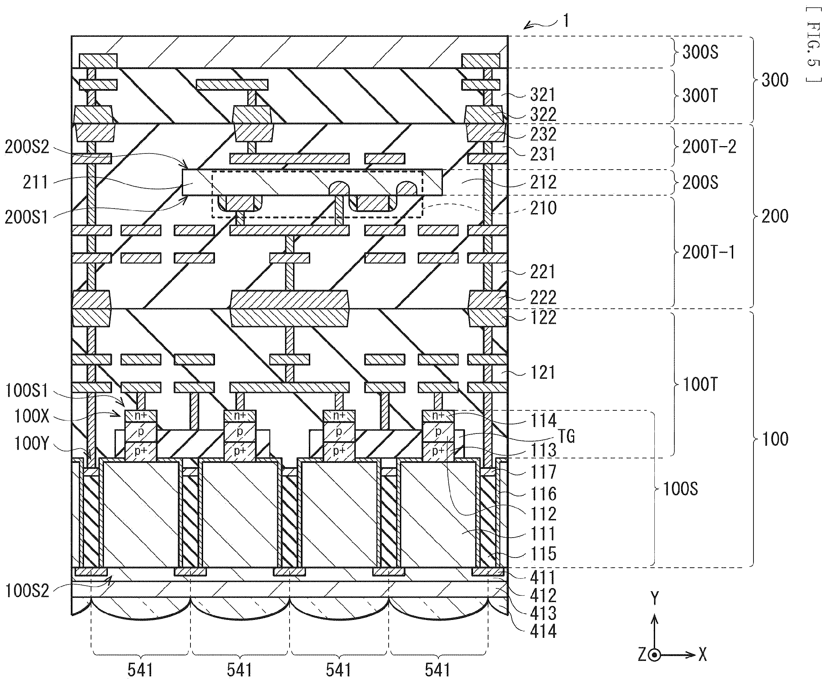

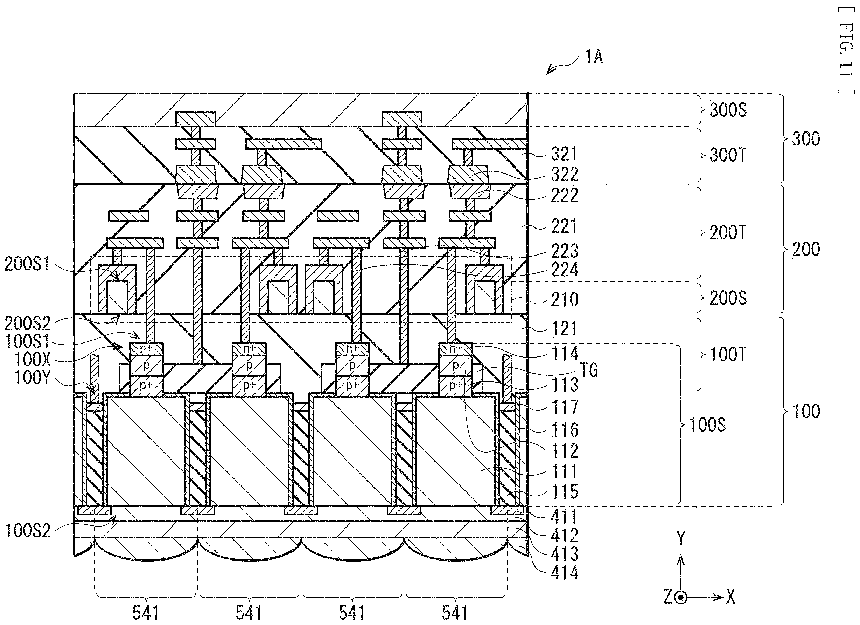

The first substrate 100 and the second substrate 200 are electrically coupled by, for example, a contact (for example, contact electrodes 122 and 222 in FIG. 5 to be described later) or a through-electrode (for example, through-electrodes 223, 224, and 225 in FIG. 11 to be described later). For example, the second substrate 200 and the third substrate 300 are electrically coupled through contacts 201, 202, 301, and 302. The second substrate 200 is provided with the contacts 201 and 202, and the third substrate 300 is provided with the contacts 301 and 302. The contact 201 of the second substrate 200 is in contact with the contact 301 of the third substrate 300, and the contact 202 of the second substrate 200 is in contact with the contact 302 of the third substrate 300. The second substrate 200 has a contact region 201R provided with a plurality of the contacts 201 and a contact region 202R provided with a plurality of the contacts 202. The third substrate 300 has a contact region 301R provided with a plurality of the contacts 301 and a contact region 302R provided with a plurality of the contacts 302. The contact regions 201R and 301R are provided between the pixel array section 540 and the row driving section 520 in the stack direction (FIG. 3). In other words, the contact regions 201R and 301R are provided, for example, in a region where the row driving section 520 (the third substrate 300) and the pixel array section 540 (the second substrate 200) overlap in the stack direction or its adjacent region. For example, the contact regions 201R and 301R are disposed in respective ends of these regions in the H direction (FIG. 2). In the third substrate 300, for example, the contact region 301R is provided in a position where it overlaps a portion of the row driving section 520, specifically, an end of the row driving section 520 in the H direction (FIGs. 2 and 3). The contacts 201 and 301 couple, for example, the row driving section 520 provided in the third substrate 300 to the row drive signal lines 542 provided in the second substrate 200. For example, the contacts 201 and 301 may couple the input section 510A provided in the third substrate 300 to the power line 544 and a reference potential line (a reference potential line VSS to be described later). The contact regions 202R and 302R are provided between the pixel array section 540 and the column signal processing section 550 in the stack direction (FIG. 3). In other words, the contact regions 202R and 302R are provided, for example, in a region where the column signal processing section 550 (the third substrate 300) and the pixel array section 540 (the second substrate 200) overlap in the stack direction or its adjacent region. For example, the contact regions 202R and 302R are disposed in respective ends of these regions in the V direction (FIG. 2). In the third substrate 300, for example, the contact region 301R is provided in a position to overlap a portion of the column signal processing section 550, specifically, an end of the column signal processing section 550 in the V direction (FIGs. 2 and 3). The contacts 202 and 302 couple, for example, pixel signals (signals corresponding to the amount of electric charge generated as a result of photoelectric conversion by the photodiodes) output from each of the plurality of unit cells 539 included in the pixel array section 540 to the column signal processing section 550 provided in the third substrate 300. The pixel signals are configured to be transmitted from the second substrate 200 to the third substrate 300.

FIG. 3 is an example of a cross-sectional view of the imaging device 1. The first substrate 100, the second substrate 200, and the third substrate 300 are electrically coupled through the wiring layers 100T, 200T, and 300T. For example, the imaging device 1 includes an electrical coupler that electrically couples the second substrate 200 to the third substrate 300. Specifically, the contacts 201, 202, 301, and 302 are each formed using an electrode including a conductive material. The conductive material includes, for example, a metallic material such as copper (Cu), aluminum (Al), or gold (Au). The contact regions 201R, 202R, 301R, and 302R electrically couple the second substrate 200 to the third substrate 300, for example, by directly connecting wires formed as electrodes, which enables a signal input and/or output between the second substrate 200 and the third substrate 300.

It is possible to provide the electrical coupler that electrically couples the second substrate 200 to the third substrate 300 in a desired spot. For example, as has been described as the contact regions 201R, 202R, 301R, and 302R in FIG. 3, the electrical coupler may be provided in a region where it overlaps with the pixel array section 540 in the stack direction. Furthermore, the electrical coupler may be provided in a region where it does not overlap with the pixel array section 540 in the stack direction. Specifically, it may be provided in a region where it overlaps, in the stack direction, with a peripheral section provided outside the pixel array section 540.

The first substrate 100 and the second substrate 200 are provided with, for example, coupling holes H1 and H2. The coupling holes H1 and H2 go through the first substrate 100 and the second substrate 200 (FIG. 3). The coupling holes H1 and H2 are provided outside the pixel array section 540 (or a portion that overlap with the pixel array section 540) (FIG. 2). For example, the coupling hole H1 is disposed on the outer side in the H direction than the pixel array section 540, and the coupling hole H2 is disposed on the outer side in the V direction than the pixel array section 540. For example, the coupling hole H1 reaches the input section 510A provided in the third substrate 300, and the coupling hole H2 reaches the output section 510B provided in the third substrate 300. The coupling holes H1 and H2 may be hollow, and at least a portion thereof may include a conductive material. For example, there is a configuration in which a bonding wire is coupled to an electrode formed as the input section 510A and/or the output section 510B. Alternatively, there is a configuration in which the electrode formed as the input section 510A and/or the output section 510B is coupled to the conductive material provided in the coupling holes H1 and H2. The conductive material provided in the coupling holes H1 and H2 may be embedded in all or a part of the coupling holes H1 and H2, or the conductive material may be formed on respective side walls of the coupling holes H1 and H2.

It is to be noted that FIG. 3 illustrates a structure in which the input section 510A and the output section 510B are provided in the third substrate 300; however, the present disclosure is not limited to this. For example, by configuring a signal of the third substrate 300 to be transmitted to the second substrate 200 through the wiring layers 200T and 300T, it becomes possible to provide the input section 510A and/or the output section 510B in the second substrate 200. Likewise, by configuring a signal of the second substrate 200 to be transmitted to the first substrate 1000 through the wiring layers 100T and 200T, it becomes possible to provide the input section 510A and/or the output section 510B in the first substrate 100.

Pixels 541A, 541B, 541C, and 541D have common components. Hereinafter, to make a distinction among the respective components of the pixels 541A, 541B, 541C, and 541D, distinction number "1" is suffixed to respective reference numerals of the components of the pixel 541A, distinction number "2" is suffixed to respective reference numerals of the components of the pixel 541B, distinction number "3" is suffixed to respective reference numerals of the components of the pixel 541C, and distinction number "4" is suffixed to respective reference numerals of the components of the pixel 541D. In a case where it is not necessary to make a distinction among the respective components of the pixels 541A, 541B, 541C, and 541D, the distinction numbers suffixed to the reference numerals of the components of the pixels 541A, 541B, 541C, and 541D are omitted.

FIG. 4 is an equivalent circuit diagram illustrating an example of a configuration of a unit cell 539. The unit cell 539 includes a plurality of pixels 541 (in FIG. 4, four pixels that are pixels 541A, 541B, 541C, and 541D), one pixel circuit 210 coupled to this plurality of pixels 541, and a vertical signal line 543 coupled to the pixel circuit 210. The pixel circuit 210 includes, for example, four transistors, specifically, an amplifier transistor AMP, a selection transistor SEL, a reset transistor RST, and an FD conversion gain switching transistor FDG. As described above, by causing the one pixel circuit 210 to operate in a time-division manner, the unit cell 539 sequentially outputs respective pixel signals of the four pixels 541 (the pixels 541A, 541B, 541C, and 541D) provided in adjacent two pixels. A situation in which one pixel circuit 210 is coupled to a plurality of pixels 541, and respective pixel signals of this plurality of pixels 541 are output in a time-division manner by the one pixel circuit 210 means "a plurality of pixels 541 share one pixel circuit 210".

The pixels 541A, 541B, 541C, and 541D have common components.

The pixels 541A, 541B, 541C, and 541D include, for example, the photodiode PD, the transfer transistor TR electrically coupled to the photodiode PD, and a floating diffusion FD electrically coupled to the transfer transistor TR. In the photodiode PD, a cathode is electrically coupled to a source of the transfer transistor TR, and an anode is electrically coupled to a reference potential line (for example, the ground). The photodiode PD photoelectrically converts light that has entered, and generates an electric charge according to an amount of the light received. The transfer transistor TR is, for example, an N-type complementary metal-oxide semiconductor (CMOS) transistor. In the transfer transistor TR, a drain is electrically coupled to the floating diffusion FD, and a gate is electrically coupled to a drive signal line. This drive signal line is a part of the multiple row drive signal lines 542 coupled to one unit cell 539 (see FIG. 1). The transfer transistor TR transfers the electric charge generated in the photodiode PD to the floating diffusion FD. The floating diffusion FD is an n-type diffusion region formed within a p-type semiconductor layer. The floating diffusion FD is a charge holding means that temporarily holds the electric charge transferred from the photodiode PD, and is a charge-voltage conversion means that generates a voltage according to an amount of the electric charge.

Four floating diffusions FD (floating diffusions FD1, FD2, FD3, and FD4) included in one unit cell 539 are electrically coupled to one another, and are electrically coupled to a gate of the amplifier transistor AMP and a source of the FD conversion gain switching transistor FDG. A drain of the FD conversion gain switching transistor FDG is coupled to a source of the reset transistor RST, and a gate of the FD conversion gain switching transistor FDG is coupled to a drive signal line. This drive signal line is a part of the multiple row drive signal lines 542 coupled to one unit cell 539. A drain of the reset transistor RST is coupled to a power line VDD, and a gate of the reset transistor RST is coupled to a drive signal line. This drive signal line is a part of the multiple row drive signal lines 542 coupled to one unit cell 539. The gate of the amplifier transistor AMP is coupled to the floating diffusion FD, a drain of the amplifier transistor AMP is coupled to the power line VDD, and a source of the amplifier transistor AMP is coupled to a drain of the selection transistor SEL. A source of the selection transistor SEL is coupled to the vertical signal line 543, and a gate of the selection transistor SEL is coupled to a drive signal line. This drive signal line is a part of the multiple row drive signal lines 542 coupled to one unit cell 539.

If the transfer transistor TR goes into an ON state, the transfer transistor TR transfers an electric charge in the photodiode PD to the floating diffusion FD. As will be described in detail later, the gate (a transfer gate TG) of the transfer transistor TR is provided, for example, around a pillar-like projection 100X with the floating diffusion FD (an FD 114) formed on an upper surface thereof; the projection 100X is provided on the side of a front surface (a surface 100S1) of the semiconductor layer 100S. The reset transistor RST resets the potential of the floating diffusion FD to a predetermined potential. If the reset transistor RST goes into an ON state, it resets the potential of the floating diffusion FD to the potential of the power line VDD. The selection transistor SEL controls the timing to output a pixel signal from the pixel circuit 210. The amplifier transistor AMP generates, as a pixel signal, a signal of a voltage according to the level of an electric charge held in the floating diffusion FD. The amplifier transistor AMP is coupled to the vertical signal line 543 through the selection transistor SEL. In the column signal processing section 550, together with the load circuit part (see FIG. 1) coupled to the vertical signal line 543, this amplifier transistor AMP constitutes a source follower. If the selection transistor SEL goes into an ON state, the amplifier transistor AMP outputs the voltage of the floating diffusion FD to the column signal processing section 550 through the vertical signal line 543. The reset transistor RST, the amplifier transistor AMP, and the selection transistor SEL are, for example, an N-type CMOS transistor.

The FD conversion gain switching transistor FDG is used when the gain of charge-voltage conversion in the floating diffusion FD is changed. In general, a pixel signal is small when an image is taken in a dark place. On the basis of Q = CV, when charge-voltage conversion is performed, if the capacitance of the floating diffusion FD (FD capacitance C) is high, V, a voltage converted in the amplifier transistor AMP, becomes small. Meanwhile, a pixel signal becomes large in a bright place; therefore, if the FD capacitance C is not high, the floating diffusion FD fails to receive an electric charge of the photodiode PD. Furthermore, the FD capacitance C has to be high to cause V, a voltage converted in the amplifier transistor AMP, not to be too high (i.e., to be low). In light of these, when the FD conversion gain switching transistor FDG has been turned ON, the gate capacitance increases by that of the FD conversion gain switching transistor FDG, thus the entire FD capacitance C becomes high. Meanwhile, when the FD conversion gain switching transistor FDG has been turned OFF, the entire FD capacitance C becomes low. In this way, by switching the FD conversion gain switching transistor FDG ON and OFF, it becomes possible for the FD capacitance C to be variable and possible to switch the conversion efficiency. The FD conversion gain switching transistor FDG is, for example, an N-type CMOS transistor.

It is to be noted that a configuration with no FD conversion gain switching transistor FDG provided is also possible. At this time, for example, the pixel circuit 210 includes, for example, three transistors: the amplifier transistor AMP, the selection transistor SEL, and the reset transistor RST. The pixel circuit 210 includes, for example, at least one of pixel transistors such as the amplifier transistor AMP, the selection transistor SEL, the reset transistor RST, and the FD conversion gain switching transistor FDG.

The selection transistor SEL may be provided between the power line VDD and the amplifier transistor AMP. In this case, the drain of the reset transistor RST is electrically coupled to the power line VDD and the drain of the selection transistor SEL. The source of the selection transistor SEL is electrically coupled to the drain of the amplifier transistor AMP, and the gate of the selection transistor SEL is electrically coupled to a row drive signal line 542 (see FIG. 1). The source of the amplifier transistor AMP (an output terminal of the pixel circuit 210) is electrically coupled to the vertical signal line 543, and the gate of the amplifier transistor AMP is electrically coupled to the source of the reset transistor RST. It is to be noted that although not illustrated, the number of pixels 541 sharing one pixel circuit 210 may be other than 4. For example, two or eight pixels 541 may share one pixel circuit 210.

### [Cross-sectional Configuration of Imaging Device]

FIG. 5 illustrates an example of a cross-sectional configuration of the imaging device 1 in a direction perpendicular to principal surfaces of the first substrate 100, the second substrate 200, and the third substrate 300. To simplify a positional relationship of components, FIG. 5 illustrates a schematic one, and it may be different from an actual cross-section. In the imaging device 1, the first substrate 100, the second substrate 200, and the third substrate 300 are stacked on top of another in this order. The imaging device 1 further includes a light receiving lens 414 on the side of the back surface (the side of the light incident surface) of the first substrate 100. Between the light receiving lens 414 and the first substrate 100, for example, a light-shielding film 411, a protective layer 412, and a color filter layer 413 are provided. The light receiving lens 414 is provided, for example, in each of pixels 541A, 541B, 541C, and 541D. The imaging device 1 is, for example, a back-illuminated imaging device. The imaging device 1 includes the pixel array section 540 disposed in the middle and the peripheral section (not illustrated) disposed outside the pixel array section 540.

The first substrate 100 includes the semiconductor layer 100S and the wiring layer 100T. The semiconductor layer 100S includes, for example, a silicon substrate. The semiconductor layer 100S has a pair of surfaces opposed to each other (the front surface (the surface 100S1) and a back surface (a surface 100S2)). The semiconductor layer 100S includes a p-well layer 112 in a portion of the surface 100S1 and its adjacent region, and includes an n-type semiconductor region 111 in the other region (a region deeper than the p-well layer 112). For example, this n-type semiconductor region 111 and the p-well layer 112 constitute a p-n junction type photodiode PD. The p-well layer 112 is a p-type semiconductor region.

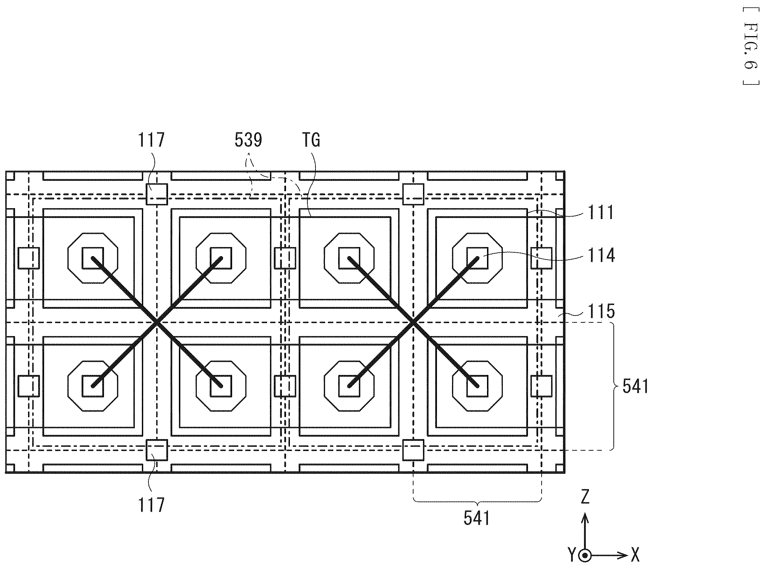

The FD 114 and a contact layer 117 are provided adjacent to the front surface of the semiconductor layer 100S. The FD 114 includes an n-type semiconductor region provided within the p-well layer 112. The FD 114 is provided with respect to each pixel 541. For example, as illustrated in FIG. 6, the FD 114 provided with respect to each pixel 541 is provided in substantially the middle of the pixel 541. As will be described in detail later, respective FDs 114 (FD1, FD2, FD3, and FD4) provided in four pixels 541A, 541B, 541C, and 541D constituting a unit cell 539 are, within the first substrate 100 (more specifically, within the wiring layer 100T), electrically coupled to one another through an electrical coupling means (wires within the wiring layer 100T). Furthermore, the FD 114 is coupled from the first substrate 100 to the second substrate 200 (more specifically, from the wiring layer 100T to the wiring layer 200T) through an electrical means (for example, the contacts 122 and 222, etc.). In the second substrate 200 (more specifically, inside the wiring layer 200T), the FD 114 is electrically coupled by this electrical means to the gate of the amplifier transistor AMP and the source of the FD conversion gain switching transistor FDG that constitute the pixel circuit 210.

The contact layer 117 is a region electrically coupled to the reference potential line VSS, and is disposed away from the FD 114. The contact layer 117 is provided, for example, between adjacent unit cells 539 in the V direction (a Z-axis direction). The contact layer 117 is coupled to, for example, a ground potential or a fixed potential. This causes the semiconductor layer 100S to be supplied with a reference potential. The contact layer 117 includes, for example, polysilicon (poly-Si), more specifically, doped polysilicon doped with an impurity.

The first substrate 100 is provided with the transfer transistor TR in addition to the photodiode PD, the FD 114, and the contact layer 117. The transfer transistor TR is provided, for example, with respect to each pixel 541. The transfer transistor TR has the transfer gate TG. As will be described in detail later, for example, with respect to each pixel 541, the transfer gate TG may be provided around the FD 114, or may be provided, for example, as illustrated in FIG. 6, for example, between adjacent unit cells 539 in an X-axis direction, continuously in two adjacent pixels 541 in the X-axis direction. This makes it possible to reduce the number of wires.

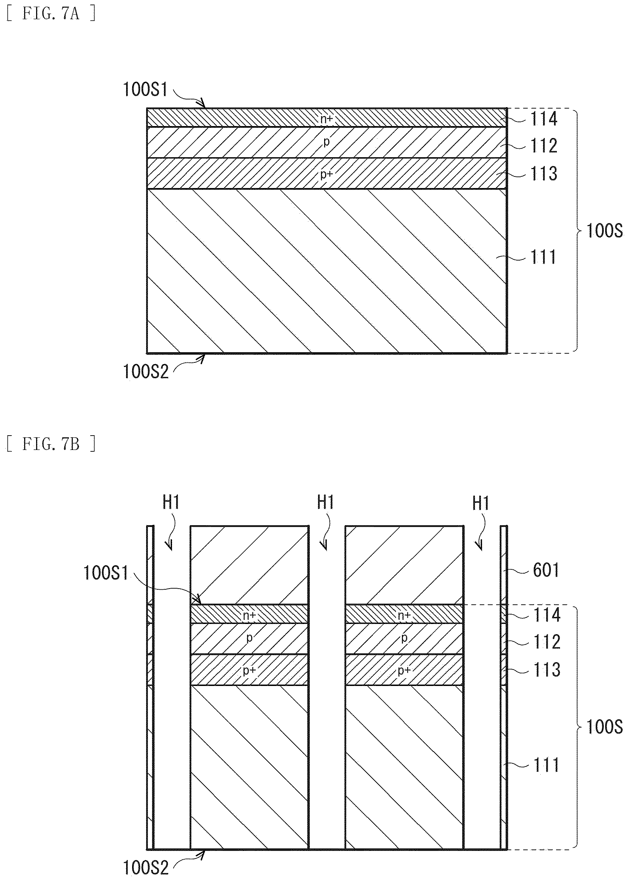

The semiconductor layer 100S is provided with a separation part 115 that separates adjacent pixels 541 from each other. The separation part 115 is formed to extend in a direction of normal to the semiconductor layer 100S (a Y-axis direction). The separation part 115 is provided to separate adjacent unit cells 539 and separate four pixels 541 (pixels 541A, 541B, 541C, and 541D) constituting a unit cell 539 from one another, and has, for example, a grid-like planar shape. For example, the separation part 115 electrically separates adjacent pixels 541 from each other. The separation part 115 has, for example, a full trench isolation (FTI) structure, and goes through between the surfaces 100S1 and 100S2 of the semiconductor layer 100S. Furthermore, the separation part 115 may have, for example, a deep trench isolation (DTI) structure in which it does not go through the semiconductor layer 100S. The separation part 115 is formed, for example, by embedding an insulating film such as silicon oxide (SiO) into a trench (for example, an opening H1 (see FIG. 7B)) provided on the semiconductor layer 100S. It is to be noted that a metallic material having a light blocking effect such as tungsten (W) may be embedded in the inside of the insulating film of the separation part 115. This makes it possible to electrically and optically separate adjacent pixels 541 from each other.

In the present embodiment, the semiconductor layer 100S has a structure in which the surface 100S1 is uneven. Specifically, the semiconductor layer 100S has a plurality of projections 100X with respect to each pixel 541, on the surface 100S1, and, as illustrated in FIG. 5, the FD 114 is formed on top of each of the plurality of projections 100X. At the bottom of each of the plurality of projections 100X, for example, a p-type semiconductor layer 113 having a higher impurity concentration than the p-well layer 112 is formed; the p-type semiconductor layer 113 serves as an overflow path. That is, in each of the plurality of projections 100X, the p-type semiconductor layer 113, the p-well layer 112, and the FD 114 are stacked in this order from the side of the n-type semiconductor region 111. The transfer gate TG is provided around multiple projections 100X, and is formed to cause its upper surface to be positioned lower than the FD 114. Specifically, it is formed to cause the upper surface of the transfer gate TG to be positioned, for example, on a side surface of, of the p-type semiconductor layer 113, the p-well layer 112, and the FD 114 stacked in the Y-axis direction, the p-well layer 112. Thus, it is possible to secure the distance between the FD 114 and the transfer gate TG in a height direction (the Y-axis direction).

The contact layer 117 is embedded in the surface 100S1 of the semiconductor layer 100S above the separation part 115, and, on its side surface, is electrically coupled to the semiconductor layer 100S. More specifically, a portion of the surface 100S1 of the semiconductor layer 100S embedded with the contact layer 117 is a recess 100Y. Thus, it is possible to secure the distance between the FD 114 and the contact layer 117 in the height direction (the Y-axis direction).

On the surface 100S1 of the semiconductor layer 100S and a side surface of the semiconductor layer 100S provided with the separation part 115, for example, a pinning region 116 including a p-type semiconductor region is formed. Furthermore, although not illustrated, a pinning region may be provided on the surface 100S2 of the semiconductor layer 100S as well. Thus reduces the generation of dark current caused by an interface state of the semiconductor layer 100S.

The wiring layer 100T provided between the semiconductor layer 100S and the second substrate 200 includes an interlayer insulating layer 121, the above-described transfer gate TG, and a plurality of the contacts 122. The interlayer insulating layer 121 is provided over the entire surface of the semiconductor layer 100S, and buries projections and recesses on the front surface (the surface 100S1) of the semiconductor layer 100S. Within the interlayer insulating layer 121, further, one or more wires are formed, and the plurality of contacts 122 is embedded in its front surface opposed to the second substrate 200. The interlayer insulating layer 121 includes, for example, a silicon oxide film. It is to be noted that a configuration of the wiring layer 100T is not limited to the above-described one, and it only has to include a wire and an insulating film.

The plurality of contacts 122 is exposed on a surface of the wiring layer 100T. Some of the contacts 122 are coupled to, for example, the FD 114 provided with respect to each pixel 541, and are coupled to the pixel circuit 210 (for example, the gate of the amplifier transistor AMP) through the contacts 222 provided on the side of the second substrate 200. Furthermore, some of the contacts 122 are coupled to the contact layer 117, and are coupled to, for example, the reference potential line VSS provided in the third substrate 300 through the contacts 222, etc. provided on the side of the second substrate 200. The plurality of contacts 122 is used for bonding to the second substrate 200. The plurality of contacts 122 includes, for example, metal such as copper (Cu) or aluminum (Al).

The second substrate 200 includes the semiconductor layer 200S, a wiring layer 200T-1 provided on the side of a front surface (a surface 200S1) of the semiconductor layer 200S, and a wiring layer 200T-2 provided on the side of a back surface (a surface 200S2) of the semiconductor layer 200S. The semiconductor layer 200S includes a silicon substrate. The semiconductor layer 200S is provided with a well region 211 throughout in a thickness direction. The well region 211 is, for example, a p-type semiconductor region. The second substrate 200 is provided with pixel circuits 210 provided, for example, one for two adjacent pixels in the V direction in a unit cell 539. This pixel circuit 210 is provided, for example, on the side of the front surface (the surface 200S1) of the semiconductor layer 200S (the wiring layer 200T-1 side). In the imaging device 1, the second substrate 200 is bonded to the first substrate 100 in such a manner that a front surface of the second substrate 200 (the side of the surface 200S1 of the semiconductor layer 200S) is opposed to the front surface side (the wiring layer 100T side) of the first substrate 100. That is, the second substrate 200 is bonded to the first substrate 100 face-to-face.

The second substrate 200 further includes an insulating region 212 that divides the semiconductor layer 200S. The insulating region 212 has substantially the same thickness as the thickness of the semiconductor layer 200S, and the semiconductor layer 200S is divided by this insulating region 212. The insulating region 212 includes, for example, silicon oxide.

The wiring layer 200T-1 includes an interlayer insulating layer 221, gates of various transistors (the selection transistor SEL, the amplifier transistor AMP, the reset transistor RST, and the FD conversion gain switching transistor FDG) constituting the pixel circuit 210, and a plurality of the contacts 222. The interlayer insulating layer 221 is provided over the entire surface of the semiconductor layer 200S. Within the interlayer insulating layer 221, further, one or more wires are formed. The plurality of contacts 222 is exposed on a surface of the wiring layer 200T-1 opposed to the first substrate 100. The plurality of contacts 222 is used for bonding to the first substrate 100. The interlayer insulating layer 221 includes, for example, a silicon oxide film. The plurality of contacts 222 includes, for example, metal such as copper (Cu) or aluminum (Al). It is to be noted that a configuration of the wiring layer 200T-1 is not limited to the above-described one, and it only has to include a wire and an insulating film.

The wiring layer 200T-2 includes an interlayer insulating layer 231 and a plurality of contacts 232. The interlayer insulating layer 231 is provided over the entire surface of the semiconductor layer 200S. Inside the interlayer insulating layer 231, further, one or more wires are formed. The plurality of contacts 232 is exposed on a surface of the wiring layer 200T-2 opposed to the third substrate 300. The plurality of contacts 232 is used for bonding to the third substrate 300. The interlayer insulating layer 231 includes, for example, a silicon oxide film. The plurality of contacts 232 includes, for example, metal such as copper (Cu) or aluminum (Al). It is to be noted that a configuration of the wiring layer 200T-2 is not limited to the above-described one, and it only has to include a wire and an insulating film.

The third substrate 300 includes, for example, the wiring layer 300T and the semiconductor layer 300S in this order from the side of the second substrate 200. For example, a front surface of the semiconductor layer 300S is provided on the side of the second substrate 200. The semiconductor layer 300S includes a silicon substrate. Circuits are provided in a part of the front surface side of this semiconductor layer 300S. Specifically, in the part of the front surface side of the semiconductor layer 300S, for example, at least some of the input section 510A, the row driving section 520, the timing control section 530, the column signal processing section 550, the image signal processing section 560, and the output section 510B are provided. The wiring layer 300T provided between the semiconductor layer 300S and the second substrate 200 includes, for example, an interlayer insulating layer 321 and a plurality of the contacts 332. The plurality of contacts 322 is exposed on a surface of the wiring layer 200T, and the plurality of contacts 322 is electrically coupled to a circuit (for example, at least any of the input section 510A, the row driving section 520, the timing control section 530, the column signal processing section 550, the image signal processing section 560, and the output section 510B) formed in the semiconductor layer 300S. The plurality of contacts 322 is used for bonding to the second substrate 200. The plurality of contacts 322 includes, for example, metal such as copper (Cu) or aluminum (Al).

### [Method for Manufacturing Imaging Device]

FIGs. 7A to 7L illustrate an example of a method for manufacturing the imaging device 1 (particularly, the first substrate 100) illustrated in FIG. 1.

First, as illustrated in FIG. 7A, an n-type semiconductor region that serves as the p-type semiconductor layer 113, the p-well layer 112, and the FD 114 is formed on the side of the surface 100S1 of the semiconductor layer 100S. Then, as illustrated in FIG. 7B, a mask 601 is formed on the surface 100S1 of the semiconductor layer 100S, and, for example, the opening H1 that goes through the semiconductor layer 100S is formed by photolithography and etching.

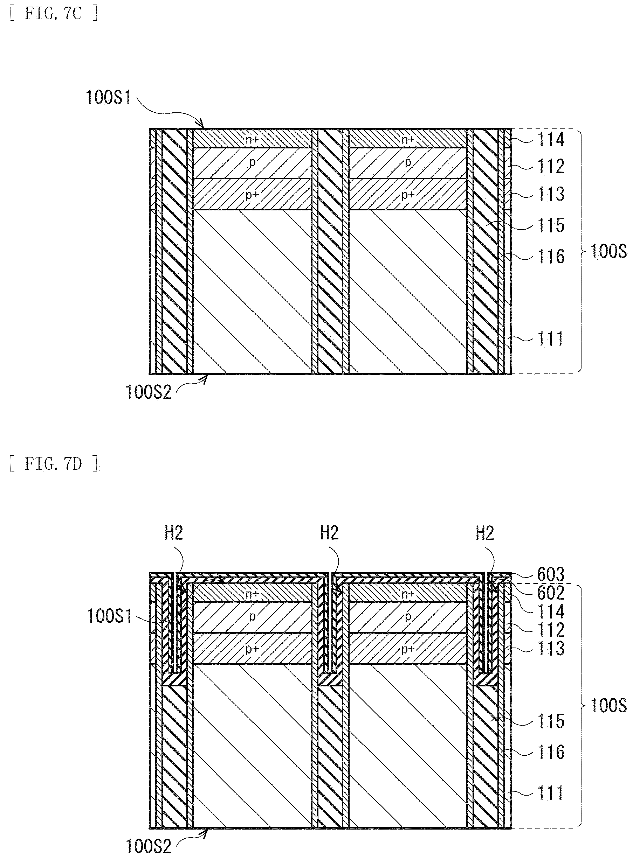

Next, as illustrated in FIG. 7C, for example, the p-type pinning region 116 is formed on a side surface of the opening H1 by conformal doping, and then, for example, a SiO film that serves as the separation part 115 is formed inside the opening H1, for example, by chemical vapor deposition (CVD). After that, for example, the SiO film formed on the surface 100S1 of the semiconductor layer 100S is ground by chemical mechanical polishing (CMP). Thus, the separation part 115 is formed.

Then, as illustrated in FIG. 7D, an opening H2 that serves as the recess 100Y is formed by etching back the separation part 115, and then, using, for example, an atomic layer deposition (ALD) method, insulating films 602 and 603 having different etching rates from each other are formed in turn on the surface 100S1 of the semiconductor layer 100S and an exposed side surface of the semiconductor layer 100S.

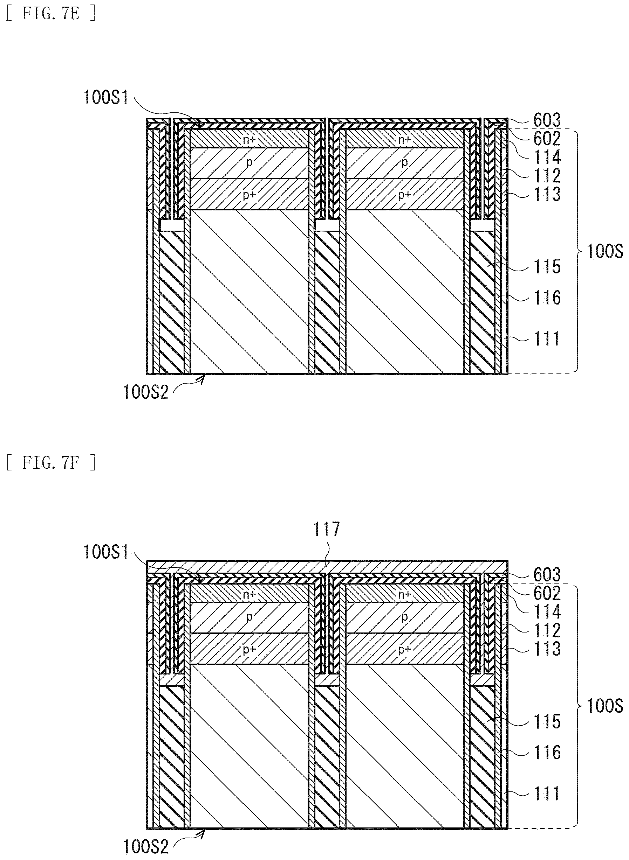

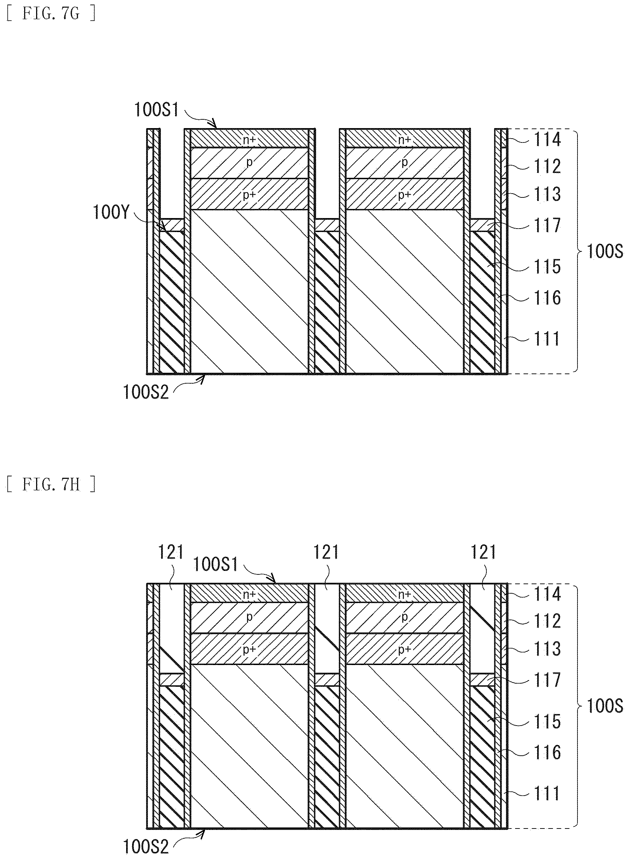

Next, as illustrated in FIG. 7E, the insulating film 602 formed on the separation part 115 is removed by isotropic etching, and after that, a polysilicon film that serves as the contact layer 117 is formed as illustrated in FIG. 7F. Then, as illustrated in FIG. 7G, the contact layer 117 is formed on the separation part 115 by etching back the insulating films 602 and 603 thereby removing them.

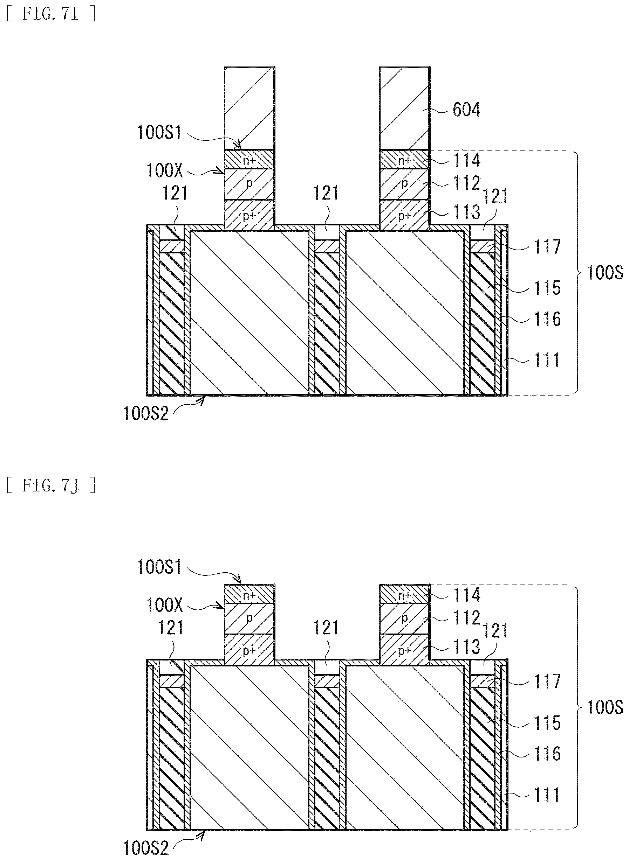

Next, as illustrated in FIG. 7H, for example, a SiO film that serves as the interlayer insulating layer 121 is formed on the contact layer 117, for example, by CVD to embed the opening H2. Then, as illustrated in FIG. 7I, a mask 640 is formed in a predetermined position on the semiconductor layer 100S, and after that, the projection 100X is formed by photolithography and etching. After that, the p-type pinning region 116 is formed on the surface 100S1 of the semiconductor layer 100S exposed from the mask 604 by conformal doping.

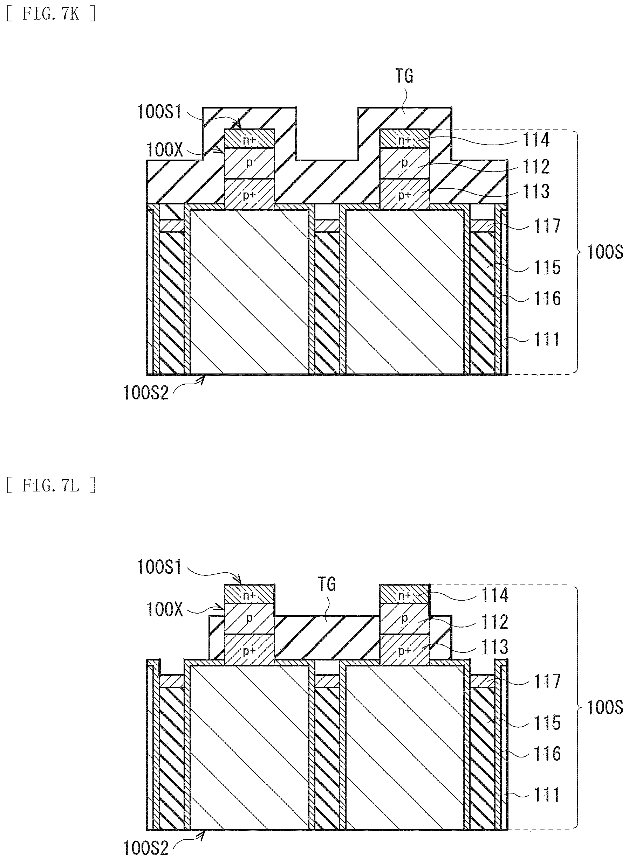

Next, the mask 604 is removed as illustrated in FIG. 7J, and after that, as illustrated in FIG. 7K, a polysilicon film that serves as the transfer gate TG is formed to cover the surface 100S1 of the semiconductor layer 100S including the projection 100X. Then, as illustrated in FIG. 7L, the transfer gate TG is formed by processing the polysilicon film, for example, by photolithography and etching and CMP. After that, for example, a SiO film, a wire, and the contact 122 that serve as the interlayer insulating layer 121 are formed to form the wiring layer 100T. Through the above process, the first substrate 100 illustrated in FIG. 5 is completed.

### [Operation of Imaging Device]

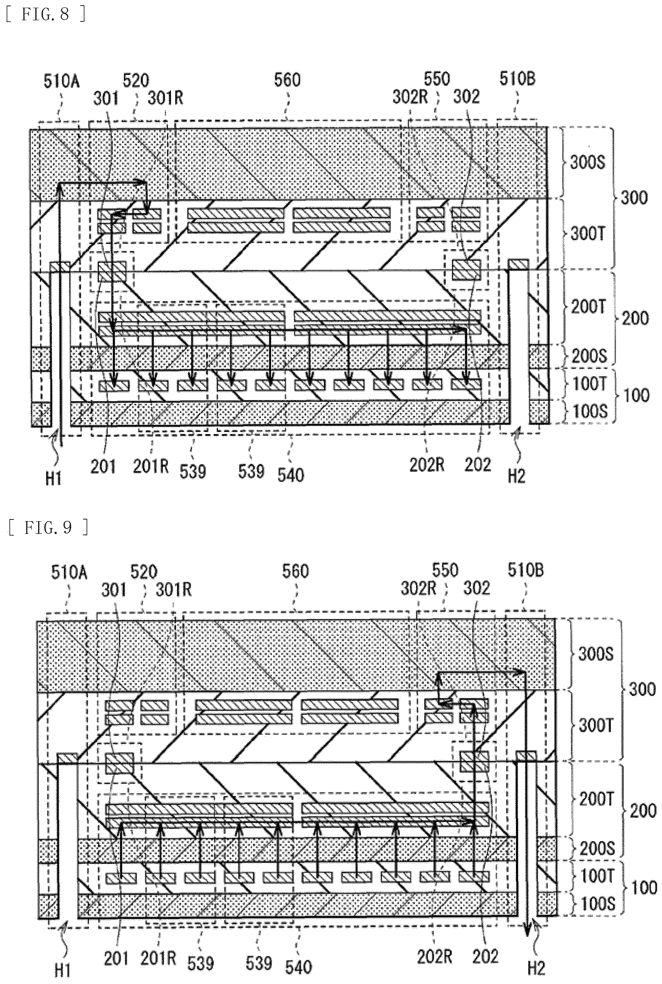

Subsequently, the operation of the imaging device 1 is described with FIGs. 8 and 9. FIGs. 8 and 9 are what arrows indicating a path of each signal are added to FIG. 3. FIG. 8 illustrates a path of an input signal input from the outside to the imaging device 1, a power supply potential, and a reference potential by arrows. FIG. 9 illustrates a signal path of a pixel signal output from the imaging device 1 to the outside. For example, an input signal (for example, a pixel clock and a synchronization signal) input to the imaging device 1 through the input section 510A is transmitted to the row driving section 520 of the third substrate 300, and a row drive signal is created in the row driving section 520. This row drive signal is transmitted to the second substrate 200 through the contacts 301 and 201. Furthermore, this row drive signal reaches each of the unit cells 539 of the pixel array section 540 through the row drive signal lines 542 within the wiring layer 200T. Of the row drive signals that have reached the unit cells 539 in the second substrate 200, drive signals other than one for the transfer gate TG are input to the pixel circuit 210, and the respective transistors included in the pixel circuit 210 are driven. A drive signal for the transfer gate TG is input to the transfer gate TG in the first substrate 100, and pixels 541 are driven (FIG. 8). Furthermore, the power supply potential and the reference potential that have been supplied from the outside to the input section 510A (the input terminal 511) in the third substrate 300 are transmitted to the second substrate 200 through the contacts 301 and 201, and are supplied to the pixel circuit 210 of each unit cell 539 through the wire within the wiring layer 200T. The reference potential is also supplied to the pixels 541 in the first substrate 100. Meanwhile, pixel signals subjected to photoelectric conversion by the pixels 541 in the first substrate 100 are transmitted to the pixel circuit 210 in the second substrate 200 with respect to each unit cell 539. Pixel signals based on these pixel signals are transmitted from the pixel circuit 210 to the third substrate 300 through the vertical signal line 543 and the contacts 202 and 302. These pixel signals are processed by the column signal processing section 550 and the image signal processing section 560 in the third substrate 300, and then are output to the outside through the output section 510B.

### [Effects]

In the imaging device 1 of the present embodiment, within the semiconductor layer 100S having a pair of surfaces opposed to each other (the surfaces 100S1 and 100S2), a plurality of projections 100X is provided on the surface 100S1, the FD 114 is provided on top of each projection 100X, and the transfer gate TG is provided around multiple projections 100X and to be located below the FD 114. Thus, the distance between the FD 114 and the transfer gate TG is secured in the height direction.

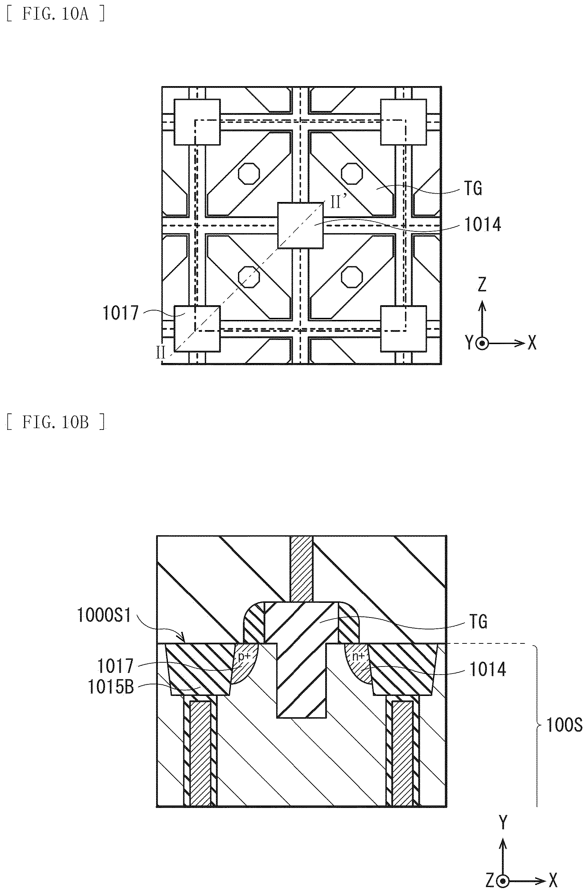

As described above, in recent years, a three-dimensional structural imaging element has been developed to make an imaging device smaller and achieve the high density of pixels. In the three-dimensional structural imaging element, for example, a first substrate is provided with sensor pixels that perform photoelectric conversion, and a second substrate stacked on top of the first substrate is provided with a readout circuit. In the first substrate, as the sensor pixels, an FD 1014, a transfer transistor (a transfer gate TG), and a well contact (a contact layer 1017) are laid out, for example, as illustrated in FIG. 10A.

However, in a fine pixel structure, for example, with a pixel pitch of 0.5 µm or less, an effective pixel region is narrow; for example, a cross-section corresponding to a line II-II' illustrated in FIG. 10A is as illustrated in FIG. 10B, where the distances among the FD 1014, the transfer gate TG, and the contact layer 1017 become closer, and the electric field intensity becomes higher. Thus, the three-dimensional structural imaging element is disadvantageous in that a dark current component caused by an electric field is increased.

Meanwhile, in the present embodiment, as described above, within the semiconductor layer 100S having a pair of surfaces opposed to each other (the surfaces 100S1 and 100S2), a plurality of projections 100X is provided on the surface 100S1, the FD 114 is provided on top of each projection 100X, and the transfer gate TG is provided around multiple projections 100X and to be located below the FD 114. Thus, the distance between the FD 114 and the transfer gate TG is secured in the height direction, and an electric field between the FD 114 and the transfer gate TG is relaxed.

As above, in the imaging device 1 of the present embodiment, it is possible to achieve an imaging device having a three-dimensional structure that allows the reduction of generation of dark current. Furthermore, it is possible to improve the charge transfer efficiency.

Furthermore, in the present embodiment, the contact layer 117 is formed in the recess 100Y of the semiconductor layer 100S; thus, besides the distance between the FD 114 and the transfer gate TG, the distance from the contact layer 117 is also secured in the height direction. Therefore, an electric field between the transfer gate TG and the contact layer 117 is relaxed, which makes it possible to further reduce the generation of dark current.

A second embodiment and modification examples 1 to 5, and an application example and a practical application example will be described below. In the following description, a component similar to that of the above-described first embodiment is assigned the same reference numeral, and its description is omitted accordingly.

### <2. Modification Examples>

### (2-1. Modification Example 1)

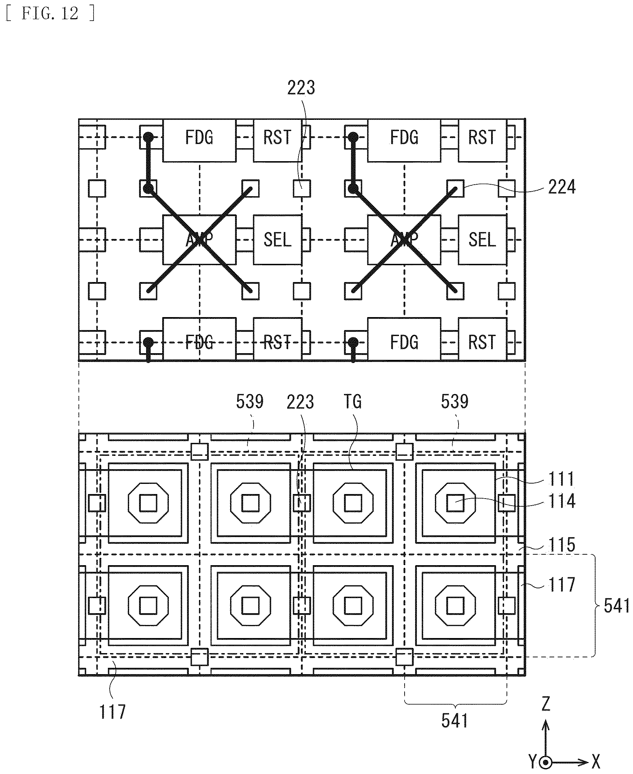

FIG. 11 illustrates an example of a cross-sectional configuration of an imaging device (an imaging device 1A) according to Modification Example 1 of the present disclosure. FIG. 12 schematically illustrates an example of a planar layout of the first substrate 100 and the second substrate 200 of the imaging device 1A illustrated in FIG. 11.

The above-described first embodiment provides an example where the second substrate 200 is bonded to the first substrate 100 face-to-face in such a manner that the front surface (the surface 200S1) of the semiconductor layer 200S provided with the various transistors (the selection transistor SEL, the amplifier transistor AMP, the reset transistor RST, and the FD conversion gain switching transistor FDG) constituting the pixel circuit 210 is opposed to the first substrate 100; however, the present disclosure is not limited to this. For example, like the imaging device 1A illustrated in FIG. 11, in a case where the various transistors (the selection transistor SEL, the amplifier transistor AMP, the reset transistor RST, and the FD conversion gain switching transistor FDG) constituting the pixel circuit 210 are in a three-dimensional structure such as a Fin-FET, the second substrate 200 may be bonded to the first substrate 100 in such a manner that the back surface side of the second substrate 200 (the surface 200S2 of the semiconductor layer 200S) is opposed to the front surface side (the wiring layer 100T side) of the first substrate 100. That is, the second substrate 200 may be bonded to the first substrate 100 face-to-back.

In this way, in the imaging device 1A with the first substrate 100 and the second substrate 200 bonded face-to-back, for example, the FD 114 provided in the first substrate 100 and the gate of the amplifier transistor AMP provided in the second substrate 200, and the transfer gate TG provided in the first substrate and the reference potential line VSS provided in the third substrate 300 are able to be electrically coupled, for example, through the through-electrodes 223 and 224.

In such a configuration, it is possible to obtain effects similar to those of the above-described first embodiment.

### (2-2. Modification Example 2)

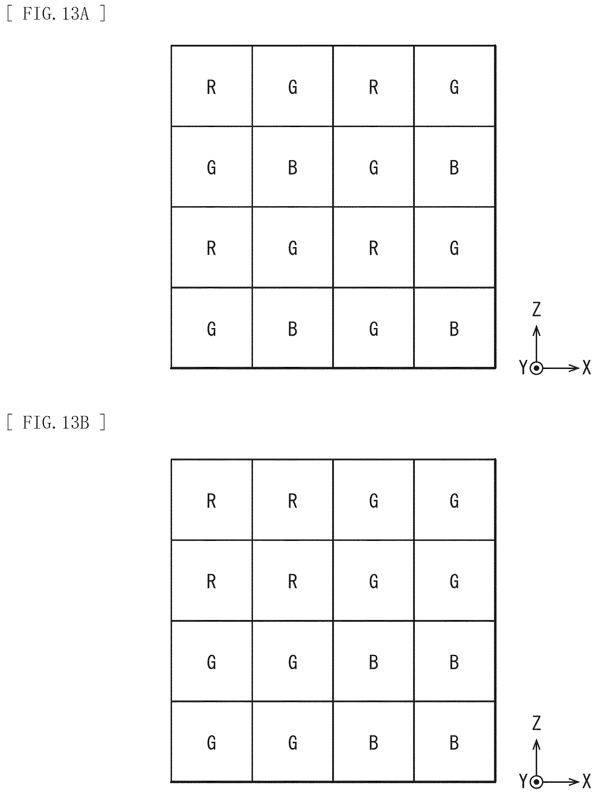

FIG. 13A schematically illustrates an example of a pixel array of an imaging device according to Modification Example 2 of the present disclosure. FIG. 13B schematically illustrates another example of the pixel array of the imaging device according to Modification Example 2 of the present disclosure. The device structure described in the above-described first embodiment and Modification Example 1 is also applicable to an imaging device having, for example, a Bayer array illustrated in FIG. 13A or a Quad Bayer array illustrated in FIG. 13B. It is to be noted that in a case of a Quad Bayer array, the FDs 114 for the same color pixels are coupled to each other, for example, by a Cu wire or the like.

### <3. Second Embodiment>

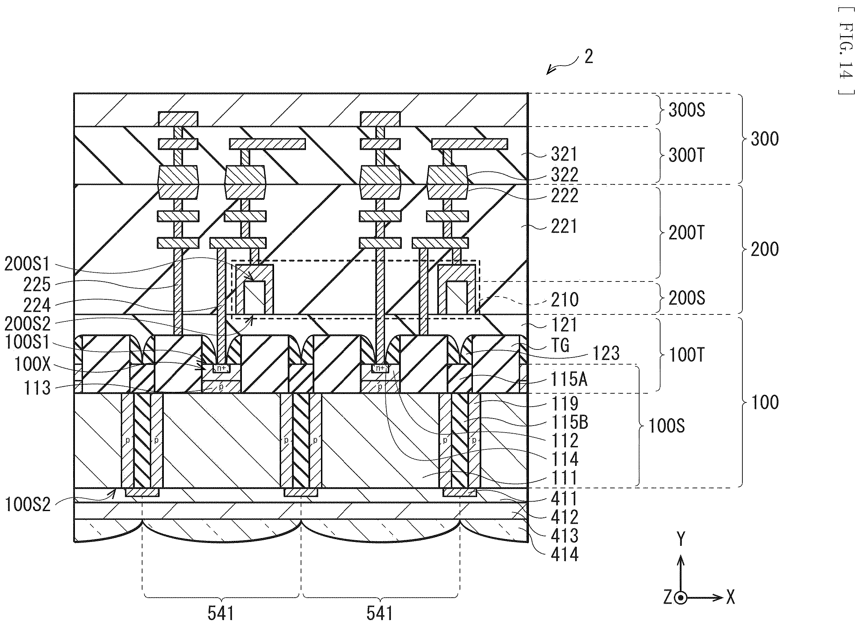

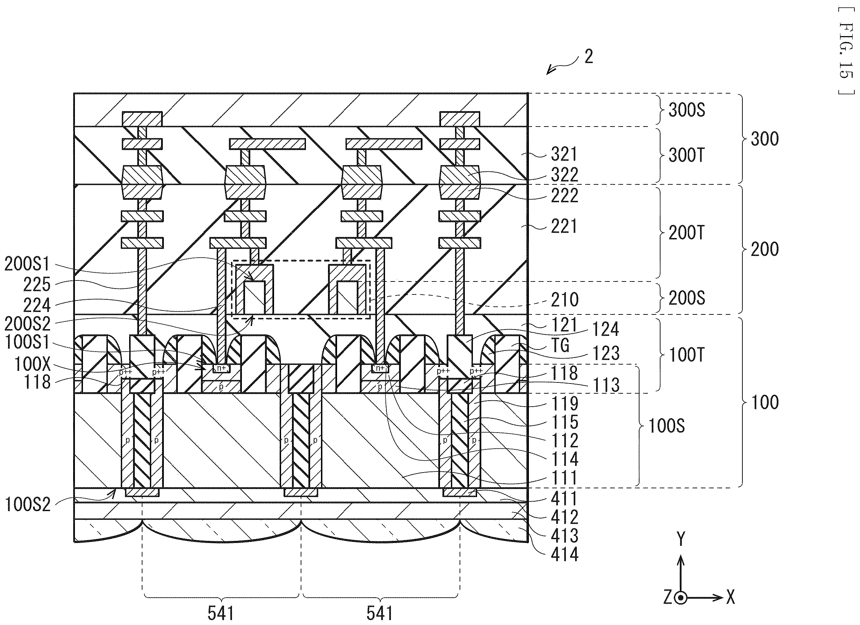

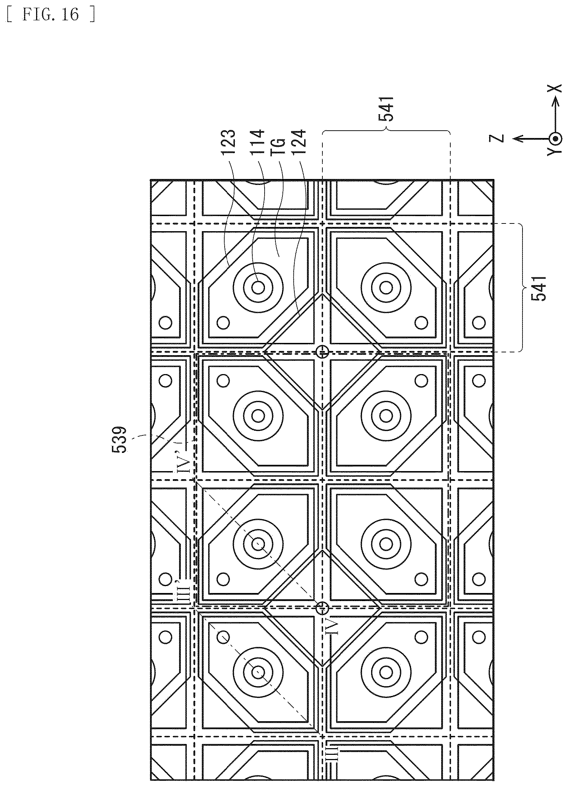

FIG. 14 illustrates an example of a cross-sectional configuration of an imaging device (an imaging device 2) according to the second embodiment of the present disclosure in a direction perpendicular to the principal surfaces of the first substrate 100, the second substrate 200, and the third substrate 300. FIG. 15 illustrates an example of a cross-sectional configuration of the imaging device 2 according to the second embodiment of the present disclosure in a direction perpendicular to the principal surfaces of the first substrate 100, the second substrate 200, and the third substrate 300 that are located in different positions from those in FIG. 14. FIG. 16 schematically illustrates an example of a planar layout of the imaging device 2 according to the second embodiment of the present disclosure; FIGs. 14 and 15 correspond to cross-sections along a line III-III' and a line IV-IV' illustrated in FIG. 16, respectively.

### [Cross-sectional Configuration of Imaging Device]

In the imaging device 2, as with the above-described first embodiment, the first substrate 100, the second substrate 200, and the third substrate 300 are stacked on top of another in this order. The imaging device 2 further includes the light receiving lens 414 on the side of the back surface (the side of the light incident surface) of the first substrate 100. Between the light receiving lens 414 and the first substrate 100, for example, the light-shielding film 411, the protective layer 412, and the color filter layer 413 are provided. The light receiving lens 414 is provided, for example, in each of pixels 541A, 541B, 541C, and 541D. The imaging device 2 is, for example, a back-illuminated imaging device. The imaging device 2 includes the pixel array section 540 disposed in the middle and the peripheral section (not illustrated) disposed outside the pixel array section 540.

The first substrate 100 includes the semiconductor layer 100S and the wiring layer 100T. The semiconductor layer 100S includes, for example, a silicon substrate. The semiconductor layer 100S has a pair of surfaces opposed to each other (the front surface (the surface 100S1) and the back surface (the surface 100S2)). The semiconductor layer 100S includes the p-well layer 112 in a portion of the surface 100S1 and its adjacent region, and includes the n-type semiconductor region 111 in the other region (a region deeper than the p-well layer 112). For example, this n-type semiconductor region 111 and the p-well layer 112 constitute a p-n junction type photodiode PD. The p-well layer 112 is a p-type semiconductor region.

The FD 114 and a contact region 118 are provided adjacent to the front surface of the semiconductor layer 100S. The FD 114 includes an n-type semiconductor region provided within the p-well layer 112. The FD 114 is provided with respect to each pixel 541. For example, as illustrated in FIG. 16, the FD 114 provided with respect to each pixel 541 is provided in substantially the middle of the pixel 541. As will be described in detail later, the respective FDs 114 (FD1, FD2, FD3, and FD4) provided in four pixels 541A, 541B, 541C, and 541D constituting a unit cell 539 are, within the first substrate 100 (more specifically, within the wiring layer 100T), electrically coupled to one another through the electrical coupling means (wires within the wiring layer 100T). Furthermore, the FD 114 is coupled from the first substrate 100 to the second substrate 200 (more specifically, from the wiring layer 100T to the wiring layer 200T) through the electrical means (for example, the contacts 122 and 222, etc.). In the second substrate 200 (more specifically, inside the wiring layer 200T), the FD 114 is electrically coupled by this electrical means to the gate of the amplifier transistor AMP and the source of the FD conversion gain switching transistor FDG that constitute the pixel circuit 210.

The contact region 118 is a region electrically coupled to the reference potential line VSS, and is disposed away from the FD 114. The contact region 118 is provided, for example, between adjacent unit cells 539 in the V direction (the Z-axis direction). The contact region 118 includes, for example, a p-type semiconductor region. The contact region 118 is coupled to, for example, a ground potential or a fixed potential. This causes the semiconductor layer 100S to be supplied with a reference potential. The contact region 118 includes, for example, a p-type semiconductor region.

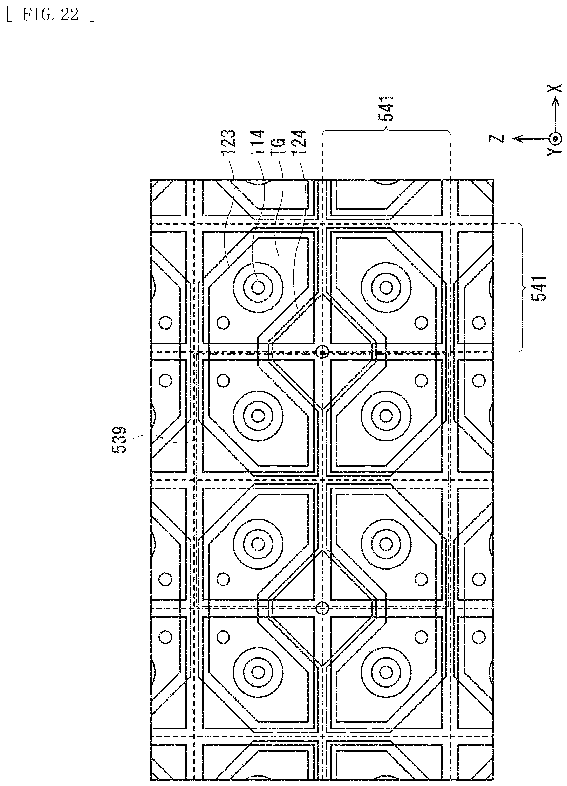

The first substrate 100 is provided with the transfer transistor TR in addition to the photodiode PD, the FD 114, and the contact region 118. The transfer transistor TR is provided with respect to each pixel 541. The transfer transistor TR has the transfer gate TG. As will be described in detail later, the transfer gate TG may be provided, for example, as illustrated in FIG. 16, around the FD 114 with respect to each pixel 541, or may be provided, for example, as illustrated in FIG. 22, for example, between adjacent unit cells 539 in the X-axis direction, continuously in two adjacent pixels 541 in the X-axis direction. This makes it possible to reduce the number of wires (for example, the number of the through-electrodes 224) extending in the stack direction (the Y-axis direction).

The semiconductor layer 100S is provided with the separation part 115 that separates adjacent pixels 541 from each other. The separation part 115 is formed to extend in the direction of normal to the semiconductor layer 100S (the Y-axis direction). The separation part 115 is provided to separate adjacent unit cells 539 and separate four pixels 541 (pixels 541A, 541B, 541C, and 541D) constituting a unit cell 539 from one another, and has, for example, a grid-like planar shape. For example, the separation part 115 electrically separates adjacent pixels 541 from each other. The separation part 115 may have, for example, an FTI structure as with the above-described first embodiment, or may have, for example, as illustrated in FIGs. 14 and 15, a structure in which it goes through between the surfaces 100S1 and 100S2 of the semiconductor layer 100S by a combination of a shallow trench isolation (STI) structure and a DTI structure in which it does not go through the semiconductor layer 100S. The separation part 115 is formed, for example, by embedding an insulating film such as silicon oxide (SiO) into a trench provided on the semiconductor layer 100S. It is to be noted that a metallic material having a light blocking effect such as tungsten (W) may be embedded in the inside of the insulating film of the separation part 115. This makes it possible to electrically and optically separate adjacent pixels 541 from each other. The semiconductor layer 100S is further provided with a p-type diffusion region 119 on the side surface of the separation part 115.

In the present embodiment, the semiconductor layer 100S has a structure in which the surface 100S1 is uneven. Specifically, the semiconductor layer 100S has a plurality of projections 100X on the surface 100S1, and, as illustrated in FIGs. 14 and 15, the FD 114 is formed on the upper surface of each of the plurality of projections 100X. At the bottom of each of the plurality of projections 100X, for example, the p-type semiconductor layer 113 having a higher impurity concentration than the p-well layer 112 is formed; the p-type semiconductor layer 113 serves as an overflow path. That is, in each of the plurality of projections 100X, the p-type semiconductor layer 113, the p-well layer 112, and the FD 114 are stacked in this order from the side of the n-type semiconductor region 111. The transfer gate TG is provided around multiple projections 100X, and is formed to cause its upper surface to be positioned higher than the FD 114. A side wall 123 is provided on a side surface of the transfer gate TG projecting more upward than the projections 100X. This makes it possible to secure the distance between the FD 114 and the transfer gate TG in the height direction (the Z-axis direction).

The contact region 118 is formed in the surface 100S1 of the semiconductor layer 100S above the separation part 115, and is electrically coupled to the semiconductor layer 100S.

The wiring layer 100T provided between the semiconductor layer 100S and the second substrate 200 includes the interlayer insulating layer 121, the above-described transfer gate TG, the plurality of contacts 122, and the contact region 118. The interlayer insulating layer 121 is provided over the entire surface of the semiconductor layer 100S, and buries projections and recesses on the front surface (the surface 100S1) of the semiconductor layer 100S. Within the interlayer insulating layer 121, further, one or more wires are formed, and the plurality of contacts 122 is embedded in its front surface opposed to the second substrate 200. The interlayer insulating layer 121 includes, for example, a silicon oxide film. A contact layer 124 includes, for example, polysilicon (poly-Si), more specifically, doped polysilicon doped with an impurity. It is to be noted that a configuration of the wiring layer 100T is not limited to the above-described one, and it only has to include a wire and an insulating film.

The plurality of contacts 122 is exposed on the surface of the wiring layer 100T. Some of the contacts 122 are coupled to, for example, the FD 114 provided with respect to each pixel 541, and are coupled to the pixel circuit 210 (for example, the gate of the amplifier transistor AMP) through the contacts 222 provided on the side of the second substrate 200. Furthermore, some of the contacts 122 are coupled to the contact region 118, and are coupled to, for example, the reference potential line VSS provided in the third substrate 300 through the contacts 222, etc. provided on the side of the second substrate 200. The plurality of contacts 122 is used for bonding to the second substrate 200. The plurality of contacts 122 includes, for example, metal such as copper (Cu) or aluminum (Al).

The second substrate 200 includes the semiconductor layer 200S and the wiring layer 200T provided on the side of the front surface (the surface 200S1) of the semiconductor layer 200S. The semiconductor layer 200S includes a silicon substrate. The semiconductor layer 200S is provided with the well region 211 throughout in the thickness direction. The well region 211 is, for example, a p-type semiconductor region. The second substrate 200 is provided with pixel circuits 210 provided, for example, one for two adjacent pixels in the V direction in a unit cell 539. This pixel circuit 210 is provided, for example, on the side of the front surface (the surface 200S1) of the semiconductor layer 200S (the wiring layer 200T side). In the imaging device 2, the second substrate 200 is bonded to the first substrate 100 in such a manner that the back surface of the second substrate 200 (the side of the surface 200S2 of the semiconductor layer 200S) is opposed to the front surface side (the wiring layer 100T side) of the first substrate 100. That is, the second substrate 200 is bonded to the first substrate 100 face-to-back.

The second substrate 200 further includes the insulating region 212 that divides the semiconductor layer 200S. The insulating region 212 has substantially the same thickness as the thickness of the semiconductor layer 200S, and the semiconductor layer 200S is divided by this insulating region 212. The insulating region 212 includes, for example, silicon oxide.

The wiring layer 200T includes the interlayer insulating layer 221, the gates of the various transistors (the selection transistor SEL, the amplifier transistor AMP, the reset transistor RST, and the FD conversion gain switching transistor FDG) constituting the pixel circuit 210, and the plurality of contacts 222. The interlayer insulating layer 221 is provided over the entire surface of the semiconductor layer 200S. Within the interlayer insulating layer 221, further, one or more wires are formed. The plurality of contacts 222 is exposed on the surface of the wiring layer 200T opposed to the first substrate 100. The plurality of contacts 222 is used for bonding to the third substrate 300. The interlayer insulating layer 221 includes, for example, a silicon oxide film. The plurality of contacts 222 includes, for example, metal such as copper (Cu) or aluminum (Al). It is to be noted that a configuration of the wiring layer 200T is not limited to the above-described one, and it only has to include a wire and an insulating film.

For example, the through-electrodes 223, 224, and 225 are disposed in the insulating region 212. The through-electrodes 223, 224, and 225 are provided to go through the insulating region 212 in the thickness direction. Respective upper ends of the through-electrodes 223, 224, and 225 are coupled to the wire of the wiring layer 200T. These through-electrodes 223, 224, and 225 are provided to go through the insulating region 212 and the interlayer insulating layer 121, and their lower ends are each coupled to the transfer gate TG, the FD 114, and the contact layer 124.

The through-electrode 223 electrically couples the transfer gate TG to the wire of the wiring layer 200T (a part of the row drive signal line 542). That is, the transfer gate TG of the first substrate 100 is electrically coupled to a wire TRG of the second substrate 200 by the through-electrode 223, and a drive signal is transmitted to each transfer transistor TR. The through-electrode 2224 electrically couples the FD 114 to the pixel circuit 210. That is, the FD 114 of the first substrate 100 is electrically coupled to the pixel circuit 210 of the second substrate 200 by the through-electrode 224. The through-electrode 225 electrically couples the contact layer 124 to the reference potential line VSS of the third substrate 300. That is, the contact layer 124 of the first substrate 100 is electrically coupled to the reference potential line VSS of the third substrate 300 by the through-electrode 225.

The third substrate 300 includes, for example, the wiring layer 300T and the semiconductor layer 300S in this order from the side of the second substrate 200. For example, the front surface of the semiconductor layer 300S is provided on the side of the second substrate 200. The semiconductor layer 300S includes a silicon substrate. Circuits are provided in a part of the front surface side of this semiconductor layer 300S. Specifically, in the part of the front surface side of the semiconductor layer 300S, for example, at least some of the input section 510A, the row driving section 520, the timing control section 530, the column signal processing section 550, the image signal processing section 560, and the output section 510B are provided. The wiring layer 300T provided between the semiconductor layer 300S and the second substrate 200 includes, for example, the interlayer insulating layer 321 and the plurality of contacts 332. The plurality of contacts 322 is exposed on the surface of the wiring layer 200T, and the plurality of contacts 322 is electrically coupled to a circuit (for example, at least any of the input section 510A, the row driving section 520, the timing control section 530, the column signal processing section 550, the image signal processing section 560, and the output section 510B) formed in the semiconductor layer 300S. The plurality of contacts 322 is used for bonding to the second substrate 200. The plurality of contacts 322 includes, for example, metal such as copper (Cu) or aluminum (Al).

### [Method for Manufacturing Imaging Device]

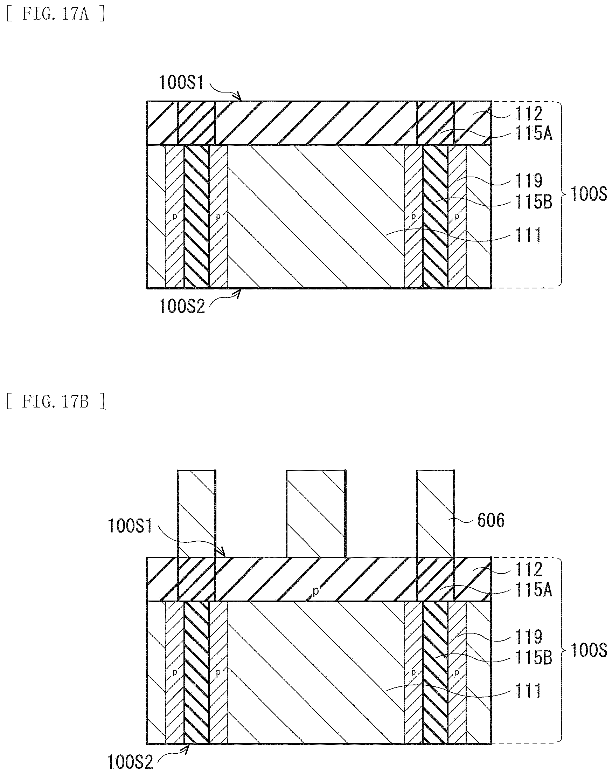

FIGs. 17A to 17G illustrate an example of a method for manufacturing the imaging device 2 (particularly, the first substrate 100) illustrated in FIG. 14, etc.

First, as illustrated in FIG. 17A, for example, a separation part 115A having an STI structure is formed on the side of the surface 100S1 of the semiconductor layer 100S, and after that, a separation part 115B having an DTI structure is formed from the side of the surface 100S2 of the semiconductor layer 100S, and the p-type diffusion region 119 is formed on its side surface.

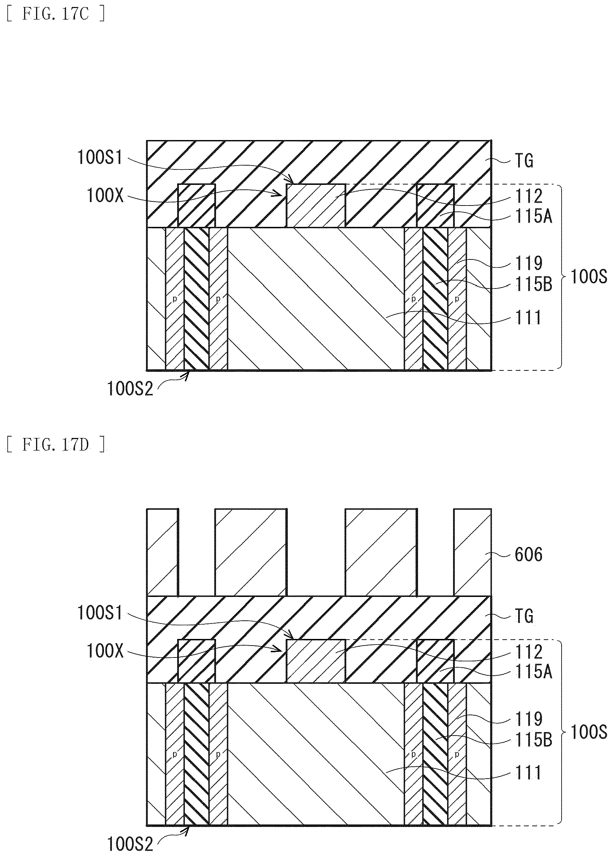

Next, as illustrated in FIG. 17B, a mask 605 is formed on the surface 100S1 of the semiconductor layer 100S, and after that, as illustrated in FIG. 17C, the projection 100X is formed, for example, by processing the semiconductor layer 100S by photolithography and etching. After that, a polysilicon film that serves as the transfer gate TG is formed to cover the surface 100S1 of the semiconductor layer 100S including the projection 100X.

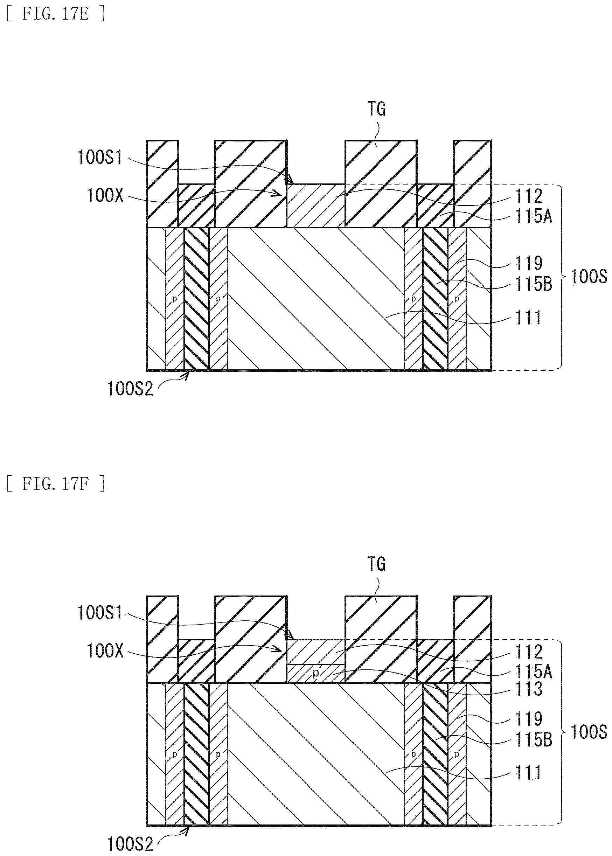

Then, as illustrated in FIG. 17D, a mask 606 is formed on the polysilicon film. Next, as illustrated in FIG. 17E, the polysilicon film is processed by photolithography and etching, and after that, derivatization processing is performed. Next, as illustrated in FIG. 17F, the p-type semiconductor layer 113 is formed on the bottom of a projection 100C.

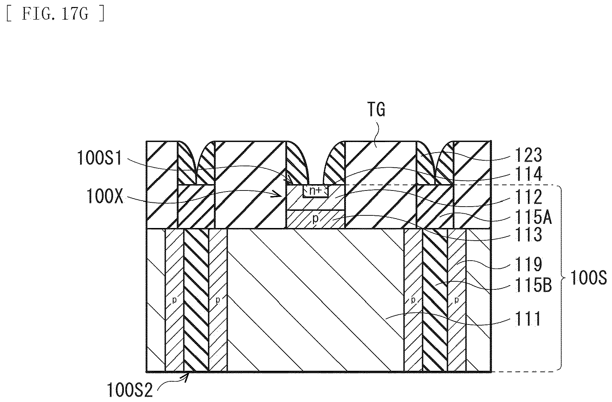

Then, as illustrated in FIG. 17G, the side wall 123 is provided on the side surface of the transfer gate TG projecting from the projection 100X, and after that, an n-type semiconductor region that serves as the FD 114 is formed on an upper surface of the projection 100X by self-alignment. After that, for example, a SiO film, a wire, and the contact 122 that serve as the interlayer insulating layer 121 are formed to form the wiring layer 100T. Through the above process, the first substrate 100 illustrated in FIG. 14, etc. is completed.

### [Effects]

In the imaging device 2 of the present embodiment, within the semiconductor layer 100S having a pair of surfaces opposed to each other (the surfaces 100S1 and 100S2), a plurality of projections 100X is provided on the surface 100S1, the FD 114 is provided on the upper surface of each projection 100X, and the transfer gate TG is provided around multiple projections 100X and to cause its upper surface to project more upward than the projection 100X provided with the FD 114. Thus, the distance between the FD 114 and the transfer gate TG is secured in the height direction, and an electric field between the FD 114 and the transfer gate TG is relaxed.

As above, in the imaging device 2 of the present embodiment, it is possible to achieve an imaging device having a three-dimensional structure that allows the reduction of generation of dark current. Furthermore, it is possible to improve the charge transfer efficiency.

### <4. Modification Examples>

### (4-1. Modification Example 3)

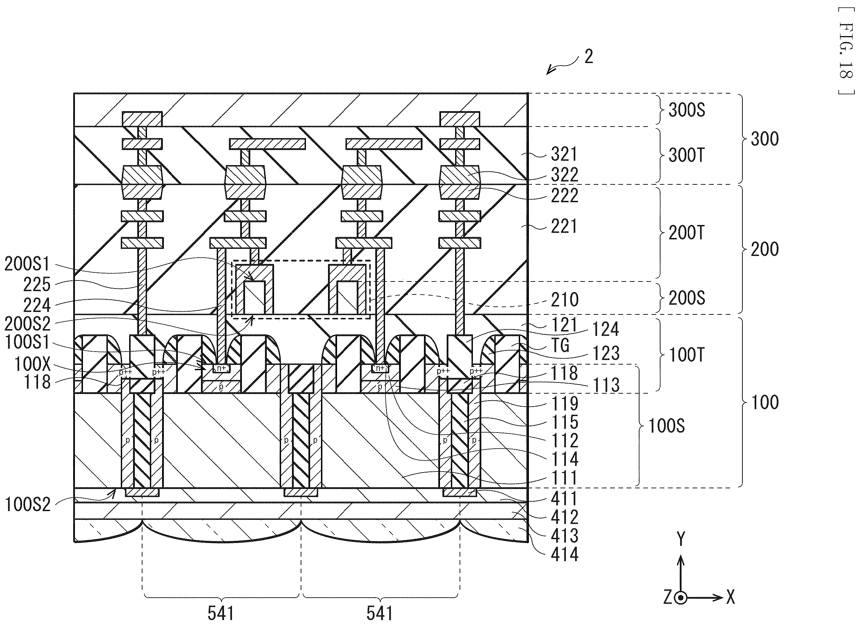

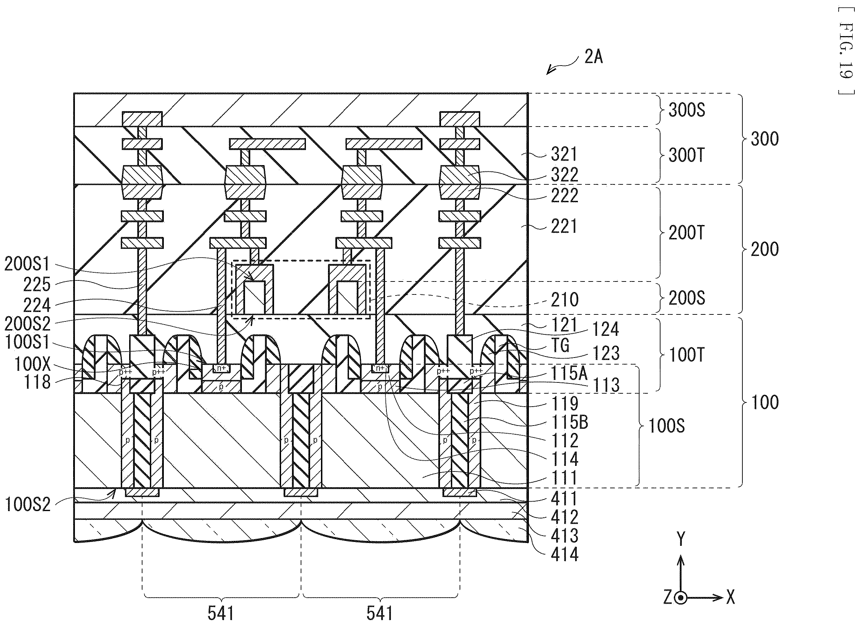

FIG. 18 illustrates an example of a cross-sectional configuration of an imaging device (an imaging device 2A) according to Modification Example 3 of the present disclosure in a direction perpendicular to the principal surfaces of the first substrate 100, the second substrate 200, and the third substrate 300. FIG. 19 illustrates an example of a cross-sectional configuration of the imaging device 2A according to the second embodiment of the present disclosure in a direction perpendicular to the principal surfaces of the first substrate 100, the second substrate 200, and the third substrate 300 that are located in different positions from those in FIG. 18. FIGs. 18 and 19 correspond to cross-sections along the line III-III' and the line IV-IV' illustrated in FIG. 16, respectively.

The side wall 123 provided on the side surface of the transfer gate TG projecting more upward than the projection 100X may be embedded in the transfer gate TG along a side surface of the projection 100X as illustrated in FIGs. 18 and 19.

Thus, in addition to the effects of the above-described second embodiment, there is obtained an effect that it is possible to achieve the reduction in the pixel size while maintaining the relaxation of the electric field.

### (4-2. Modification Example 4)

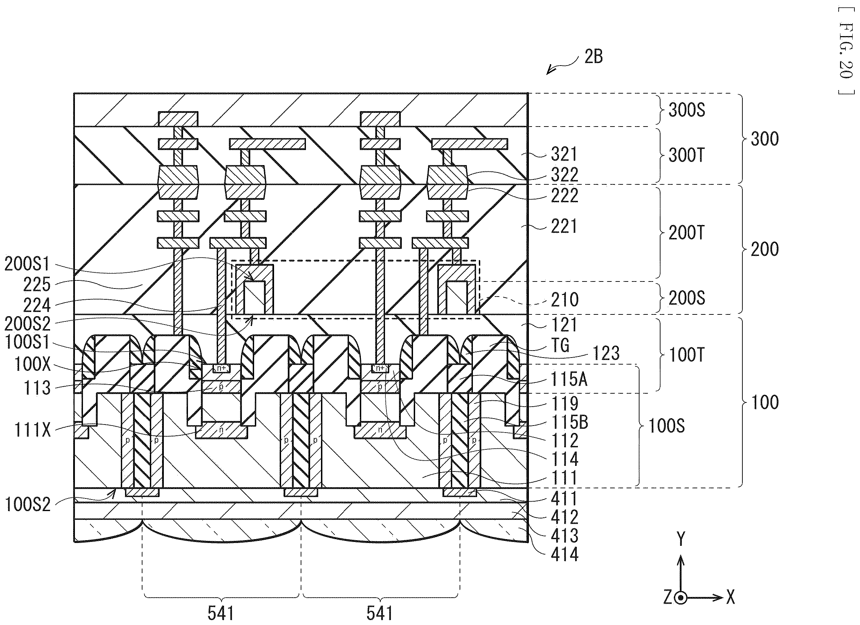

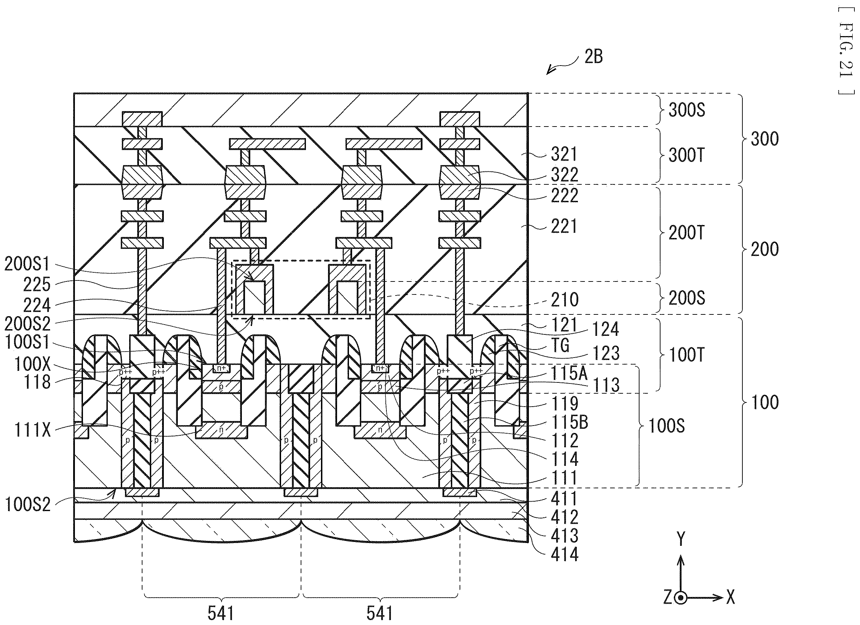

FIG. 20 illustrates an example of a cross-sectional configuration of an imaging device (an imaging device 2B) according to Modification Example 4 of the present disclosure in a direction perpendicular to the principal surfaces of the first substrate 100, the second substrate 200, and the third substrate 300. FIG. 21 illustrates an example of a cross-sectional configuration of the imaging device 2B according to the second embodiment of the present disclosure in a direction perpendicular to the principal surfaces of the first substrate 100, the second substrate 200, and the third substrate 300 that are located in different positions from those in FIG. 20. FIGs. 20 and 21 correspond to cross-sections along the line III-III' and the line IV-IV' illustrated in FIG. 16, respectively.

The transfer gate TG formed around the projection 100X may be partially embedded in the semiconductor layer 100S as illustrated in FIGs. 20 and 21. In other words, the transfer gate TG may be a vertical gate. Furthermore, an n-type semiconductor region 111X may be further provided between the transfer gates TG embedded in the semiconductor layer 100S.

Thus, in addition to the effects of the above-described second embodiment, there is obtained an effect that it is possible to achieve the reduction in the pixel size while maintaining the relaxation of the electric field.

### (4-3. Modification Example 5)

FIG. 22 schematically illustrates an example of a planar layout of an imaging device 2 according to Modification Example 5 of the present disclosure. For example, between adjacent unit cells 539 in the X-axis direction, the transfer gate TG may be provided continuously in two adjacent pixels 541 in the X-axis direction. This makes it possible to reduce the number of through-electrodes 2254, and thus it is possible to improve the area efficiency.

### <5. Third Embodiment>

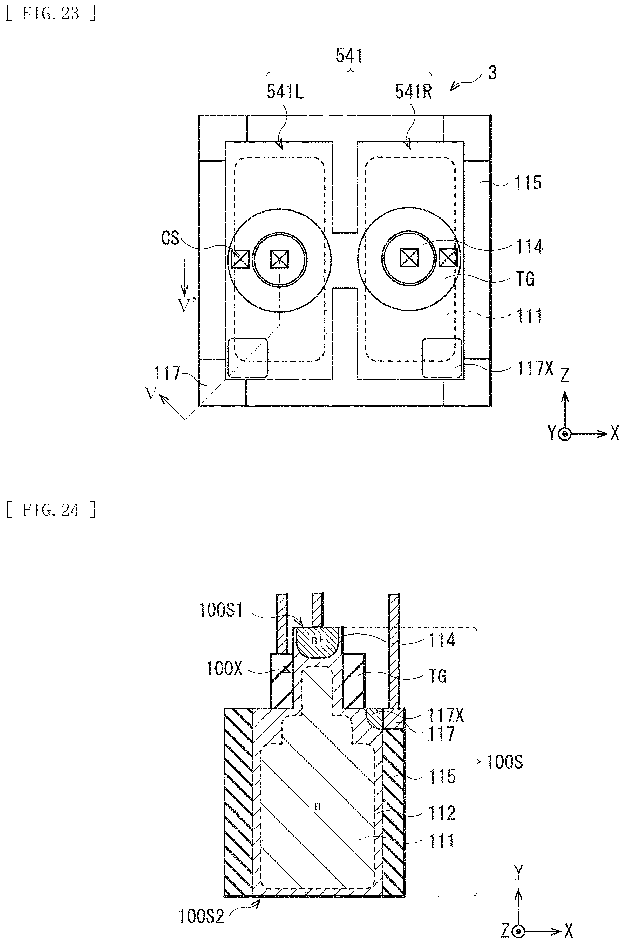

FIG. 23 schematically illustrates an example of a planar configuration of a pixel 541 of an imaging device (an imaging device 3) according to a third embodiment of the present disclosure. FIG. 24 schematically illustrates an example of a cross-sectional configuration corresponding to a line V-V' illustrated in FIG. 23.

### [Configuration of Imaging Device]

As with the above-described first embodiment, in the imaging device 3, the first substrate 100, the second substrate 200, and the third substrate 300 are stacked on top of another in this order. The imaging device 3 further includes the light receiving lens 414 on the side of the back surface (the side of the light incident surface) of the first substrate 100. Between the light receiving lens 414 and the first substrate 100, for example, the light-shielding film 411, the protective layer 412, and the color filter layer 413 are provided. The light receiving lens 414 is provided, for example, with respect to each pixel 541. The imaging device 3 is, for example, a back-illuminated imaging device. The imaging device 3 includes the pixel array section 540 disposed in the middle and the peripheral section disposed outside the pixel array section 540.

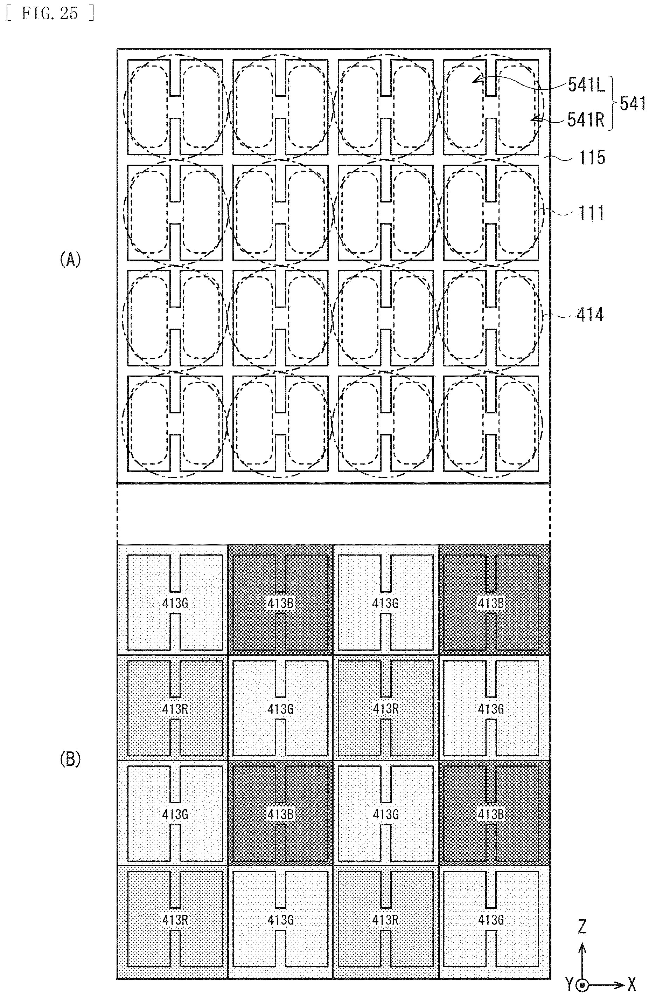

FIG. 25 schematically illustrates an example of a planar configuration of the pixel array section 540 in the imaging device 3. As with the imaging device 1 of the above-described first embodiment, in the pixel array section 540, pixels 541 are repeatedly arranged in an array. In the imaging device 3 of the present embodiment, all the pixels 541 constituting the pixel array section 540 are an image plane phase difference pixel. The image plane phase difference pixel divides a pupil region of an imaging lens, and photoelectrically converts a subject image from a divided pupil region and thereby generates a signal for phase difference detection.

Each of the pixels 541 constituting the pixel array section 540 is provided with, as illustrated in FIG. 25, one light receiving lens 414 (A) and, for example, any of a color filter 413R that selectively allows transmission of a wavelength in a red band, a color filter 413G that selectively allows transmission of a wavelength in a green band, and a color filter 413B that selectively allows transmission of a wavelength in a blue band (B). It is to be noted that the color filters 413R, 413G, and 413B are not limited to a Bayer array illustrated in a part (B) of FIG. 25, and may adopt various forms, for example, a Quad Bayer array, etc.

For example, as illustrated in a part (A) of FIG. 25, each pixel 541 includes a right pixel 541R and a left pixel 541L that are arranged in parallel in the X-axis direction. For example, as illustrated in FIGs. 23 and 24, the right pixel 541R and the left pixel 541L are each provided with the n-type semiconductor region 111 that constitutes the photodiode PD, the FD 114, and the transfer transistor TR. The right pixel 541R and the left pixel 541L are each further provided with a contact region 117X coupled to the contact layer 117.

On the front surface (the surface 100S1) of the semiconductor layer 100S, the pillar-like projection 100X is formed in each of the right pixel 541R and the left pixel 541L. The FD 114 is provided on the upper surface of the projection 100X. Furthermore, the gate (the transfer gate TG) of the transfer transistor is formed around the projection 100X. The transfer gate TG is provided, for example, below the projection 100X provided with the FD 114. The projection 100X formed in each of the right pixel 541R and the left pixel 541L is preferably formed, as illustrated in FIG. 23, in substantially the center of the n-type semiconductor region 111 constituting the photodiode PD in a planer view. This makes it possible to efficiently transfer an electric charge generated through photoelectric conversion to the FD 114.

### [Actions and Effects]

In a pixel for phase difference detection (an image plane phase difference pixel), phase difference information is acquired by a right pixel and a left pixel individually reading out an electric charge that has been photoelectrically converted by the right and left pixels. Thus, it is necessary to drive the transfer gates of the right and left pixels independently of each other.

Incidentally, in a fine pixel structure like the one described above, for example, with a pixel pitch of 0.5 µm or less, the degree of freedom of a layout in one pixel is constrained. If a general planar type transistor is used in the fine pixel structure, the area of formation of the transistor is not sufficiently able to be secured, thus the transfer efficiency is worsened, which causes, for example, degradation of the image quality in a low light condition.

For the purpose of improving the transfer efficiency, the introduction of an embedded gate that three-dimensionally expands a transfer gate has been promoted. However, in the embedded gate of the planar type transistor, a channel through which an electric charge is transferred is likely to be influenced by an impurity, etc. for separation of photodiodes or elements, and that influence becomes stronger as it becomes finer, thus the difficulty of design is increased, and it becomes difficult to ensure the characteristics of the transistor.

Meanwhile, in the present embodiment, in the imaging device 3 in which all the pixels 541 constituting the pixel array section 540 are an image plane phase difference pixel, in each of the right pixel 541R and the left pixel 541L, the projection 100X is provided on the surface 100S1 of the semiconductor layer 100S, and the FD 114 is provided on the upper surface of each projection 100X, and the transfer gate TG is provided around multiple projections 100X and to be located below the projection 100X provided with the FD 114. Thus, the distance between the FD 114 and the transfer gate TG is secured in the height direction, and the electric field between the FD 114 and the transfer gate TG is relaxed. In addition, it is possible to protect a transfer channel from an external impurity.

As above, in the imaging device 3 of the present embodiment, it is possible to achieve an imaging device having a three-dimensional structure that allows the reduction of generation of dark current. Furthermore, it is possible to improve the charge transfer efficiency in the imaging device (the imaging device 3) in which all the pixels 541 constituting the pixel array section 540 are an image plane phase difference pixel.

Furthermore, in the present embodiment, the projection 100X formed in each of the right pixel 541R and the left pixel 541L is formed in substantially the center of the n-type semiconductor region 111 constituting the photodiode PD in a planer view. Thus, it is possible to further improve the charge transfer efficiency.

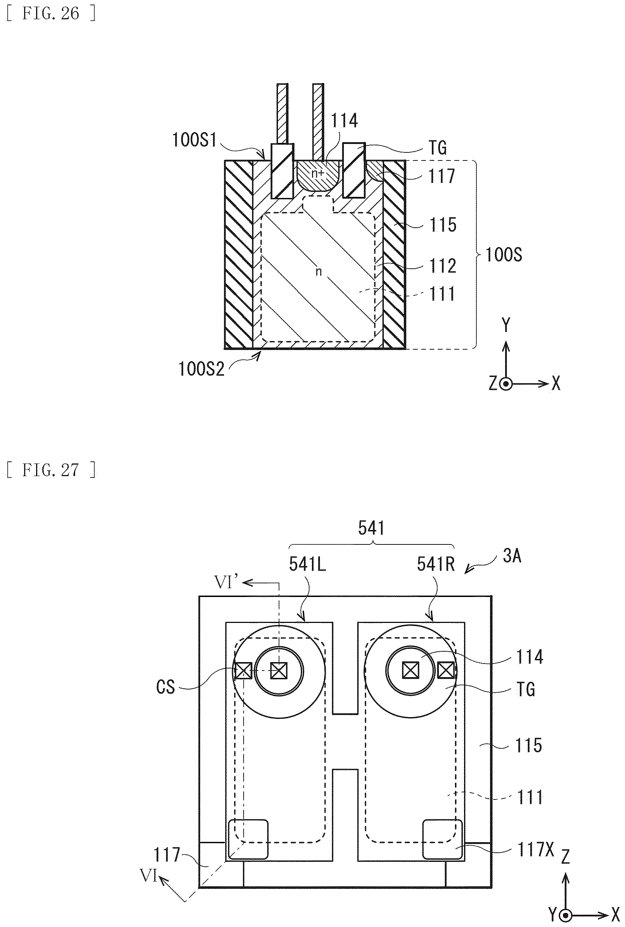

It is to be noted that in the present embodiment, there has been described an example where the FD 114 is provided on the upper surface of the projection 100X formed on the surface 100S1 of the semiconductor layer 100S, and its surroundings are surrounded by the transfer gate TG; however, as illustrated in FIG. 26, also in an imaging device in which the FD 114 is provided on the flat surface 100S1 without providing the projection 100X, and a portion of the transfer gate TG is embedded around the FD 114, it is possible to improve the charge transfer efficiency.

### <6. Modification Examples>

### (6-1. Modification Example 6)

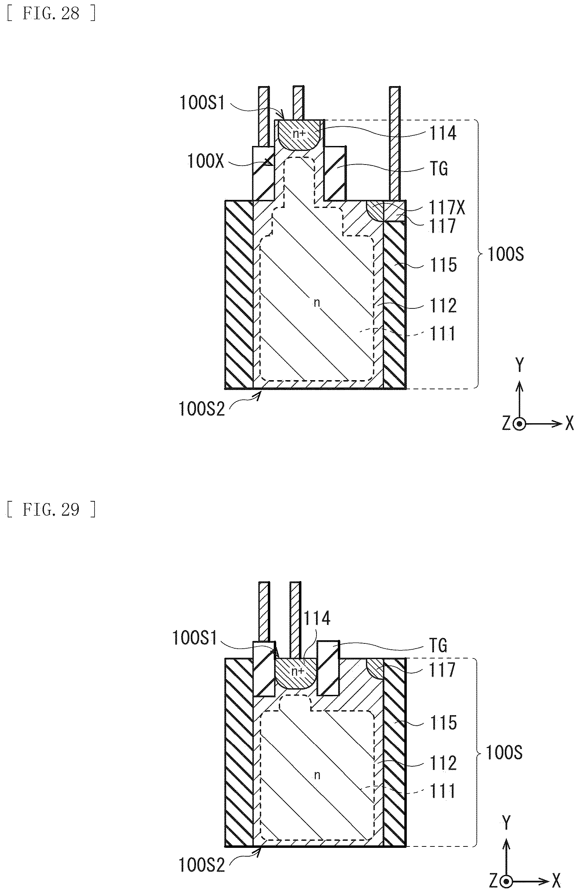

FIG. 27 illustrates an example of a planar configuration of a pixel of an imaging device (an imaging device 3A) according to Modification Example 6 of the present disclosure. FIG. 28 schematically illustrates an example of a cross-sectional configuration corresponding to a line VI-VI' illustrated in FIG. 27.

In the above-described third embodiment, there has been described an example where the projection 100X is formed in substantially the center of the n-type semiconductor region 111 constituting the photodiode PD in a planer view; however, the present disclosure is not limited to this. In the imaging device 3A of the present modification example, the projection 100X is formed near the end of the n-type semiconductor region 111 extending in the Z-axis direction.

In this way, in the present modification example, the projection 100X is formed near the end of the n-type semiconductor region 111 extending in the Z-axis direction. Thus, for example, it is possible to shorten an FD wire used when multiple pixels 541 share the FD 114, and therefore, it is possible to improve the conversion efficiency. As a result, the S/N ratio is improved, thus it is possible to improve the image quality.

It is to be noted that in the present modification example, the impurity concentration is adjusted to cause the potential gravity center of the photodiode PD to be formed below the projection 100X, thereby it is possible to improve the transfer efficiency while improving the conversion efficiency.

Furthermore, as illustrated in FIG. 29, also in an imaging device in which the FD 114 is provided on the flat surface 100S1 without providing the projection 100X, and a portion of the transfer gate TG is embedded around the FD 114, the present configuration makes it possible to improve the conversion efficiency.

### (6-2. Modification Example 7)

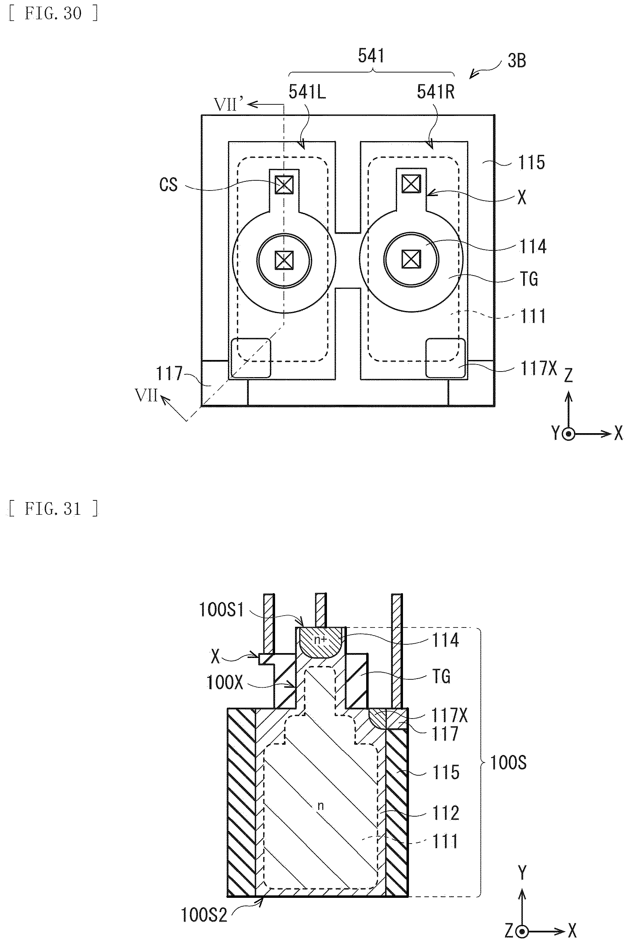

FIG. 30 illustrates an example of a planar configuration of a pixel of an imaging device (an imaging device 3B) according to Modification Example 7 of the present disclosure. FIG. 31 schematically illustrates an example of a cross-sectional configuration corresponding to a line VII-VII' illustrated in FIG. 30.

In the above-described third embodiment, there has been described an example where a contact CS is set on the ring-like transfer gate TG surrounding the projection 100X; however, the present disclosure is not limited to this. In the imaging device 3B of the present modification example, the ring-like transfer gate TG is provided with an overhanging portion X, and the contact CS is set on this overhanging portion X.

In this way, in the present modification example, the ring-like transfer gate TG is provided with the overhanging portion X, and the contact CS is set on this overhanging portion X, thereby it is possible to secure the distance between the contact CS and the contact of the FD 114. Thus, in addition to the effects of the above-described third embodiment, it is possible to reduce the FD capacitance. Furthermore, it is possible to avoid the occurrence of a short circuit.

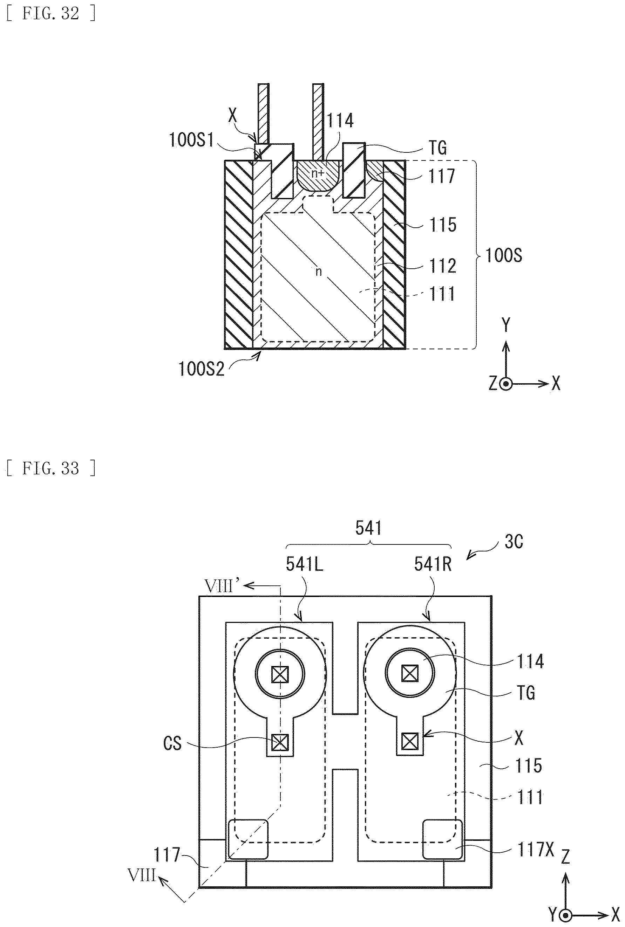

Moreover, as illustrated in FIG. 32, also in an imaging device in which the FD 114 is provided on the flat surface 100S1 without providing the projection 100X, and a portion of the transfer gate TG is embedded around the FD 114, the present configuration makes it possible to reduce the FD capacitance. Furthermore, it is possible to avoid the occurrence of a short circuit.

### (6-3. Modification Example 8)

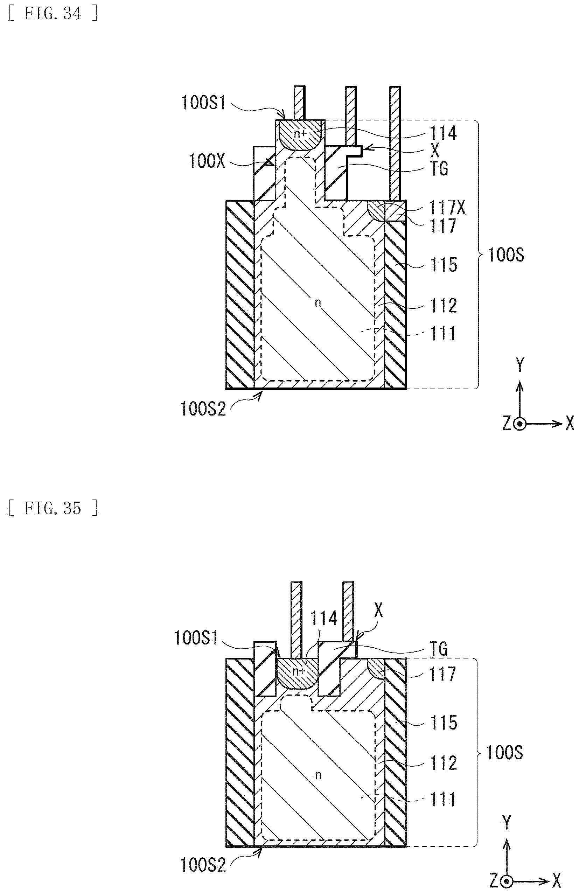

FIG. 33 illustrates an example of a planar configuration of a pixel of an imaging device (an imaging device 3C) according to Modification Example 8 of the present disclosure. FIG. 34 schematically illustrates an example of a cross-sectional configuration corresponding to a line VIII-VIII' illustrated in FIG. 33.

In the above-described Modification Example 7, there has been described an example where the projection 100X is formed in substantially the center of the n-type semiconductor region 111 constituting the photodiode PD in a planer view, the ring-like transfer gate TG having the overhanging portion X is provided around the projection 100X, and the contact CS is set on the overhanging portion X; however, the present disclosure is not limited to this. In the imaging device 3C of the present modification example, the projection 100X is formed near the end of the n-type semiconductor region 111, and the overhanging portion X is provided in a direction of the center of each of the right pixel 541R and the left pixel 541L.

In this way, in the present modification example, the projection 100X is formed near the end of the n-type semiconductor region 111, the ring-like transfer gate TG is provided with the overhanging portion X extending in the direction of the center of each of the right pixel 541R and the left pixel 541L, and the contact CS is set on this overhanging portion X. Thus, in addition to the effects of the above-described third embodiment, it is possible to reduce the FD capacitance while improving the conversion efficiency. Furthermore, it is possible to avoid the occurrence of a short circuit.

Moreover, as illustrated in FIG. 35, also in an imaging device in which the FD 114 is provided on the flat surface 100S1 without providing the projection 100X, and a portion of the transfer gate TG is embedded around the FD 114, the present configuration makes it possible to reduce the FD capacitance while improving the conversion efficiency. Furthermore, it is possible to avoid the occurrence of a short circuit.

### (6-4. Modification Example 9)

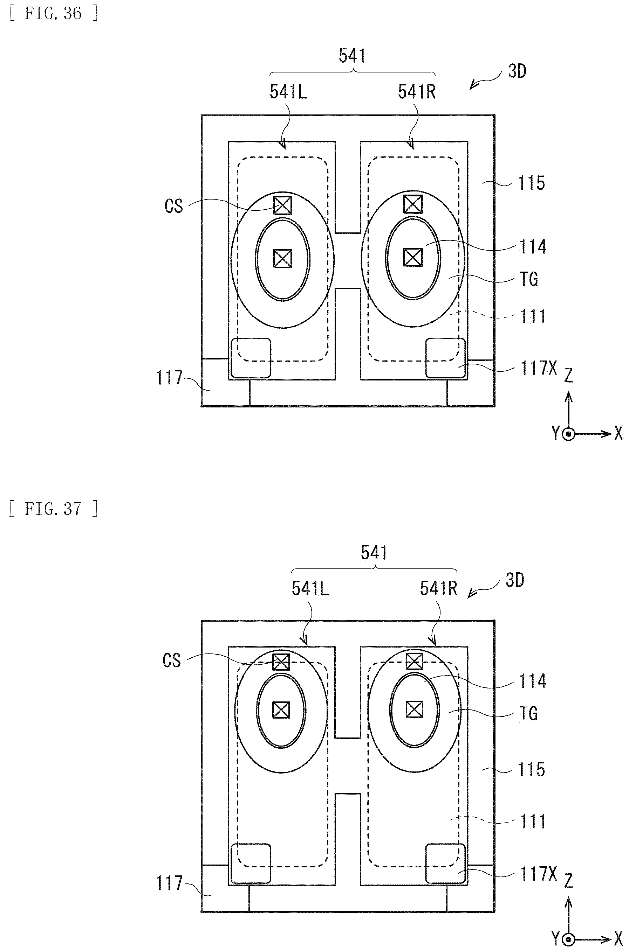

FIG. 36 illustrates an example of a planar configuration of a pixel of an imaging device (an imaging device 3D) according to Modification Example 9 of the present disclosure. FIG. 37 illustrates another example of the planar configuration of the pixel of the imaging device (the imaging device 3D) according to Modification Example 9 of the present disclosure.

In the above-described third embodiment, there has been described an example where a substantially perfect circular projection in a plane view and the ring-like transfer gate TG are provided; however, the present disclosure is not limited to this. In the imaging device 3D of the present modification example, a substantially elliptical projection in a plane view and, around the projection, the ring-like transfer gate TG are provided in substantially the center or the end of the n-type semiconductor region 111 constituting the photodiode PD in a planer view, and the contact CS is set in a direction of the long axis.

In this way, in the present modification example, the substantially elliptical projection in a plane view and, around the projection, the ring-like transfer gate TG are provided, and the contact CS is set in the direction of the long axis. Thus, it is possible to physically separate the contact of the FD 114 from the contact CS of the transfer gate TG. Therefore, in addition to the effects of the above-described third embodiment, it is possible to improve the S/N ratio.

### (6-5. Modification Example 10)

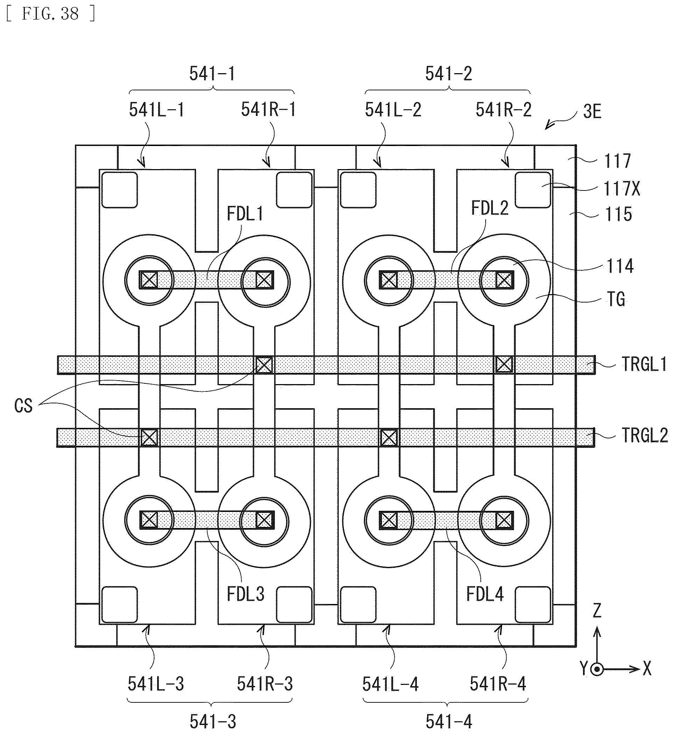

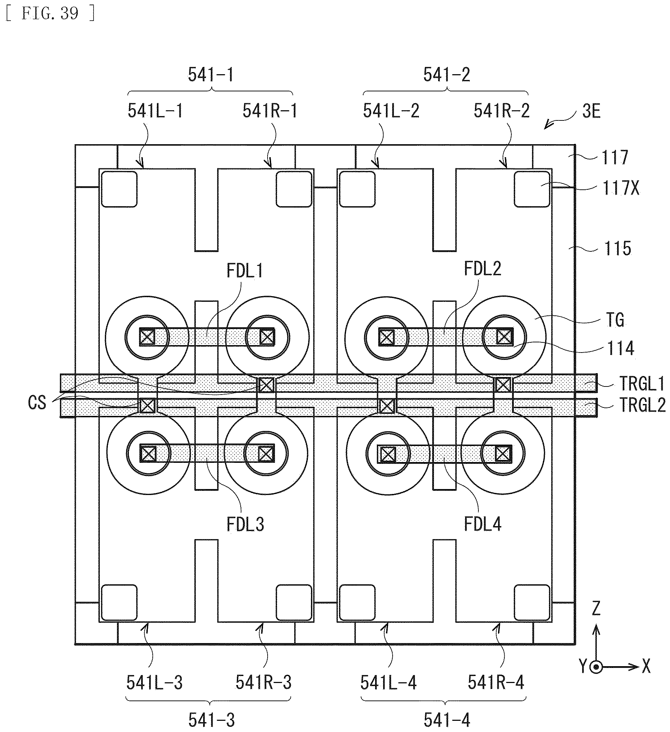

FIG. 38 illustrates an example of a planar configuration of an imaging device (an imaging device 3E) according to Modification Example 10 of the present disclosure. FIG. 39 illustrates another example of the planar configuration of the imaging device (the imaging device 3E) according to Modification Example 10 of the present disclosure.

In two adjacent pixels 541 in a direction intersecting with the direction in which the right pixel 541R and the left pixel 541L are arranged in parallel, the respective ring-like transfer gates TG provided in the right pixel 541R and the left pixel 541L may be coupled to each other and shared. Specifically, as illustrated in FIG. 38, in pixels 541-1, 541-2, 541-3, and 541-4 arranged in two rows and two columns, between the adjacent pixels 541-1 and 541-3 in the Z-axis direction and between the adjacent pixels 541-2 and 541-4 in the Z-axis direction, the respective ring-like transfer gates TG may be coupled to each other and shared between the respective right pixels (between right pixels 541R-1 and 541R-3 and between right pixels 541R-2 and 541R-4) and between the respective left pixels (between left pixels 541L-1 and 541L-3 and between left pixels 541L-2 and 541L-4).

The shared transfer gate TG between the right pixels 541R-1 and 541R-3 and the shared transfer gate TG between the right pixels 541R-2 and 541R-4 are each coupled to a wire TRGL1. The shared transfer gate TG between the left pixels 541L-1 and 541L-3 and the shared transfer gate TG between the left pixels 541L-2 and 541L-4 are each coupled to a wire TRGL2. The respective FDs 114 provided in the right and left pixels 541R-1 and 541L-1 of the pixel 541-1 are electrically coupled to each other by a wire FDL1. The respective FDs 114 provided in the right and left pixels 541R-2 and 541L-2 of the pixel 541-2 are electrically coupled to each other by a wire FDL2. The respective FDs 114 provided in the right and left pixels 541R-3 and 541L-3 of the pixel 541-3 are electrically coupled to each other by a wire FDL3. The respective FDs 114 provided in the right and left pixels 541R-4 and 541L-4 of the pixel 541-4 are electrically coupled to each other by a wire FDL4.

Thus, it is possible to individually control the respective transistors TR provided in the right pixel 541R and the left pixel 541L of each of the pixels 541-1, 541-2, 541-3, and 541-4. Furthermore, an electric charge generated in each of the pixels 541-1, 541-2, 541-3, and 541-4 is able to be read out without mixing with an electric charge of another pixel. Moreover, it is possible to simultaneously read two adjacent pixels 541 in the Z-axis direction, thus the frame rate is improved.

It is to be noted that the respective projections 100X provided in the right pixel 541R and the left pixel 541L of each of the pixels 541-1, 541-2, 541-3, and 541-4 may be provided to come close between adjacent pixels in the Z-axis direction as illustrated in FIG. 39. This reduces the area of an electrode that couples the respective transfer gates TG, thus the capacitance of the entire transfer gate TG is reduced. Therefore, it is possible to reduce the time taken for a readout period, which makes it possible to improve the frame rate.

In this way, in the present modification example, between two adjacent pixels 541 in the direction intersecting with the direction in which the right pixel 541R and the left pixel 541L are arranged in parallel, the respective ring-like transfer gates TG provided in the right pixel 541R and the left pixel 541L are coupled to each other. Thus, as compared with the above-described third embodiment, etc., the number of contacts CS is reduced. Therefore, it is possible to improve the degree of freedom of the layout.

### (6-6. Modification Example 11)

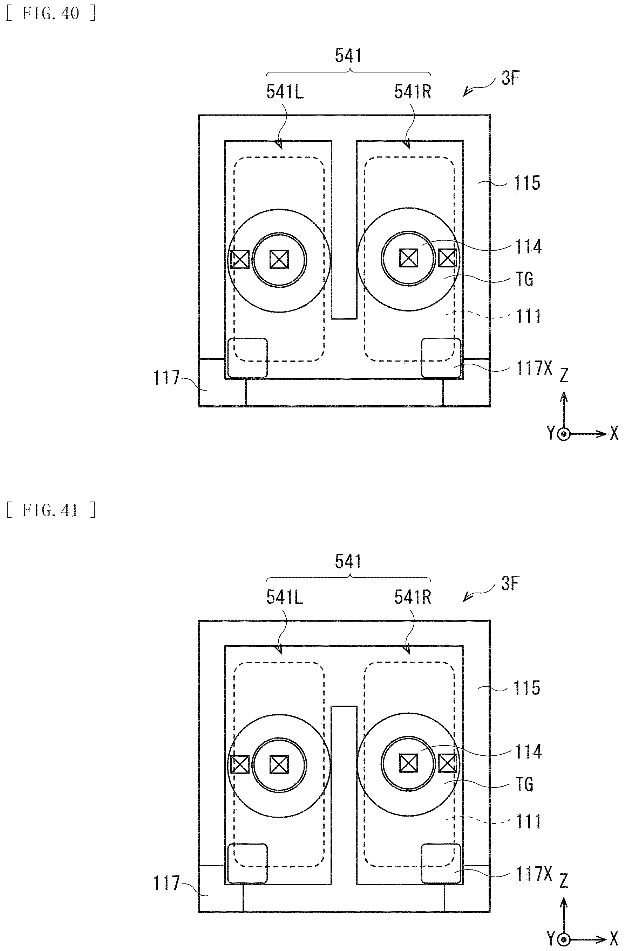

FIGs. 40 to 43 illustrate an example of a planar configuration of a pixel of an imaging device (an imaging device 3F) according to Modification Example 11 of the present disclosure.

In the above-described third embodiment, there has been described an example where, to prevent electrical mixing of colors of the adjacent right and left pixels 541R and 541L, the separation part 115 is extended from both sides of the separation part 115 opposed in the Z-axis direction toward the center of the pixel 541 between the right pixel 541R and the left pixel 541L; however, the present disclosure is not limited to this. The separation part 115 that separates the adjacent right and left pixels 541R and 541L may be extended from one of the sides of the separation part 115 opposed in the Z-axis direction toward the other side, for example, as illustrated in FIGs. 40 and 41.

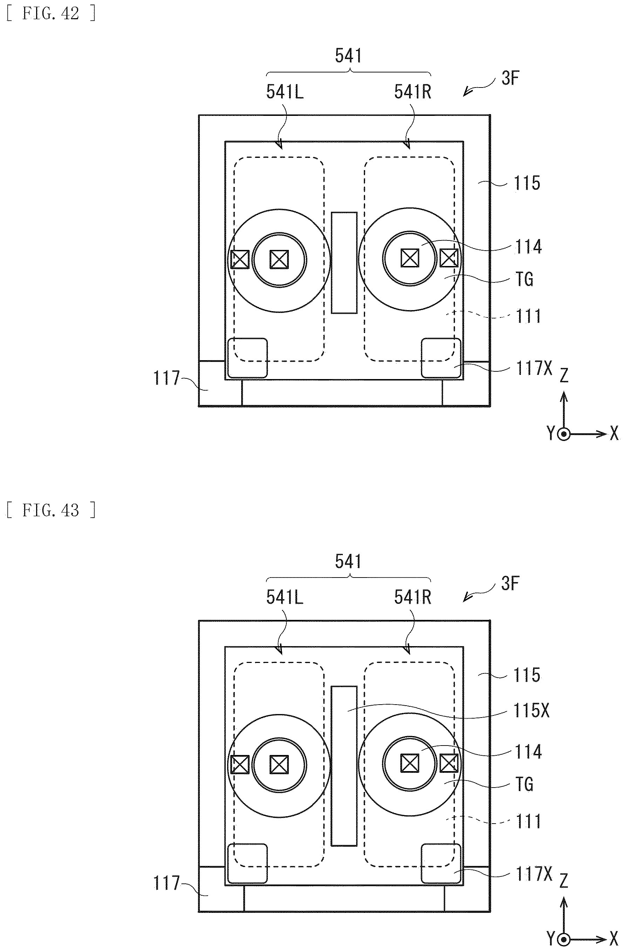

Furthermore, as illustrated in FIG. 42, a separation part (a separation part 115X) that separates the adjacent right and left pixels 541R and 541L may be separated from the separation part 115 that surrounds the pixel 541. In that case, the separation part 115X may have, for example, a reverse deep trench isolation (RDTI) structure in which it is formed from the side of the back surface (the surface 100S2) of the semiconductor layer 100S as illustrated in FIG. 43, or may be formed as, for example, a p-type impurity layer.

### <7. Fourth Embodiment>

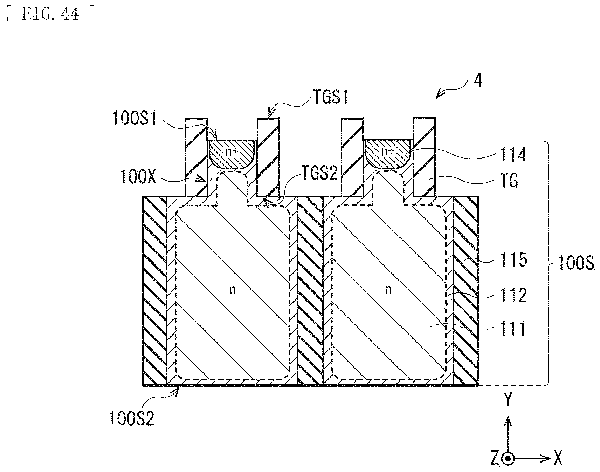

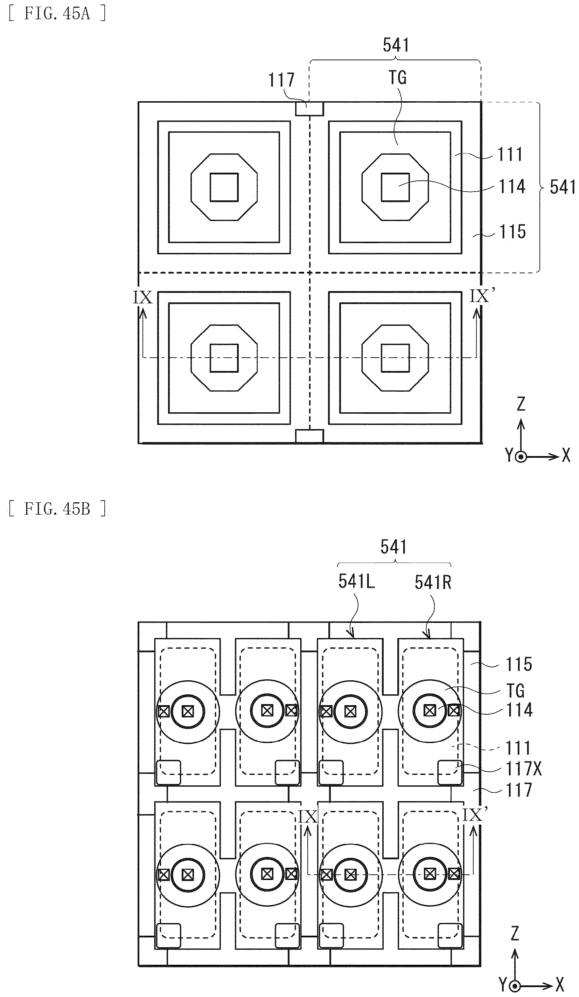

FIG. 44 schematically illustrates an example of a cross-sectional configuration of the semiconductor layer 100S of an imaging device (an imaging device 4) according to a fourth embodiment of the present disclosure. FIG. 45A schematically illustrates an example of a planar layout of the semiconductor layer 100S illustrated in FIG. 44. FIG. 45B schematically illustrates another example of the planar layout of the semiconductor layer 100S illustrated in FIG. 44. It is to be noted that FIG. 44 illustrates a cross-section corresponding to a line IX-IX' illustrated in FIGs. 45A and 45B.

### [Configuration of Imaging Device]

As with the above-described first embodiment, in the imaging device 4, the first substrate 100, the second substrate 200, and the third substrate 300 are stacked on top of another in this order. The imaging device 4 further includes the light receiving lens 414 on the side of the back surface (the side of the light incident surface) of the first substrate 100. Between the light receiving lens 414 and the first substrate 100, for example, the light-shielding film 411, the protective layer 412, and the color filter layer 413 are provided. The light receiving lens 414 is provided with respect to each pixel 541. The imaging device 4 is, for example, a back-illuminated imaging device. The imaging device 4 includes the pixel array section 540 disposed in the middle and the peripheral section disposed outside the pixel array section 540.

The first substrate 100 includes the semiconductor layer 100S and the wiring layer 100T. The semiconductor layer 100S has a pair of surfaces opposed to each other (the front surface (the surface 100S1) and the back surface (the surface 100S2)), and, within the layer, a p-n junction type photodiode PD is formed. The semiconductor layer 100S includes a plurality of pillar-like projections 100X on the surface 100S1, for example, with respect to each pixel 541, and the FD 114 is formed on the upper surface of each of the plurality of projections 100X. The ring-like transfer gate TG is provided around the projection 100X, and is formed to cause its upper surface to be located above the FD 114. In other words, the FD 114 is provided at a height of between the upper surface and the lower surface of the transfer gate TG.

The above-described structure is also applicable to the right pixel 541R and the left pixel 541L constituting an image plane phase difference pixel illustrated in FIG. 45B. Specifically, in each of the right pixel 541R and the left pixel 541L, the pillar-like projection 100X is formed, and the FD 114 is provided on the upper surface of the projection 100X. The ring-like transfer gate TG is provided around each projection 100X, and is formed to cause its upper surface to be positioned higher than the FD 114.

### [Actions and Effects]

In the imaging device 4 of the present embodiment, within the semiconductor layer 100S having a pair of surfaces opposed to each other (the surfaces 100S1 and 100S2), a plurality of projections 100X is provided on the surface 100S1, the FD 114 is provided on the upper surface of each projection 100X, and the transfer gate TG is provided around multiple projections 100X and to cause its upper surface to project more upward than the projection 100X provided with the FD 114. Thus, the pixel becomes finer, which reduces the occurrence of crosstalk between the FDs 114 provided on the upper surfaces of adjacent projections 100X in adjacent pixels.

As above, in the imaging device 4 of the present embodiment, it is possible to achieve an imaging device having a three-dimensional structure that allows the reduction of generation of dark current. Furthermore, it is possible to suppress the color mixing between adjacent pixels.

### <8. Modification Examples>

### (8-1. Modification Example 12)

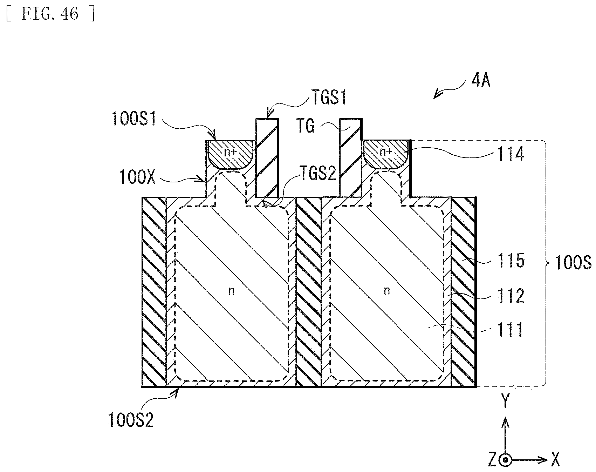

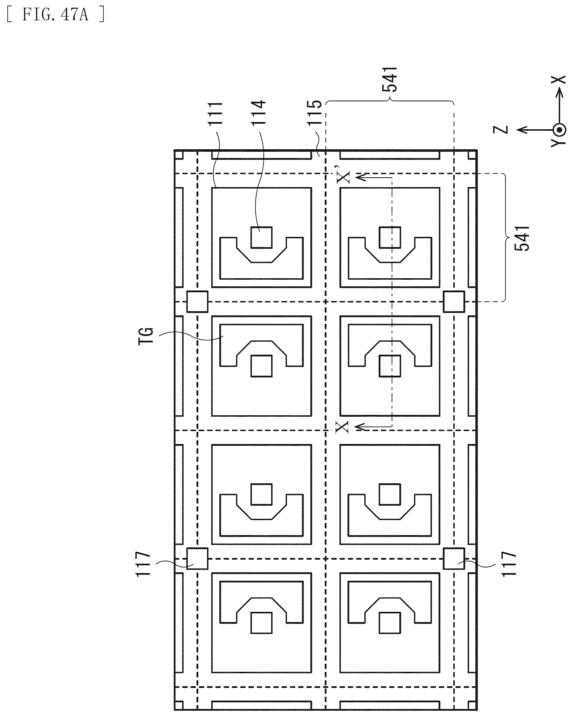

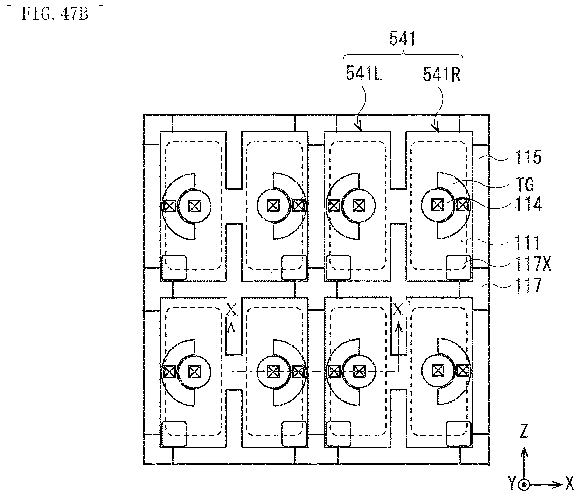

FIG. 46 schematically illustrates an example of a cross-sectional configuration of the semiconductor layer 100S of an imaging device (an imaging device 4A) according to Modification Example 12 of the present disclosure. FIG. 47A schematically illustrates an example of a planar layout of the semiconductor layer 100S illustrated in FIG. 46. FIG. 47B schematically illustrates another example of the planar layout of the semiconductor layer 100S illustrated in FIG. 46. It is to be noted that FIG. 46 illustrates a cross-section corresponding to a line X-X' illustrated in FIGs. 47A and 47B.

In the above-described fourth embodiment, there has been described an example where a continuous ring-like transfer gate TG is provided around the projection 100X; however, the present disclosure is not limited to this. In the imaging device 4A of the present modification example, the transfer gate TG is selectively formed only in a direction in which there is concern about FD coupling between adjacent pixels.

In this way, in the present modification example, the transfer gate TG is selectively formed only in a direction in which there is concern about FD coupling between adjacent pixels. Thus, it is possible to obtain similar effects to those of the above-described fourth embodiment.

### (8-2. Modification Example 13)

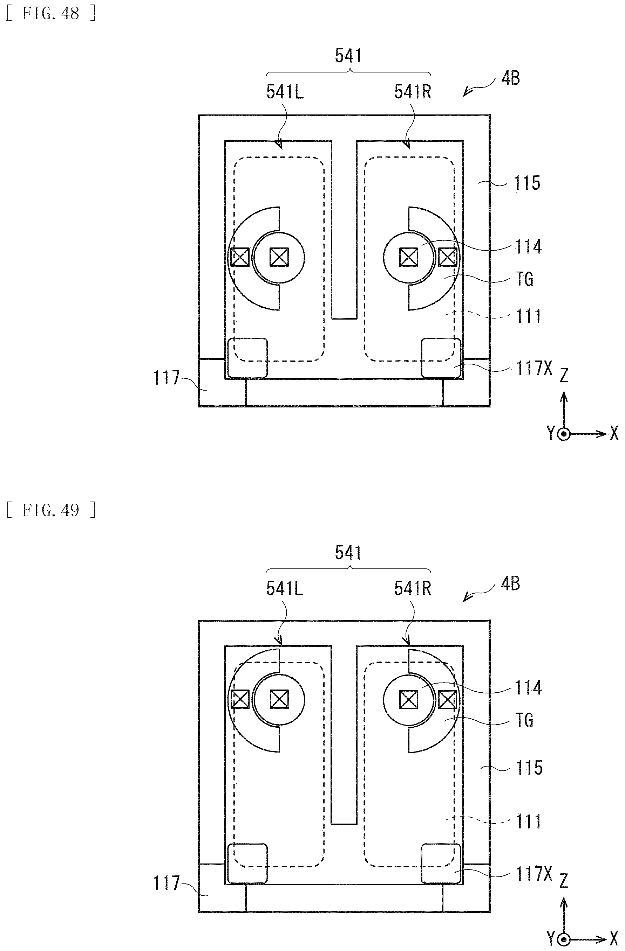

FIG. 48 schematically illustrates an example of a planar configuration of a pixel of an imaging device (an imaging device 4B) according to Modification Example 13 of the present disclosure.

In the above-described Modification Example 12, there has been described an example where in a pixel 541 as an imaging pixel having a square shape, the transfer gate TG is selectively formed only in a direction in which there is concern about FD coupling between adjacent pixels; however, the present disclosure is not limited to this. In the imaging device 4B of the present modification example, in the right and left pixels 541R and 541L having a substantially rectangular shape that constitute an image plane phase difference pixel, the transfer gate TG is selectively formed only in a direction in which there is concern about FD coupling.

Furthermore, FIG. 48 illustrates an example where the projection 100X is formed in substantially the center of the n-type semiconductor region 111 constituting the photodiode PD in a planer view; however, the present disclosure is not limited to this. For example, as illustrated in FIG. 49, the present structure is also applicable to the imaging device 3A in which the projection 100X in the above-described Modification Example 6 is formed near the end of the n-type semiconductor region 111.

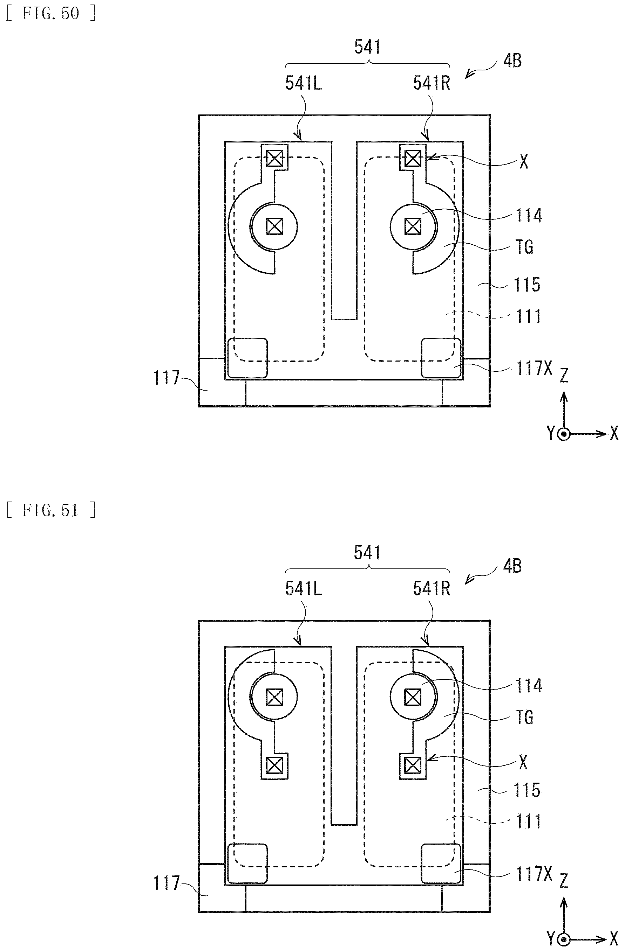

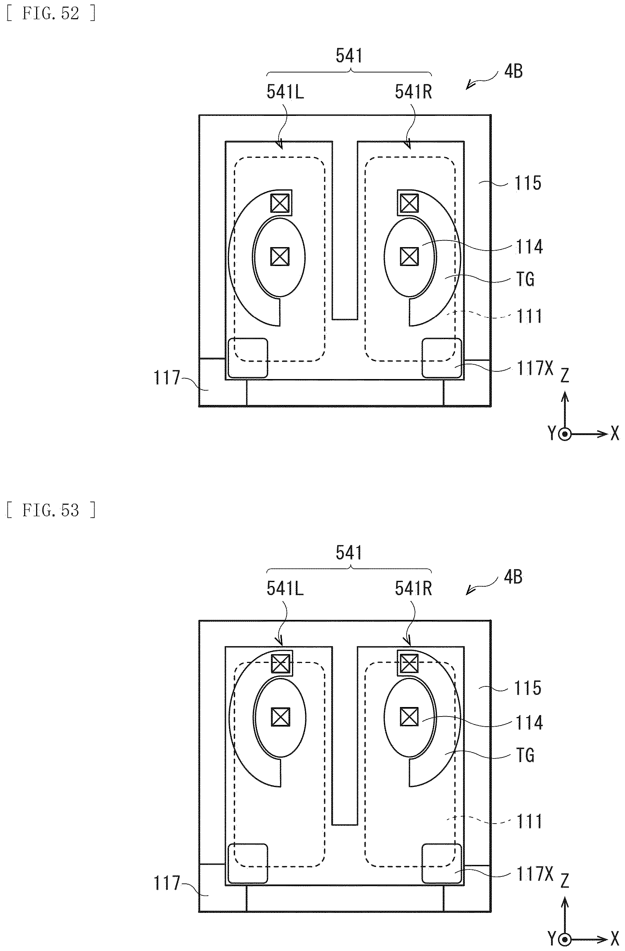

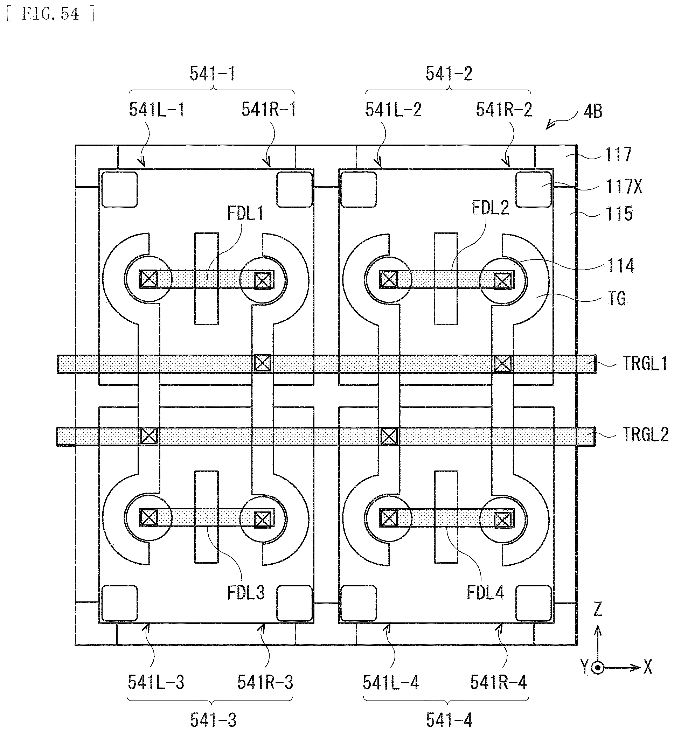

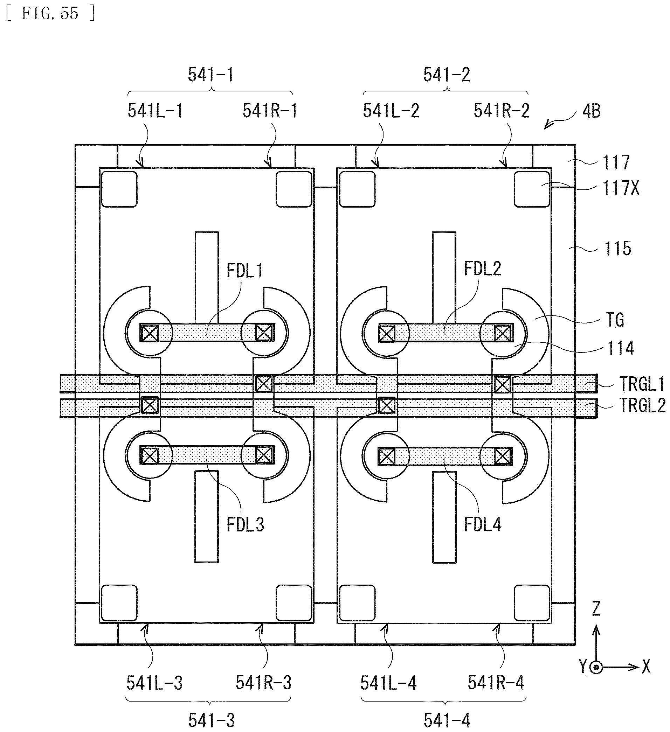

Furthermore, as illustrated in FIGs. 50 and 51, the present structure is also applicable to the imaging devices 3B and 3C in which the transfer gate TG in the above-described Modification Examples 7 and 8 is provided with the overhanging portion X, and the contact CS is set on this overhanging portion X. As illustrated in FIGs. 52 and 53, the present structure is also applicable to the imaging device 3D in which a substantially elliptical projection in a plane view and the ring-like transfer gate TG in the above-described Modification Example 9 are provided, and the contact CS is set in the direction of the long axis. As illustrated in FIGs. 54 and 55, the present structure is also applicable to the imaging device 3E in which in two adjacent pixels 541 in a direction intersecting with the direction in which the right pixel 541R and the left pixel 541L are arranged in parallel in the above-described Modification Example 10, the respective transfer gates TG provided in the right pixel 541R and the left pixel 541L are coupled to each other and shared.

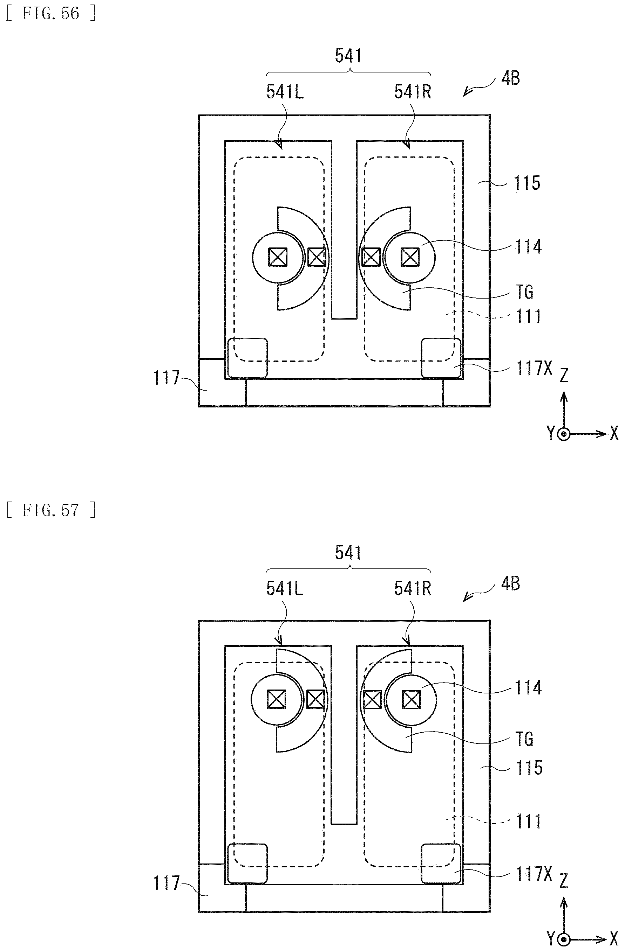

Moreover, FIGs. 48 to 55 illustrate an example where the transfer gate TG is selectively formed on the side of adjacent pixels 541; however, the present disclosure is not limited to this. In a case where there is concern about FD coupling between adjacent right and left pixels 541R and 541L in a pixel 541, as illustrated in FIGs. 56 and 57, the transfer gate TG is selectively formed on the side of the adjacent right and left pixels 541R and 541L.

In this way, in the present modification example, the transfer gate TG is selectively formed only in a direction in which there is concern about FD coupling between adjacent image plane phase difference pixels. Thus, it is possible to obtain similar effects to those of the above-described fourth embodiment.

### <9. Fifth Embodiment>

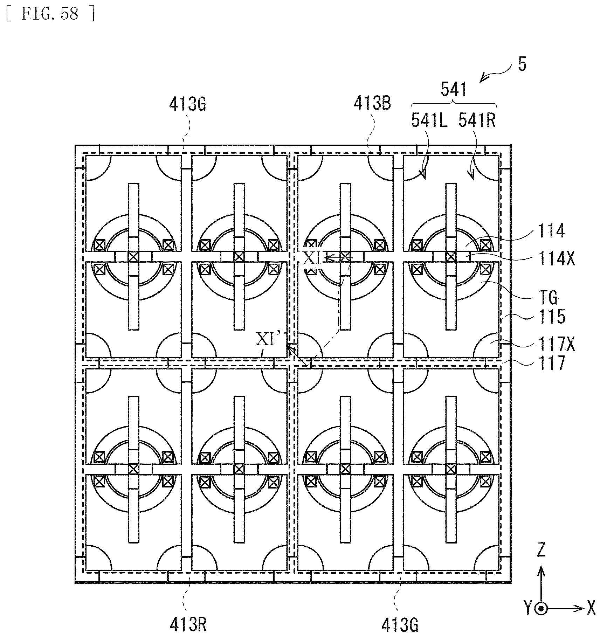

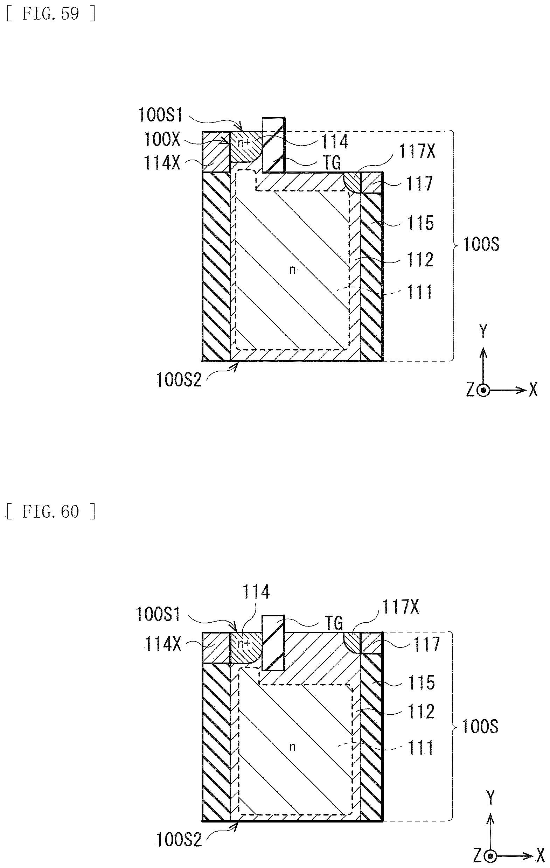

FIG. 58 schematically illustrates an example of a planar configuration of the pixel array section 540 in an imaging device (an imaging device 5) according to a fifth embodiment of the present disclosure. FIG. 59 schematically illustrates an example of a cross-sectional configuration of the semiconductor layer 100S along a line XI-XI' illustrated in FIG. 58. FIG. 60 schematically illustrates another example of the cross-sectional configuration of the semiconductor layer 100S along the line XI-XI' illustrated in FIG. 58.

### [Configuration of Imaging Device]

As with the above-described first embodiment, in the imaging device 5, the first substrate 100, the second substrate 200, and the third substrate 300 are stacked on top of another in this order. The imaging device 5 further includes the light receiving lens 414 on the side of the back surface (the side of the light incident surface) of the first substrate 100. Between the light receiving lens 414 and the first substrate 100, for example, the light-shielding film 411, the protective layer 412, and the color filter layer 413 are provided. The light receiving lens 414 is provided with respect to each pixel 541. The imaging device 5 is, for example, a back-illuminated imaging device. The imaging device 2 includes the pixel array section 540 disposed in the middle and the peripheral section disposed outside the pixel array section 540.

All the pixels 541 constituting the pixel array section 540 are an image plane phase difference pixel. In each of the pixels 541 constituting the pixel array section 540, one light receiving lens 414 is provided, and, for example, any of the color filter 413R that selectively allows transmission of a wavelength in a red band, the color filter 413G that selectively allows transmission of a wavelength in a green band, and the color filter 413B that selectively allows transmission of a wavelength in a blue band is disposed, for example, throughout four pixels 541 arranged in two rows and two columns.

In the imaging device 5, in four pixels 541 arranged in two rows and two columns and provided with any of the color filters 413R, 413G, and 413B, between two adjacent pixels 541 in a direction (the Y-axis direction) intersecting with the direction in which the right pixel 541R and the left pixel 541L are arranged in parallel (the X-axis direction), each FD 114 is formed near the point of intersection between their respective right and left pixels 541R and 541L. Four FDs 114 provided in the respective right and left pixels 541R and 541L of two adjacent pixels 541 in the Z-axis direction are electrically coupled to one another by a contact layer 114X formed on the separation part 115, thus the four FDs 114 are shared in the respective right and left pixels 541R and 541L of the two adjacent pixels 541. In the present embodiment, a substantially ring-like transfer gate TG is formed to surround the shared four FDs 114.

It is to be noted that in the imaging device 5, the separation part 115 may have the FTI structure in which it is formed from the side of the front surface (the surface 100S1) of the semiconductor layer 100S, or may have the DTI structure in which it is formed from the side of the back surface (the surface 100S2). By adopting the DTI structure and adjusting the depth of the separation part 115, it becomes possible to form the contact layer 114X deeper. Furthermore, in a case where the separation part 115 is configured in the DTI structure, it is possible to form a continuous ring-like transfer gate TG around the shared four FDs 114.

It is to be noted that FIG. 59 illustrates an example where the FD 114 is provided on the upper surface of the projection 100X formed on the surface 100S1 of the semiconductor layer 100S; however, as illustrated in FIG. 60, the FD 114 may be provided on the flat surface 100S1 without providing the projection 100X, and a portion of the transfer gate TG may be embedded around the FD 114.

### [Actions and Effects]

In the imaging device 5 of the present embodiment, among multiple pixels 541 sharing the same color filters 413R, 413G, and 413B, between two adjacent pixels 541 in a direction (the Y-axis direction) intersecting with the direction in which the right pixel 541R and the left pixel 541L are arranged in parallel (the X-axis direction), four FDs 114 are formed near the point of intersection between their respective right and left pixels 541R and 541L, and a substantially ring-like transfer gate TG is formed to surround the four FDs 114. This reduces the occurrence of electrical crosstalk between pixels that differ in wavelength to detect.

As above, in the imaging device 5 of the present embodiment, it is possible to achieve an imaging device having a three-dimensional structure that allows the reduction of generation of dark current. Furthermore, it is possible to suppress the color mixing between adjacent pixels.

Furthermore, in the present embodiment, the contact layer 114X is formed between the four FDs 114, and the contact CS is set on this contact layer 114X. Thus, it is possible to reduce the number of contacts CS.

### <10. Modification Example 14>

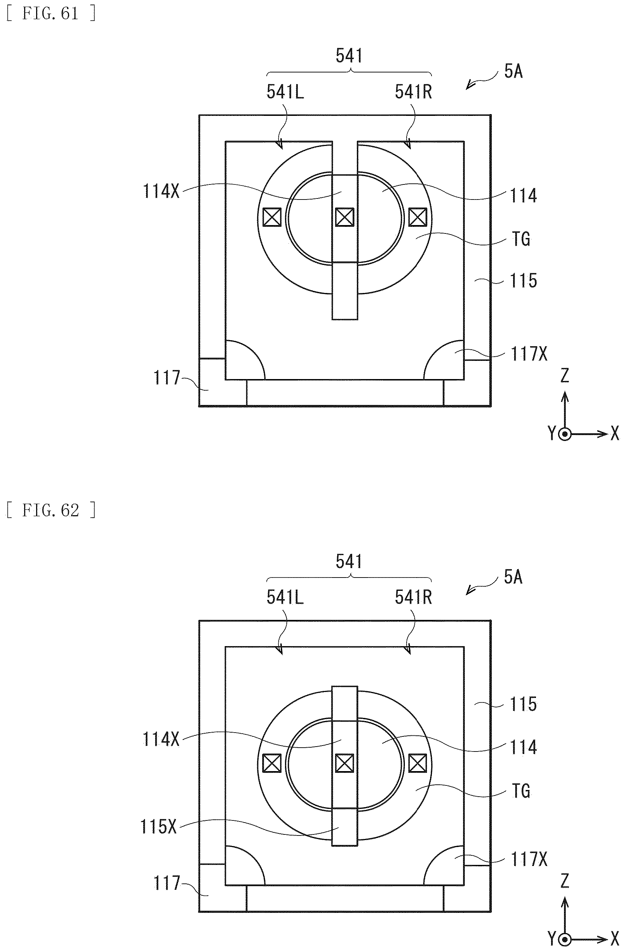

FIG. 61 schematically illustrates an example of a planar configuration of a pixel of an imaging device (an imaging device 5A) according to Modification Example 14 of the present disclosure. FIG. 62 schematically illustrates another example of the planar configuration of the pixel of the imaging device (the imaging device 5A) according to Modification Example 14 of the present disclosure.

In the above-described fifth embodiment, there has been described an example where between two adjacent pixels in the Y-axis direction, four FDs 114 are formed near the point of intersection between their respective right and left pixels 541R and 541L, and the four FDs 114 are shared with each other; however, the present disclosure is not limited to this. In the imaging device 5A of the present modification example, the FD 114 is shared only between the right pixel 541R and the left pixel 541L.

It is to be noted that in a case where the FD 114 is shared between the right pixel 541R and the left pixel 541L, the FD 114 may be formed in the end of the pixel 541 as illustrated in FIG. 61, or, as illustrated in FIG. 62, the separation part 115X independent of the separation part 115 may be provided, and the FD 114 may be formed in in substantially the center of the pixel 541.

### <11. Application Example>

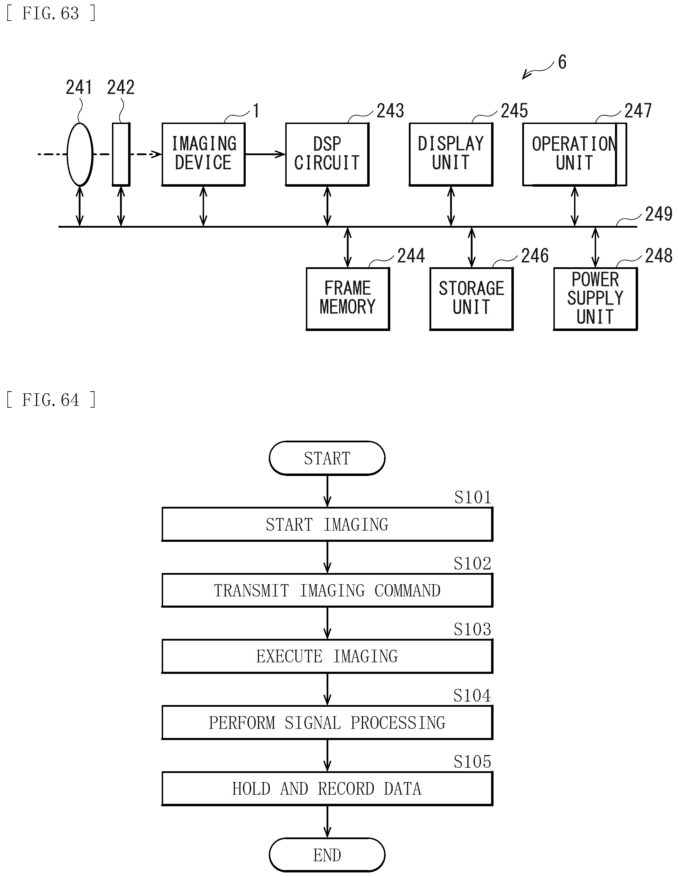

FIG. 63 illustrates an example of a schematic configuration of an imaging system 6 including the imaging device according to the above-described first to fifth embodiments and their Modification Examples 1 to 14 (for example, the imaging device 1).

The imaging system 6 is an electronic apparatus, for example, an imaging device such as a digital still camera or a video camera, a portable terminal device such as a smartphone or a tablet terminal, etc. The imaging system 6 includes, for example, the imaging device 1 according to the above-described embodiments and their modification examples, a DPS circuit 243, a frame memory 244, a display unit 245, a storage unit 246, an operation unit 247, and a power supply unit 248. In the imaging system 6, the imaging device 1 according to the above-described embodiments and their modification examples, the DPS circuit 243, the frame memory 244, the display unit 245, the storage unit 246, the operation unit 247, and the power supply unit 248 are coupled to one another through a bus line 249.

The imaging device according to the above-described embodiments, etc. (for example, the imaging device 1) outputs image data according to incident light. The DPS circuit 243 is a signal processing circuit that processes a signal (the image data) output from the imaging device 1 according to the above-described embodiments and their modification examples. The frame memory 244 temporarily holds the image data processed by the DPS circuit 243 on a frame-by-frame basis. The display unit 245 includes, for example, a panel-type display device such as a liquid crystal panel or an organic electroluminescence (EL) panel, and displays thereon a moving image or a still image taken by the imaging device 1 according to the above-described embodiments and their modification examples. The storage unit 246 records image data of the moving image or the still image taken by the imaging device 1 according to the above-described embodiments and their modification examples onto a recording medium such as a semiconductor memory or a hard disk. The operation unit 247 issues, in accordance with an operation made by a user, an operation command about various functions that the imaging system 6 has. The power supply unit 248 fittingly supplies a variety of electric power that become operating power of the imaging device 1 according to the above-described embodiments and their modification examples, the DPS circuit 243, the frame memory 244, the display unit 245, the storage unit 246, and the operation unit 247 to these targets of supply.

Subsequently, an imaging procedure in the imaging system 6 is described.

FIG. 64 illustrates an example of a flowchart of the imaging procedure in the imaging system 6. A user operates the operation unit 247 and thereby issues an instruction to start imaging (step S101). Then, the operation unit 247 transmits an imaging command to the imaging device 1 (step S102). When having received the imaging command, the imaging device 1 (specifically, a system control circuit 36) executes imaging by a predetermined imaging method (step S103).

The imaging device 1 outputs image data obtained through the imaging to the DPS circuit 243. The image data here means data of pixel signals generated in all pixels on the basis of an electric charge temporarily held in the floating diffusion FD. The DPS circuit 243 performs predetermined signal processing (for example, noise reduction processing, etc.) on the basis of the image data input from the imaging device 1 (step S104). The DPS circuit 243 causes the frame memory 244 to hold the image data subjected to the predetermined signal processing, and the frame memory 244 causes the storage unit 246 to store the image data (step S105). In this way, the imaging in the imaging system 6 is performed.

In the present application example, the imaging device 1 according to the above-described embodiments and their modification examples is applied to the imaging system 6. This makes it possible to make the imaging device 1 smaller or higher-definition, thus it is possible to provide the small-sized or high-definition imaging system 6.

### <12. Practical Application Examples >

### [Practical Application Example 1]

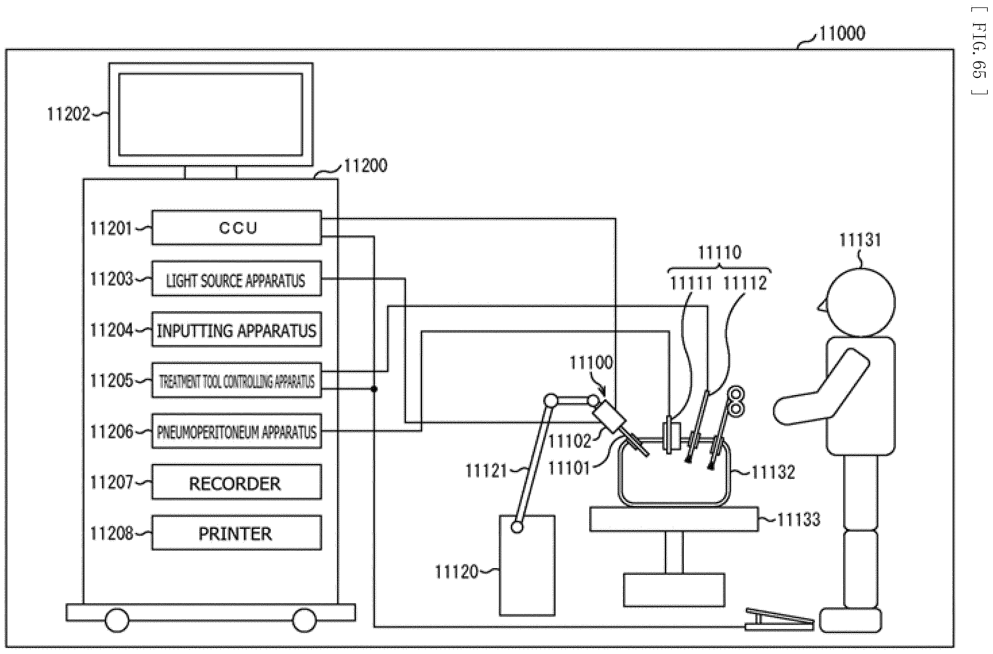

FIG. 65 is a view depicting an example of a schematic configuration of an endoscopic surgery system to which the technology according to an embodiment of the present disclosure (present technology) can be applied.

In FIG. 65, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

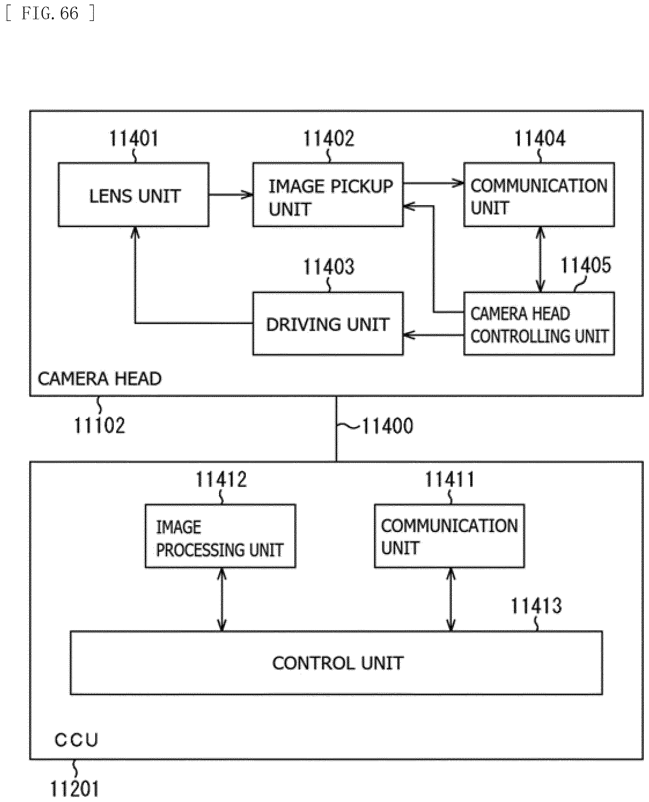

FIG. 66 is a block diagram depicting an example of a functional configuration of the camera head 11102 and the CCU 11201 depicted in FIG. 65.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

As above, there has been described an example of the endoscopic surgery system to which the technique according to the present disclosure may be applied. The technique according to the present disclosure may be suitably applied to, of the above-described components, the image pickup unit 11402 provided in the camera head 11102 of the endoscope 11100. By applying the technique according to the present disclosure to the image pickup unit 11402, it becomes possible to make the image pickup unit 11402 smaller or higher-definition; therefore, it is possible to provide the small-sized or high-definition endoscope 11100.

### [Practical Application Example 2]

The technique according to the present disclosure (the present technology) is applicable to various products. For example, the technique according to the present disclosure may be realized as a device mounted on any of kinds of moving bodies such as a motor vehicle, an electric vehicle, a hybrid electric vehicle, a motorcycle, a bicycle, a personal transporter, an airplane, a drone, a vessel, and a robot.

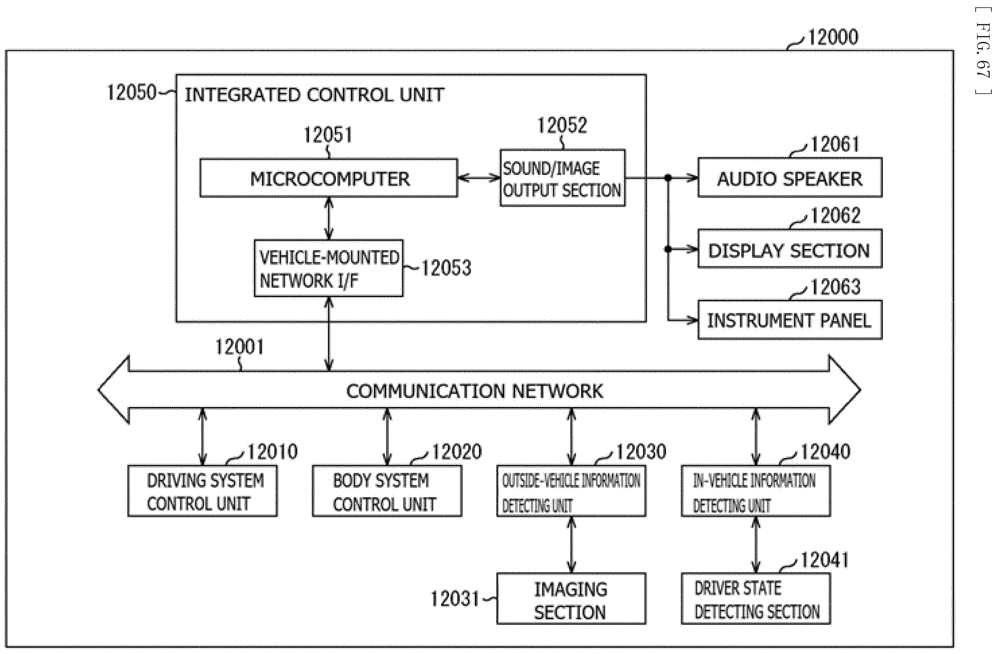

FIG. 67 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 67, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 67, an audio speaker 12061, a display section 12062, and an instrument panel 12063 are illustrated as the output device. The display section 12062 may, for example, include at least one of an on-board display and a head-up display.

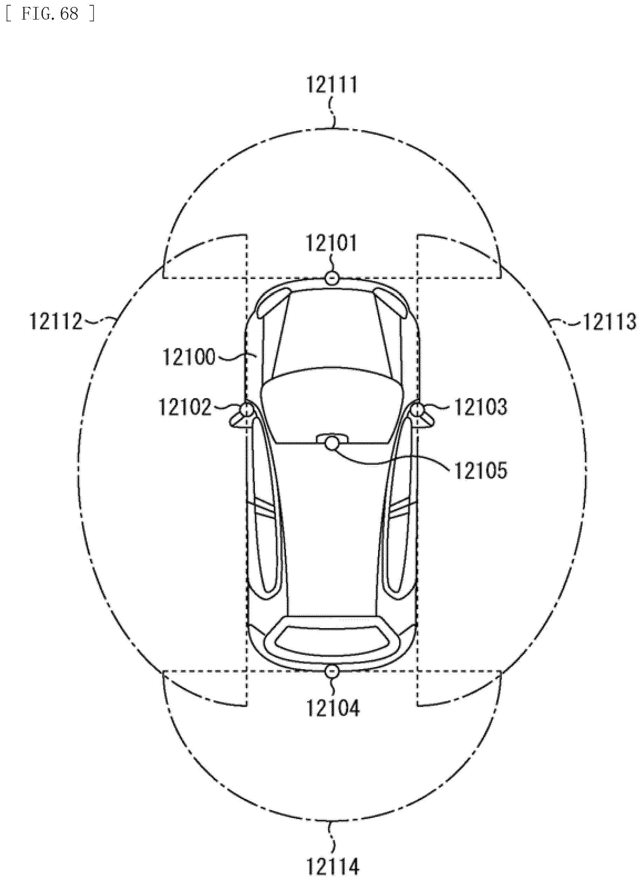

FIG. 68 is a diagram depicting an example of the installation position of the imaging section 12031.

In FIG. 68, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 68 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

As above, there has been described an example of the moving body control system to which the technique according to the present disclosure may be applied. The technique according to the present disclosure may be applied to, of the above-described components, for example, the imaging section 12031. Specifically, the imaging device 1 according to the above-described embodiments and their modification examples is applicable to the imaging section 12031. By applying the technique according to the present disclosure to the imaging section 12031, it becomes possible to obtain a high-definition taken image with less noise; therefore, it is possible to perform high-precision control using the taken image in the moving body control system.

The present disclosure has been described above with the above-described first to fifth embodiments and their Modification Examples 1 to 14, and the application example and the practical application examples; however, the present disclosure is not limited to the above-described embodiments, etc., and it is possible to make various modifications.

It is to be noted that the effects described in the present specification are merely an example. The effects of the present disclosure are not limited to those described in the present specification. The present disclosure may have effects other than those described in the present specification.

It is to be noted that it is also possible for the present disclosure to have the following configurations. According to the following configurations, in a first semiconductor substrate having first and second surfaces opposed to each other and including a plurality of pixels arranged in an array in an in-plane direction, a plurality of projections being provided on the first surface with respect to each of the plurality of pixels, a plurality of charge holding units that holds electric charges generated in a plurality of photoelectric converters, one formed to be embedded in each pixel, is provided on respective upper surfaces of the plurality of projections, and a gate of a transfer transistor that transfers the electric charges held in the charge holding units to the pixel circuits is provided around the plurality of projections. Thus, the distance between the charge holding unit and the transfer gate is secured in the height direction. Therefore, it is possible to reduce the generation of dark current.
(1) An imaging element including:
   a first semiconductor substrate having a first surface and a second surface that are opposed to each other and including a plurality of pixels arranged in an array in an in-plane direction, a plurality of projections being provided on the first surface with respect to each of the plurality of pixels;
   a plurality of photoelectric converters that is formed to be embedded in the first semiconductor substrate with respect to each pixel and generates an electric charge according to an amount of light received;
   a plurality of charge holding units that is provided on respective upper surfaces of the plurality of projections and holds electric charges generated in the plurality of photoelectric converters;
   a second semiconductor substrate stacked on the side of the first surface of the first semiconductor substrate and provided with one or more pixel circuits that generate a pixel signal on the basis of an electric charge generated by each of the plurality of photoelectric converters; and
   a gate of a transfer transistor that is provided around the plurality of projections and transfers the electric charges held in the charge holding units to the pixel circuits.
(2) The imaging element according to (1), in which the gate is provided below the plurality of charge holding units provided respectively on the plurality of projections.
(3) The imaging element according to (1) or (2), in which the gate is provided to project more upward than the upper surfaces of the plurality of projections, and a side wall is formed on a side surface of a projecting portion of the gate.
(4) The imaging element according to (3), in which a portion of the side wall is embedded between a side surface of the gate and side surfaces of the plurality of projections.
(5) The imaging element according to (3) or (4), in which a portion of the gate is embedded in the first semiconductor substrate.
(6) The imaging element according to any one of (1) to (5), in which the first semiconductor substrate further includes a separation part provided between pixels of the plurality of adjacent pixels and extending between the first surface and the second surface.
(7) The imaging element according to (6), further including a contact layer that applies a reference potential to the first semiconductor substrate,
   in which the contact layer is embedded in the first surface of the first semiconductor substrate above the separation part.
(8) The imaging element according to (7), in which the first surface of the first semiconductor substrate formed with the contact layer is a recess.
(9) The imaging element according to (7), in which the contact layer is provided at the same height as the charge holding units.
(10) The imaging element according to any one of (1) to (9), in which the gate is provided with respect to each of the plurality of pixels.
(11) The imaging element according to any one of (1) to (10), in which the gate is provided continuously in the multiple adjacent pixels.
(12) The imaging element according to any one of (1) to (11), in which the pixel circuits are provided, one for one or each of the plurality of pixels.
(13) The imaging element according to any one of (1) to (12), in which
   each of the first semiconductor substrate and the second semiconductor substrate further includes a multi-layer wiring layer on the opposed surface side,
   one or more pad electrodes are provided on surfaces of respective multi-layer wiring layers provided, and
   the first semiconductor substrate and the second semiconductor substrate are electrically coupled to each other by bonding the one or more pad electrodes together.
(14) The imaging element according to any one of (1) to (13), in which the first semiconductor substrate and the second semiconductor substrate are electrically coupled to each other through a through-electrode that goes through between the first semiconductor substrate and the second semiconductor substrate.
(15) The imaging element according to any one of (1) to (14), in which
   the second semiconductor substrate has a third surface and a fourth surface that are opposed to each other,
   the pixel circuits include: a reset transistor that resets the potential of the charge holding unit to a predetermined position; an amplifier transistor that generates, as a pixel signal, a signal of a voltage according to a level of the electric charge held in the charge holding unit; and a selection transistor that controls timing to output the pixel signal from the amplifier transistor,
   the reset transistor, the amplifier transistor, and the selection transistor are provided on the third surface of the second semiconductor substrate, and
   the first semiconductor substrate and the second semiconductor substrate are stacked with the first surface and the third surface opposed to each other.
(16) The imaging element according to any one of (1) to (15), in which
   the second semiconductor substrate has a third surface and a fourth surface that are opposed to each other,
   the pixel circuits include: a reset transistor that resets the potential of the charge holding unit to a predetermined position; an amplifier transistor that generates, as a pixel signal, a signal of a voltage according to a level of the electric charge held in the charge holding unit; and a selection transistor that controls timing to output the pixel signal from the amplifier transistor,
   the reset transistor, the amplifier transistor, and the selection transistor are provided on the third surface of the second semiconductor substrate, and
   the first semiconductor substrate and the second semiconductor substrate are stacked with the first surface and the third surface opposed to each other.
(17) The imaging element according to (16), in which the reset transistor, the amplifier transistor, and the selection transistor are a transistor having a three-dimensional structure.
(18) The imaging element according to any one of (1) to (17), further including, on the side of the second surface of the first semiconductor substrate, a color filter layer that selectively allows transmission of light of a predetermined wavelength and a plurality of light receiving lenses provided with respect to each pixel.
(19) The imaging element according to (18), in which each of the plurality of pixels includes, with respect to one light receiving lens, the two photoelectric converters, the two projections, the two charge holding units provided on respective upper surfaces of the two projections, the respective gates of the two transfer transistors provided around the two projections.
(20) The imaging element according to (19), in which
   the plurality of pixels includes a first pixel and a second pixel that are adjacent to each other in a second direction intersecting with a first direction in which the two photoelectric converters are arranged in parallel, and
   the respective gates of the two transfer transistors are continuous between the first pixel and the second pixel.
(21) The imaging element according to any one of (1) to (20), in which the plurality of charge holding units is provided at a height of between the upper surface and the lower surface of the gate.
(22) The imaging element according to any one of (1) to (21), in which the gate is continuously provided around the plurality of projections.
(23) The imaging element according to any one of (1) to (21), in which the gate is provided to surround a portion of the plurality of projections.
(24) The imaging element according to (23), in which the gate is provided between the plurality of adjacent charge holding units.
(25) The imaging element according to any one of (19) to (24), in which
   the color filter layer includes a first color filter, a second color filter, and a third color filter that selectively allow transmission of light of different wavelengths from one another, and
   the first color filter, the second color filter, and the third color filter are provided throughout the multiple adjacent pixels in at least one of a first direction in which the two photoelectric converters are arranged in parallel or a second direction intersecting with the first direction.
(26) The imaging element according to (25), in which
   in the multiple pixels sharing any of the first color filter, the second color filter, and the third color filter, the multiple charge holding units are shared between the two adjacent pixels in the second direction, and
   the gate is provided to surround the multiple charge holding units shared between the two adjacent pixels in the second direction.
(27) An imaging device including an imaging element,
   the imaging element including:
   a first semiconductor substrate having a first surface and a second surface that are opposed to each other and including a plurality of pixels arranged in an array in an in-plane direction, a plurality of projections being provided on the first surface with respect to the plurality of pixels;
   a plurality of photoelectric converters that is formed to be embedded in the first semiconductor substrate with respect to each pixel and generates an electric charge according to an amount of light received;
   a plurality of charge holding units that is provided on respective upper surfaces of the plurality of projections and holds electric charges generated in the plurality of photoelectric converters;
   a second semiconductor substrate stacked on the side of the first surface of the first semiconductor substrate and provided with one or more pixel circuits that generate a pixel signal on the basis of an electric charge generated by each of the plurality of photoelectric converters; and
   a gate of a transfer transistor that is provided around the plurality of projections and transfers the electric charges held in the charge holding units to the pixel circuits.

The present application claims the benefit of Japanese Priority Patent Application JP2022-102157 filed on June 24, 2022 and Japanese Priority Patent Application JP2023-051956 filed on March 28, 2023 with the Japan Patent Office, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. An imaging element comprising:
a first semiconductor substrate having a first surface and a second surface that are opposed to each other and including a plurality of pixels arranged in an array in an in-plane direction, a plurality of projections being provided on the first surface with respect to each of the plurality of pixels;
a plurality of photoelectric converters that is formed to be embedded in the first semiconductor substrate with respect to each pixel and generates an electric charge according to an amount of light received;
a plurality of charge holding units that is provided on respective upper surfaces of the plurality of projections and holds electric charges generated in the plurality of photoelectric converters;
a second semiconductor substrate stacked on a side of the first surface of the first semiconductor substrate and provided with one or more pixel circuits that generate a pixel signal on a basis of an electric charge generated by each of the plurality of photoelectric converters; and
a gate of a transfer transistor that is provided around the plurality of projections and transfers the electric charges held in the charge holding units to the pixel circuits.

2. The imaging element according to claim 1, wherein the gate is provided below the plurality of charge holding units provided respectively on the plurality of projections.

3. The imaging element according to claim 1, wherein the gate is provided to project more upward than the upper surfaces of the plurality of projections, and a side wall is formed on a side surface of a projecting portion of the gate.

4. The imaging element according to claim 3, wherein a portion of the side wall is embedded between a side surface of the gate and side surfaces of the plurality of projections.

5. The imaging element according to claim 3, wherein a portion of the gate is embedded in the first semiconductor substrate.

6. The imaging element according to claim 1, wherein the first semiconductor substrate further includes a separation part provided between pixels of the plurality of adjacent pixels and extending between the first surface and the second surface.

7. The imaging element according to claim 6, further comprising a contact layer that applies a reference potential to the first semiconductor substrate,
wherein the contact layer is embedded in the first surface of the first semiconductor substrate above the separation part.

8. The imaging element according to claim 7, wherein the first surface of the first semiconductor substrate formed with the contact layer is a recess.

9. The imaging element according to claim 7, wherein the contact layer is provided at a same height as the charge holding units.

10. The imaging element according to claim 1, wherein the gate is provided with respect to each of the plurality of pixels.

11. The imaging element according to claim 1, wherein the gate is provided continuously in the multiple adjacent pixels.

12. The imaging element according to claim 1, wherein the pixel circuits are provided, one for one or each of the plurality of pixels.

13. The imaging element according to claim 1, wherein
each of the first semiconductor substrate and the second semiconductor substrate further includes a multi-layer wiring layer on an opposed surface side,
one or more pad electrodes are provided on surfaces of respective multi-layer wiring layers provided, and
the first semiconductor substrate and the second semiconductor substrate are electrically coupled to each other by bonding the one or more pad electrodes together.

14. The imaging element according to claim 1, wherein the first semiconductor substrate and the second semiconductor substrate are electrically coupled to each other through a through-electrode that goes through between the first semiconductor substrate and the second semiconductor substrate.

15. The imaging element according to claim 1, wherein
the second semiconductor substrate has a third surface and a fourth surface that are opposed to each other,
the pixel circuits include: a reset transistor that resets the potential of the charge holding unit to a predetermined position; an amplifier transistor that generates, as a pixel signal, a signal of a voltage according to a level of the electric charge held in the charge holding unit; and a selection transistor that controls timing to output the pixel signal from the amplifier transistor,
the reset transistor, the amplifier transistor, and the selection transistor are provided on the third surface of the second semiconductor substrate, and
the first semiconductor substrate and the second semiconductor substrate are stacked with the first surface and the third surface opposed to each other.

16. The imaging element according to claim 1, wherein
the second semiconductor substrate has a third surface and a fourth surface that are opposed to each other,
the pixel circuits include: a reset transistor that resets the potential of the charge holding unit to a predetermined position; an amplifier transistor that generates, as a pixel signal, a signal of a voltage according to a level of the electric charge held in the charge holding unit; and a selection transistor that controls timing to output the pixel signal from the amplifier transistor,
the reset transistor, the amplifier transistor, and the selection transistor are provided on the third surface of the second semiconductor substrate, and
the first semiconductor substrate and the second semiconductor substrate are stacked with the first surface and the third surface opposed to each other.

17. The imaging element according to claim 16, wherein the reset transistor, the amplifier transistor, and the selection transistor are a transistor having a three-dimensional structure.

18. The imaging element according to claim 1, further comprising, on a side of the second surface of the first semiconductor substrate, a color filter layer that selectively allows transmission of light of a predetermined wavelength and a plurality of light receiving lenses provided with respect to each pixel.

19. The imaging element according to claim 18, wherein each of the plurality of pixels includes, with respect to one light receiving lens, the two photoelectric converters, the two projections, the two charge holding units provided on respective upper surfaces of the two projections, the respective gates of the two transfer transistors provided around the two projections.

20. The imaging element according to claim 19, wherein
the plurality of pixels includes a first pixel and a second pixel that are adjacent to each other in a second direction intersecting with a first direction in which the two photoelectric converters are arranged in parallel, and
the respective gates of the two transfer transistors are continuous between the first pixel and the second pixel.

21. The imaging element according to claim 1, wherein the plurality of charge holding units is provided at a height of between the upper surface and the lower surface of the gate.

22. The imaging element according to claim 1, wherein the gate is continuously provided around the plurality of projections.

23. The imaging element according to claim 1, wherein the gate is provided to surround a portion of the plurality of projections.

24. The imaging element according to claim 23, wherein the gate is provided between the plurality of adjacent charge holding units.

25. The imaging element according to claim 19, wherein
the color filter layer includes a first color filter, a second color filter, and a third color filter that selectively allow transmission of light of different wavelengths from one another, and
the first color filter, the second color filter, and the third color filter are provided throughout the multiple adjacent pixels in at least one of a first direction in which the two photoelectric converters are arranged in parallel or a second direction intersecting with the first direction.

26. The imaging element according to claim 25, wherein
in the multiple pixels sharing any of the first color filter, the second color filter, and the third color filter, the multiple charge holding units are shared between the two adjacent pixels in the second direction, and
the gate is provided to surround the multiple charge holding units shared between the two adjacent pixels in the second direction.

27. An imaging device comprising an imaging element,
the imaging element including:
a first semiconductor substrate having a first surface and a second surface that are opposed to each other and including a plurality of pixels arranged in an array in an in-plane direction, a plurality of projections being provided on the first surface with respect to the plurality of pixels;
a plurality of photoelectric converters that is formed to be embedded in the first semiconductor substrate with respect to each pixel and generates an electric charge according to an amount of light received;
a plurality of charge holding units that is provided on respective upper surfaces of the plurality of projections and holds electric charges generated in the plurality of photoelectric converters;
a second semiconductor substrate stacked on a side of the first surface of the first semiconductor substrate and provided with one or more pixel circuits that generate a pixel signal on a basis of an electric charge generated by each of the plurality of photoelectric converters; and
a gate of a transfer transistor that is provided around the plurality of projections and transfers the electric charges held in the charge holding units to the pixel circuits.
